(19) Europäisches Patentamt
European Patent Office
Office européen des brevets

(11) **EP 4 287 812 B1**

(12) **EUROPEAN PATENT SPECIFICATION**

(45) Date of publication and mention of the grant of the patent:
**01.10.2025 Bulletin 2025/40**

(21) Application number: **22192927.6**

(22) Date of filing: **30.08.2022**

(51) International Patent Classification (IPC):
***H10K 50/17*** *(2023.01)* ***H10K 85/60*** *(2023.01)*

(52) Cooperative Patent Classification (CPC):
**H10K 85/60; H10K 50/17; H10K 50/19; H10K 85/654; H10K 85/657;** H10K 50/125

# (54) ORGANIC ELECTROLUMINESCENT DEVICE COMPRISING A COMPOUND OF FORMULA (I) AND A COMPOUND OF FORMULA (II), AND DISPLAY DEVICE COMPRISING THE ORGANIC ELECTROLUMINESCENT DEVICE

ORGANISCHE ELEKTROLUMINESZENZVORRICHTUNG MIT EINER VERBINDUNG DER FORMEL (I) UND EINER VERBINDUNG DER FORMEL (II) SOWIE ANZEIGEVORRICHTUNG MIT DER ORGANISCHEN ELEKTROLUMINESZENZVORRICHTUNG

DISPOSITIF ÉLECTROLUMINESCENT ORGANIQUE COMPRENANT UN COMPOSÉ DE FORMULE (I) ET UN COMPOSÉ DE FORMULE (II), ET DISPOSITIF D'AFFICHAGE COMPRENANT LE DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.06.2022 EP 22177215**
**03.06.2022 EP 22177214**

(43) Date of publication of application:
**06.12.2023 Bulletin 2023/49**

(73) Proprietor: **Novaled GmbH**
**01099 Dresden (DE)**

(72) Inventors:
- **LUSCHTINETZ, Regina**
  **01099 Dresden (DE)**
- **SCHULZE, Benjamin**
  **01099 Dresden (DE)**
- **ROSENOW, Thomas**
  **01099 Dresden (DE)**
- **NÜLLEN, Max Peter**
  **01099 Dresden (DE)**
- **WUDARCZYK, Jacob Jacek**
  **01099 Dresden (DE)**

(74) Representative: **Michalski Hüttermann & Partner Patentanwälte mbB**
**Kaistraße 16A**
**40221 Düsseldorf (DE)**

(56) References cited:
**EP-A1- 3 989 305** **US-A1- 2020 062 778**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

## Technical Field

The present invention relates to an electroluminescent device comprising a compound of formula (I) and a compound of formula (II), and a display device comprising the organic electroluminescent device.

## Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds. WO 2021/250277 discloses stacked OLEDS comprising a charge generation layer comprising radialenes and an anode side hole injection layer HIL comprising the same material. EP3989305 A1 discloses stacked OLEDs comprising a charge generation layer comprising radialenes and an anode side hole injection layer HIL comprising F4-TCNQ. US2020/0062778 A1 discloses substituted benzodithiophenes having a quinoidal structure for use in the HIL.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the semiconductor layers, and among them, may be affected by characteristics of the compounds contained in the semiconductor layers.

There remains a need to improve performance of organic electroluminescent devices, in particular to achieve improved operating voltage, improved operating voltage stability over time and improved current efficiency.

## DISCLOSURE

An aspect of the present invention provides an organic electroluminescent device containing an anode layer, a cathode layer, a hole injection layer, at least two light-emitting units, and at least one charge generation layer, wherein at least one charge generation layer comprises a p-type charge generation layer,

wherein each light-emitting unit comprises at least one light-emitting layer,
wherein each of the at least one charge generation layers is disposed independently between a set of two adjacent light-emitting units of the at least two light emitting-units,
wherein the hole injection layer is closer to the anode layer than the p-type charge generation layer,
wherein the p-type charge generation layer comprises a first hole transport matrix compound and a radialene of formula (I),

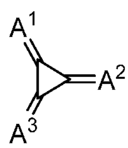

(I),

wherein in formula (I)

- $A^1$ is independently selected from a group of formula (Ia)

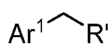

(Ia)

wherein $Ar^1$ is independently selected from substituted or unsubstituted $C_6$ to $C_{36}$ aryl, and substituted or

unsubstituted $C_2$ to $C_{36}$ heteroaryl;
wherein for the case that $Ar^1$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^2$ is independently selected from a group of formula (Ib)

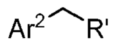

(Ib),

wherein $Ar^2$ is independently selected from substituted or unsubstituted $C_6$ to $C_{36}$ aryl, and substituted or unsubstituted $C_2$ to $C_{36}$ heteroaryl;
wherein for the case that $Ar^2$ is substituted, one or more of the substituents are independently selected from the group consisting of D, an electron-withdrawing group, halogen, Cl, F, CN, $NO_2$,substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^3$ is independently selected from a group of formula (Ic)

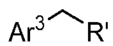

(Ic),

wherein $Ar^3$ is independently selected from substituted or unsubstituted $C_6$ to $C_{36}$ aryl, and substituted or unsubstituted $C_2$ to $C_{36}$ heteroaryl; wherein for the case that $Ar^3$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl,
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy; and wherein in $A^1$, $A^2$, and $A^3$ each R' is independently selected from substituted or unsubstituted $C_6$ to $C_{18}$ aryl, substituted or unsubstituted $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN;
- wherein the one or more substituents of $C_6$ to $C_{18}$ aryl, $C_6$ to $C_{18}$ heteroaryl, $C_1$ to $C_8$ alkyl, are independently selected from D, an electron-withdrawing group, halogen, Cl, F, CN, $-NO_2$, partially fluorinated $C_1$ to $C_6$ alkyl, perfluorinated $C_1$ to $C_6$ alkyl, partially fluorinated $C_1$ to $C_6$ alkoxy, perfluorinated $C_1$ to $C_6$ alkoxy;

whereby the hole injection layer comprises a second hole transport matrix compound and a compound of formula (II), whereby the compound of formula (II) is a quinoide compound, whereby the term "quinoide compound" means and/includes a compound which contains a moiety which is (formally) derived from a compound comprising an annelated aromatic system or non-annelated aromatic system whereby an even number of carbon atoms of said annelated aromatic system or non-annelated aromatic system are double bonded to an atom or a group outside said annelated aromatic system or non-annelated aromatic system with any necessary rearrangement of double bonds, and whereby the compound of formula (II) contains at least one substituted or unsubstituted aryl substituent or at least one substituted or unsubstituted heteroaryl substituent; preferably substituted aryl substituent or substituted heteroaryl substituent, more preferably substituted $C_6$ to $C_{30}$ aryl or substituted $C_3$ to $C_{30}$ heteroaryl preferably, and more preferably substituted phenyl or substituted $C_3$ to $C_5$ heteroaryl and wherein preferably $C_3$ to $C_5$ heteroaryl is a six-member heteroaromatic ring.

It should be noted that throughout the application and the claims any $A^n$, $B^n$, $R^n$, $X^n$ etc. always refer to the same moieties, unless otherwise noted.

In the present specification, when a definition is not otherwise provided, "substituted" refers to one substituted with a deuterium, $C_1$ to $C_{12}$ alkyl and $C_1$ to $C_{12}$ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a $C_1$ to $C_{12}$ alkyl group. More specifically, the alkyl group may be a $C_1$ to $C_{10}$ alkyl group or a $C_1$ to $C_6$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common $sp^2$-hybridized carbon atoms.

The term "cyano moiety" refers to a CN substituent.

The term "electron-withdrawing group" refers to a chemical group in a molecule, which can draw electrons away from an adjacent part of the molecule. The distance over which the electron-withdrawing group can exert its effect, namely the number of bonds over which the electron-withdrawing effect spans, is extended by conjugated pi-electron systems such as aromatic systems. Examples of electron-withdrawing groups include $NO_2$, CN, halogen, Cl, F, partially fluorinated or perfluorinated alkyl and partially fluorinated or perfluorinated $C_1$ to $C_{12}$ alkyl, partially fluorinated or perfluorinated alkoxy, partially fluorinated or perfluorinated $C_1$ to $C_6$ alkoxy.

In the present specification, the single bond refers to a direct bond.

The term "n-type charge generation layer" is sometimes in the art also named n-CGL or electron generation layer and is intended to include the both.

The term "p-type charge generation layer" is sometimes in the art also named p-CGL or hole generation layer and is intended to include the both.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The terms "cathode", "cathode layer" and "cathode electrode" are used synonymously.

The term "top emission device" is understood to mean an organic electronic device wherein the light is emitted through the cathode layer.

The term "bottom emission device" is understood to mean an organic electronic device wherein the light is emitted through the substrate.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) energy level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) energy level.

**Advantageous Effects**

Surprisingly, it was found that the organic electroluminescent device according to the invention solves the problem underlying the present invention by enabling devices in various aspects superior over the organic electroluminescent devices known in the art, in particular with respect to improved operating voltage, improved operating voltage stability over time and improved current efficiency.

According to one embodiment of the present invention, the compound of formula (II) is a compound which contains a moiety which is (formally) derived from a compound comprising an annelated aromatic system or non-annelated aromatic system whereby an even number of carbon atoms of said annelated aromatic system or non-annelated aromatic system are double bonded to an atom or a group outside said annelated aromatic system or non-annelated aromatic system with any necessary rearrangement of double bonds and resulting in at least a partial lift of aromaticity in the annelated aromatic system or non-annelated aromatic system.

Additionally or alternatively to the above, the compound of formula (II) is a compound according to formula (IIa):

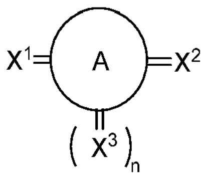

(IIa)

wherein n is an even integer including 0,

wherein $X^1$, $X^2$, and $X^3$ are independently selected from O, S, $CR^{13}R^{23}$, $CR^{1b}R^{2b}$, $NR^{3a}$, $NR^{3b}$;
wherein $R^{1a}$, $R^{2a}$, $R^{1b}$, and $R^{2b}$, are independently selected from halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $NO_2$, $SF_5$, substituted or unsubstituted $C_6$ to $C_{30}$ aryl, substituted or unsubstituted $C_3$ to $C_{30}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;
wherein $R^{3a}$ and $R^{3b}$ is selected from CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$,
wherein ring A is selected from

| | | |
|---|---|---|
| 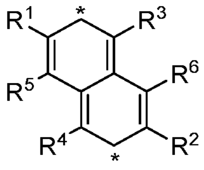 | 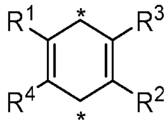 | 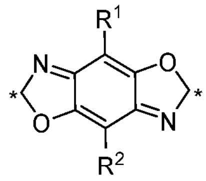 |
| 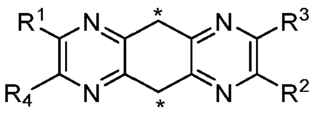 | 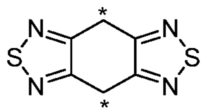 | 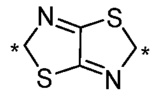 |
| 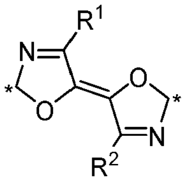 | 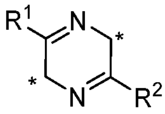 | |
| 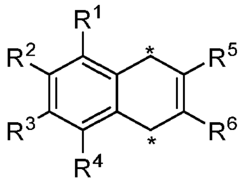 | 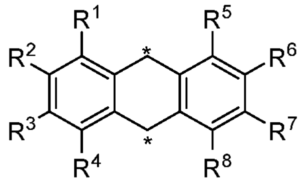 | 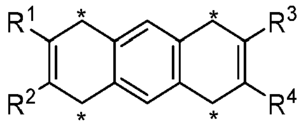 |
| 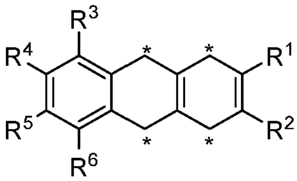 | 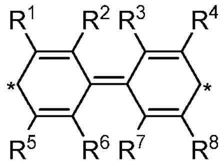 | 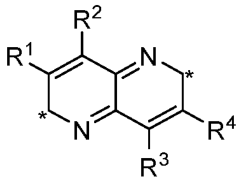 |
| 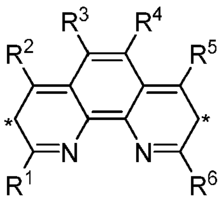 | 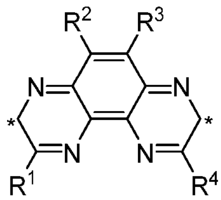 | 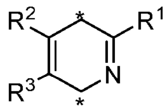 |
| 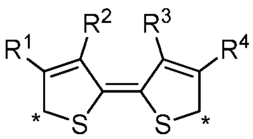 | 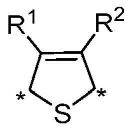 | 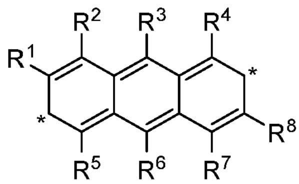 |
| 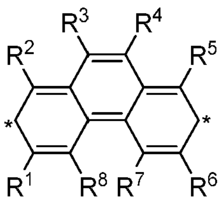 | 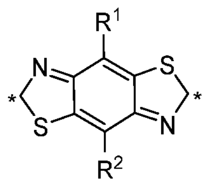 | |

| | | |
|---|---|---|
| 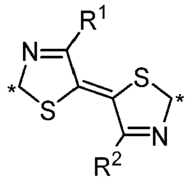 | 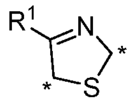 | 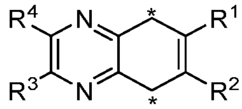 |
| 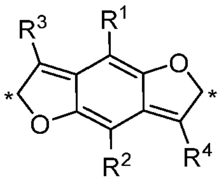 | 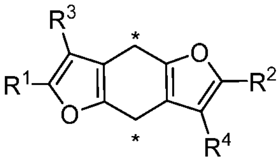 | 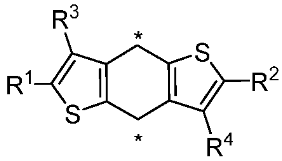 |
| 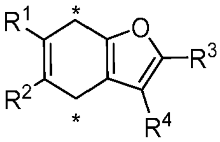 | 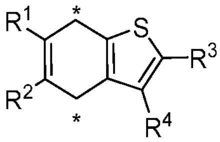 | 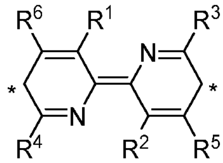 |
| 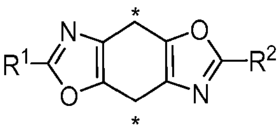 | 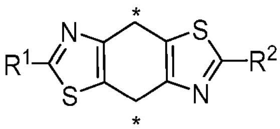 | 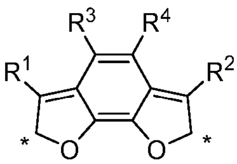 |
| 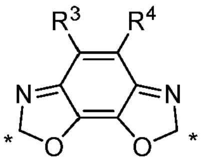 | 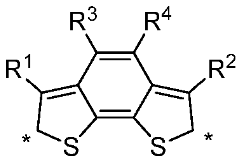 | 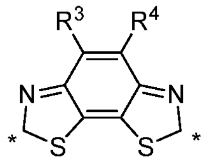 |
| 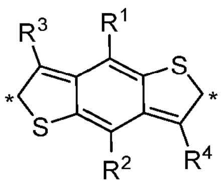 | 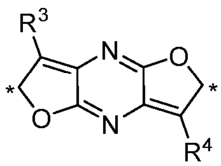 | 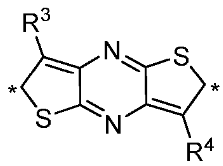 |
| 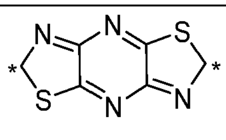 | 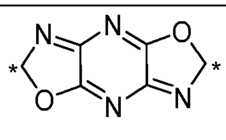 | 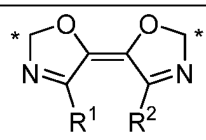 |
| 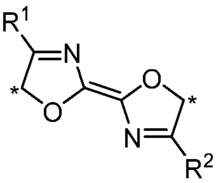 | 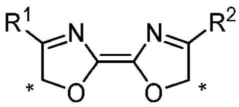 | 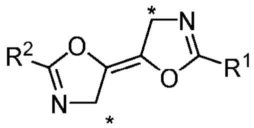 |

| | | |
|---|---|---|
| 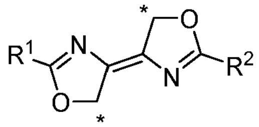 | 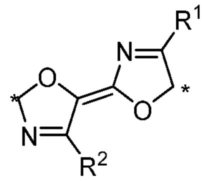 | 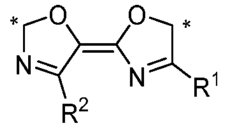 |
| 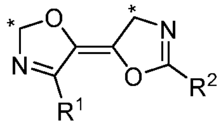 | 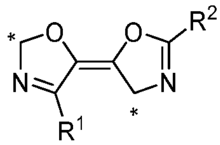 | 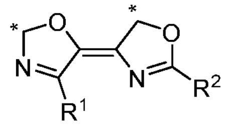 |
| 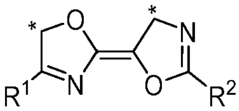 | 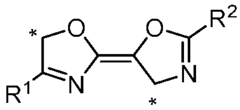 | 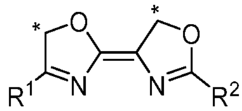 |
| 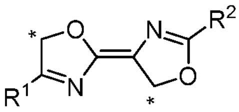 | 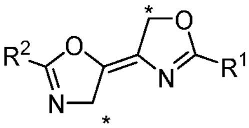 | 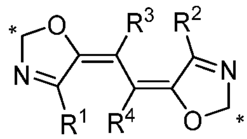 |
| 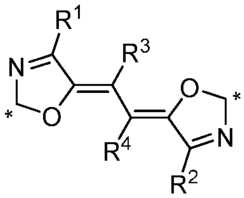 | 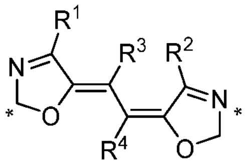 | 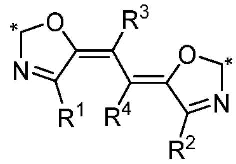 |
| 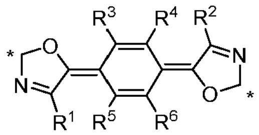 | 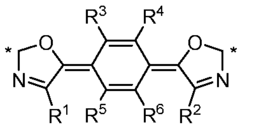 | 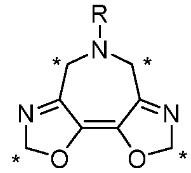 |

wherein the asterisk "*" denotes the binding position;

wherein $R^1$, $R^2$, $R^3$, $R^4$, $R^5$, $R^6$, $R^7$ and $R^8$ are independently selected from D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, $OCF_3$, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$, wherein the one or more substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$; and

wherein at least one of $R^{1a}$, $R^{2a}$, $R^{1b}$, $R^{2b}$, $R^{3a}$, $R^{3b}$, $R^1$, $R^2$, $R^3$, $R^4$, $R^5$, $R^6$, $R^7$ and $R^8$ is independently selected from a substituted or unsubstituted $C_6$ to $C_{30}$ aryl or substituted or unsubstituted $C_3$ to $C_{30}$ heteroaryl (preferably substituted $C_6$ to $C_{30}$ aryl or substituted $C_3$ to $C_{30}$ heteroaryl preferably, and more preferably substituted phenyl or substituted $C_3$ to $C_5$ heteroaryl and wherein preferably $C_3$ to $C_5$ heteroaryl is a six-member heteroaromatic ring).

According to a preferred embodiment in formula (IIa) ring A is selected from:

| | | |
|---|---|---|
| 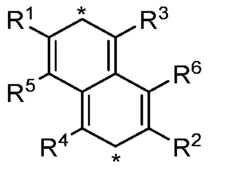 | 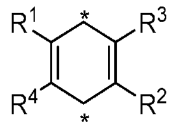 | 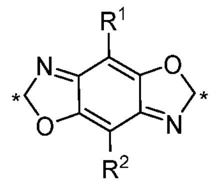 |
| 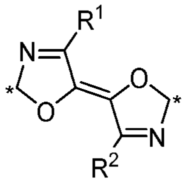 | 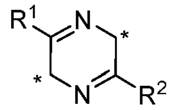 | |
| 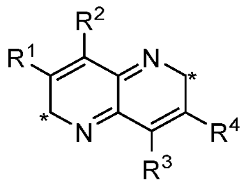 | 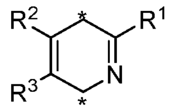 | 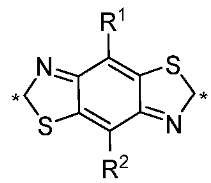 |
| 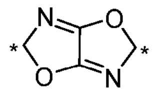 | 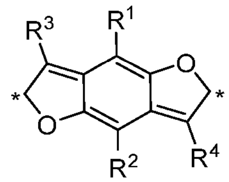 | 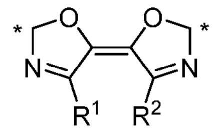 |
| 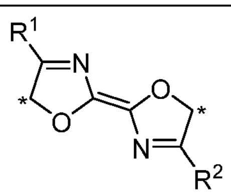 | 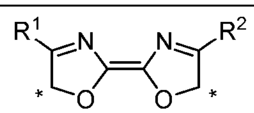 | 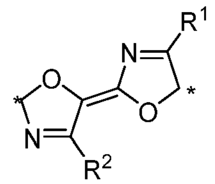 |
| 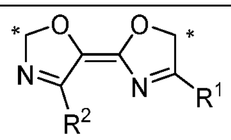 | | |

wherein the asterisk "*" denotes the binding position.

According to one embodiment of the present invention, the compound of formula (I) has a calculated LUMO energy level of ≤ -4.60 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase. preferably ≤ - 4.75 eV; more preferably ≤ -5.00 eV; even more preferred ≤ -5.10 eV; even more preferred ≤ -5.15 eV; even more preferred ≤ -5.19 eV; even more preferred ≤ -5.20 eV, and even more preferred ≤ - 5.22 eV.

According to one embodiment of the present invention, the the compound of formula (I) has a calculated LUMO energy level in the range of ≤ -5.00 eV to ≥ -5.75 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -5.10 eV to ≥ -5.70 eV; more preferred ≤ -5.15 eV to ≥ - 5.65 eV, more preferred ≤ -5.19 eV to ≥ - 5.65 eV, even more preferred ≤ -5.20 eV to ≥ - 5.60 eV, and even more preferred ≤ -5.22 eV to ≥ - 5.60 eV.

According to one embodiment of the present invention, the compound of formula (I) is present in the p-type charge generation layer in an amount of ≤99.9 wt% based on the total weight of the hole injection layer, preferably ≤99 wt%, more preferably ≤95 wt%, more preferably ≤90 wt%, more preferably ≤80 wt%, more preferably ≤70 wt%, more preferably ≤60 wt%, more preferably ≤50 wt%, more preferably ≤40 wt%, more preferably ≤30 wt%, more preferably ≤20 wt%, more preferably ≤ 10 wt.-%, more preferably ≤ 5 wt.-%, more preferably ≤ 3.0 wt.-%, more preferably ≤ 2.75 wt.-%, more preferably ≤ 2.5 wt.-%, more preferably ≤ 2.25 wt.-%, and most preferably ≤ 2.0 wt.-%.

According to one embodiment of the present invention, the compound of formula (I) at least one $CF_3$ group.

According to one embodiment of the present invention, the compound of formula (I) at one to three $CF_3$ group.

According to one embodiment of the present invention, the compound of formula (I) comprises less than nine cyano moieties.

According to one embodiment of the present invention, the compound of formula (I) comprises less than eight cyano moieties.

According to one embodiment of the present invention, the compound of formula (I) comprises at least one cyano moiety.

According to one embodiment of the present invention, the compound of formula (I) comprises at least two cyano moieties.

According to one embodiment of the present invention, the compound of formula (I) comprises at least three cyano moieties.

According to one embodiment of the present invention, the compound of formula (I) comprises at least four cyano moieties.

According to one embodiment of the present invention, the compound of formula (I) comprises from 3 to 8 cyano moieties.

According to one embodiment of the present invention, the compound of formula (I) comprises from 3 to 7 cyano moieties.

According to one embodiment of the present invention, the compound of formula (I) comprises from 4 to 7 cyano moieties.

According to one embodiment of the present invention, formula (I) comprises at least 10 fluorine atoms, at least 12 fluorine atoms, at least 13 fluorine atoms, 14 at least fluorine atoms, at least 15 fluorine atoms, at least 16 fluorine atoms, at least 17 fluorine atoms, or at least 18 fluorine atoms.

According to one embodiment of the present invention, formula (I) comprises 10 to 20 fluorine atoms, or 10 to 18 fluorine atoms or 12 to 18 fluorine atoms.

According to one embodiment of the present invention, formula (I) comprises 4 to 7 cyano moieties and 12 to 18 fluorine atoms.

According to one embodiment of the present invention, in formula (I), at least two of $A^1$, $A^2$, and $A^3$ are selected the same.

According to one embodiment of the present invention, in formula (I), $A^2$ and $A^3$ are identical.

According to one embodiment of the present invention, in formula (I), $A^1$, $A^2$ and $A^3$ are identical.

According to one embodiment of the present invention, in formula (I) $A^1$ is different from $A^2$ and/or $A^3$.

According to one embodiment of the present invention, in formula (I) $Ar^1$, $Ar^2$, and $Ar^3$ are independently selected from substituted or unsubstituted $C_6$ to $_{12}$ aryl and substituted or unsubstituted $C_3$ to $C_{12}$ heteroaryl.

According to one embodiment of the present invention, in formula (I) $Ar^1$, $Ar^2$, and $Ar^3$ are independently selected from substituted or unsubstituted $C_6$ aryl and substituted or unsubstituted $C_3$ to $C_5$ heteroaryl.

According to one embodiment of the present invention, in formula (I) the substituents on $Ar^1$, $Ar^2$, and $Ar^3$ are independently selected from the group consisting of an electron-withdrawing group, halogen, Cl, F, CN, partially fluorinated alkyl, and perfluorinated alkyl.

According to one embodiment of the present invention, in formula (I) the substituents on $Ar^1$, $Ar^2$, and $Ar^3$ are independently selected from the group consisting of Cl, F, CN, and perfluorinated alkyl.

According to one embodiment of the present invention, in formula (I) the substituents on $Ar^1$, $Ar^2$, and $Ar^3$ are independently selected from the group consisting of F, CN, and perfluorinated alkyl.

According to one embodiment of the present invention, in formula (I) the substituents on $Ar^1$, $Ar^2$, and $Ar^3$ are independently selected from the group consisting of F, CN, and $CF_3$.

According to one embodiment of the present invention, in formula (I) the substituents on $Ar^1$, $Ar^2$, and $Ar^3$ are independently selected from the group consisting of CN, and $CF_3$.

According to one embodiment of the present invention, in formula (I) the substituents on $Ar^1$, $Ar^2$, and $Ar^3$ are independently selected from the group consisting of CN.

According to one embodiment of the present invention, in formula (I) the substituents on $Ar^1$, $Ar^2$, and $Ar^3$ are independently selected from the group consisting of $CF_3$.

According to one embodiment of the present invention, in formula (I) $Ar^1$, $Ar^2$, and $Ar^3$ independently each comprise more than one and less than five substituents, preferably more than two and less than four, for example 4.

According to one embodiment of the present invention, in formula (I) each R' is independently selected from electron-withdrawing group, partially fluorinated $C_1$ to $C_8$ alkyl, perfluorinated $C_1$ to $C_8$ alkyl, halogen, F and CN.

According to one embodiment of the present invention, in formula (I) each R' is independently selected from partially fluorinated $C_1$ to $C_8$ alkyl, perfluorinated $C_1$ to $C_8$ alkyl, halogen, F and CN.

According to one embodiment of the present invention, in formula (I) each R' is independently selected from $CF_3$, F and CN.

According to one embodiment of the present invention, in formula (I) each R' is CN.

According to one embodiment of the present invention, in formula (I) $Ar^1$, $Ar^2$ and $Ar^3$ are independently selected from a group according to the following formula (III) and preferably each R' is selected from CN:

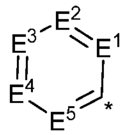

(III)

wherein

$E^1$ is selected from $CW^1$ or N;
$E^2$ is selected from $CW^2$ or N;
$E^3$ is selected from $CW^3$ or N;
$E^4$ is selected from $CW^4$ or N;
$E^5$ is selected from $CW^5$ or N;
$W^1$, $W^2$, $W^3$, $W^4$ and $W^5$ (if present) are independently selected from electron-withdrawing group, CN, halogen, Cl, F, $NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_6$ alkoxy, $OCF_3$, substituted or unsubstituted $C_6$ to $C_{30}$ aryl, substituted or unsubstituted $C_3$ to $C_{30}$ heteroaryl, D or H,
wherein the one or more substituents is independently selected from D, halogen, Cl, F, CN, $NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy,
wherein the asterisk "*" denotes the binding position.

According to one embodiment of the present invention, in formula (III)
$W^1$, $W^2$, $W^3$, $W^4$ and $W^5$ (if present) are independently selected from electron-withdrawing group, CN, halogen, Cl, F, $NO_2$, partially fluorinated or perfluorinated $C_1$ to $C_8$ alkyl, partially fluorinated or perfluorinated $C_1$ to $C_6$ alkoxy, D or H, and wherein preferably each R' is selected from CN.

According to one embodiment of the present invention, in formula (I), $Ar^1$, $Ar^2$ and $Ar^3$ are independently selected from one of the following groups and preferably each R' is selected from CN:

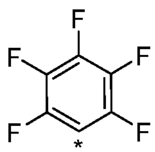 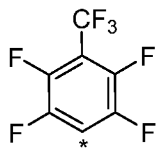 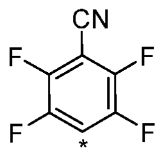 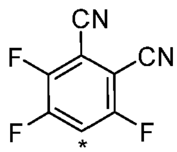 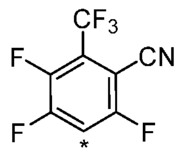

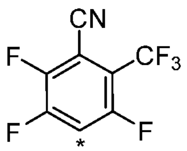 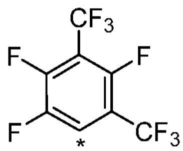 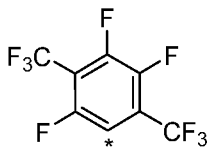 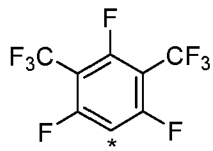 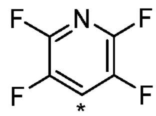

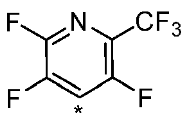 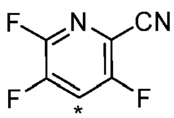 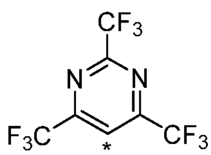 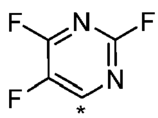 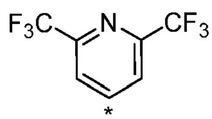

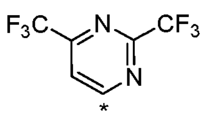 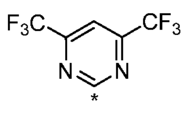 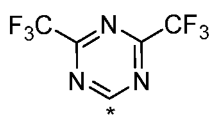 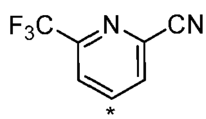 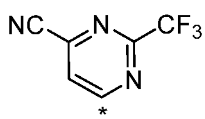

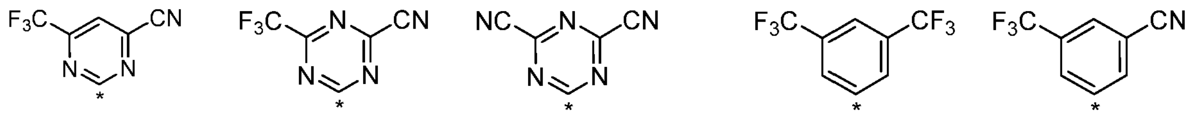

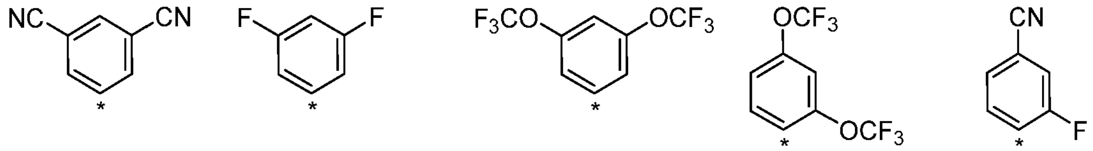

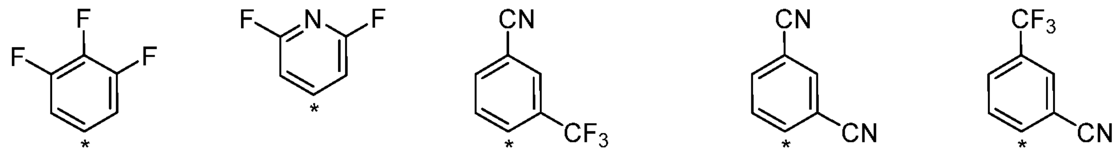

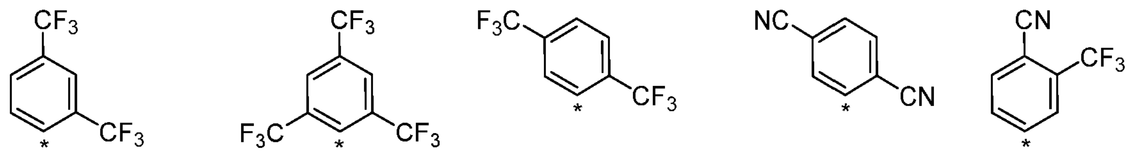

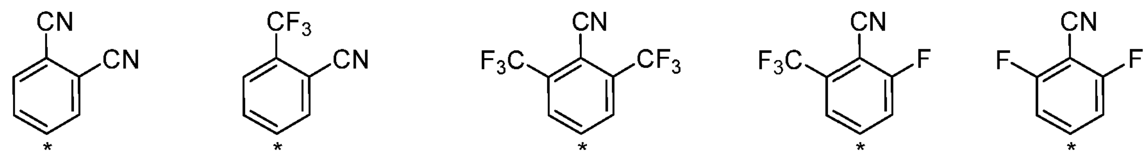

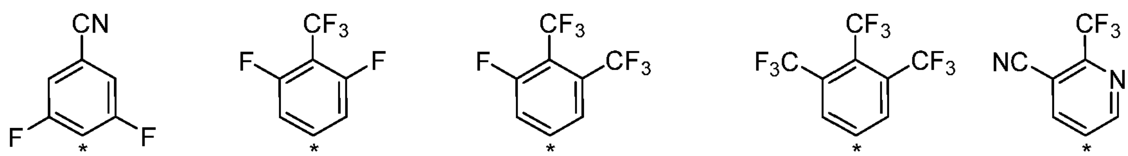

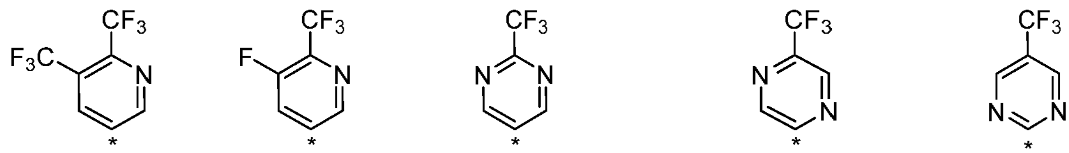

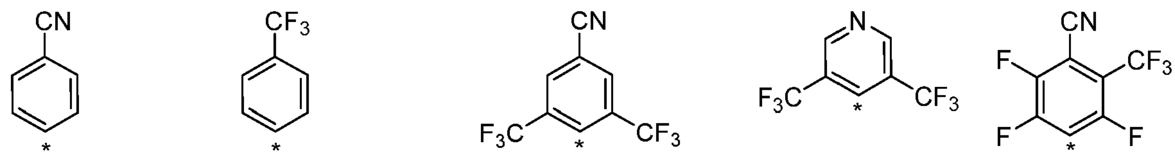

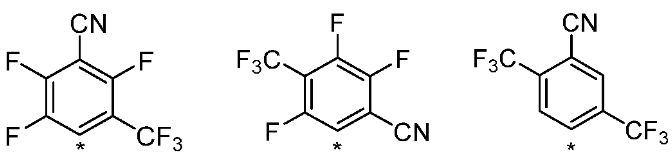

wherein the asterisk "*" denotes the binding position.

According to one embodiment of the present invention, in formula (I), $Ar^1$, $Ar^2$ and $Ar^3$ are independently selected from one of the following groups and preferably each R' is selected from CN:

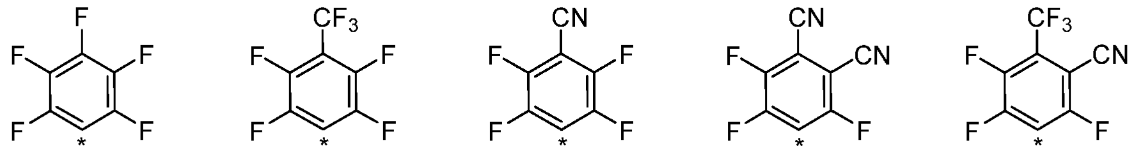

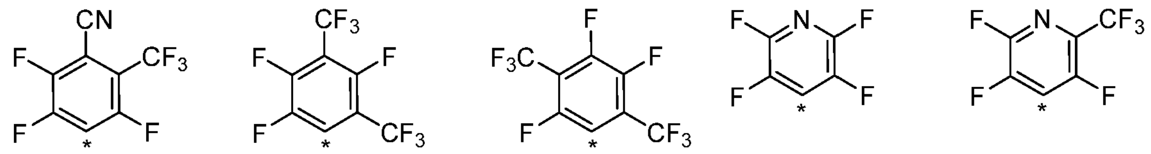

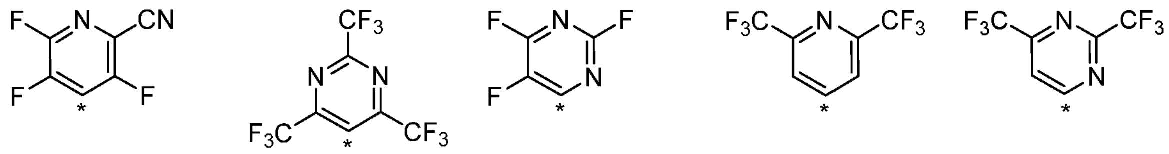

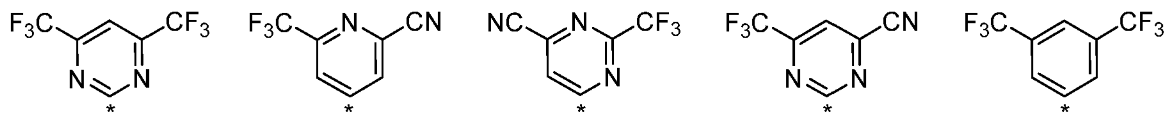

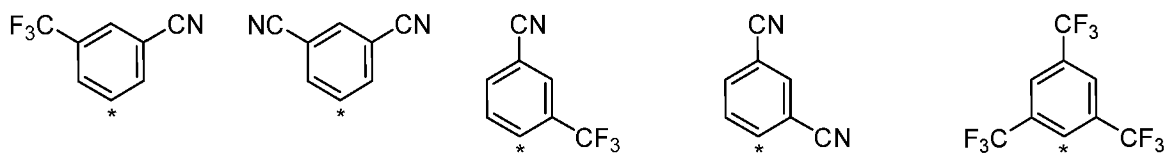

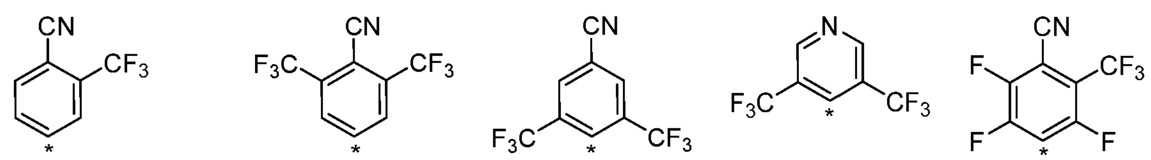

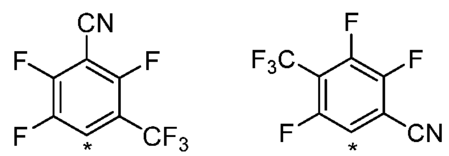

wherein the asterisk "*" denotes the binding position.

According to one embodiment of the present invention, in formula (I), $Ar^1$, $Ar^2$ and $Ar^3$ are independently selected from one of the following groups and preferably each R' is selected from CN:

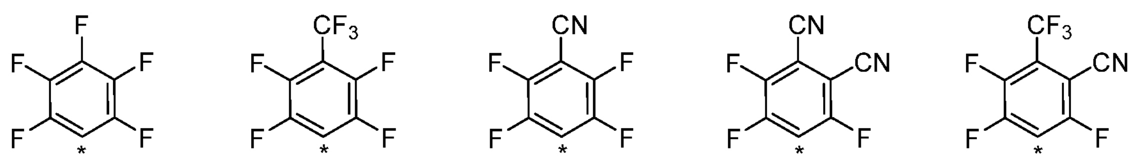

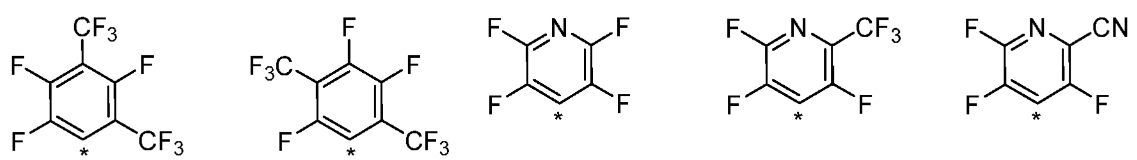

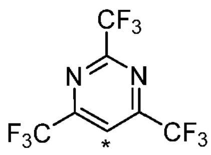 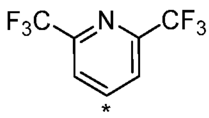 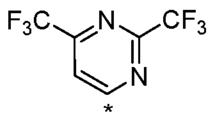 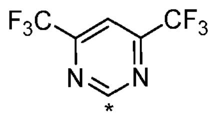 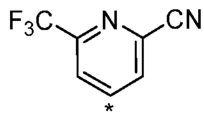

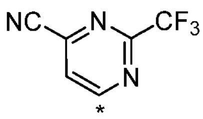 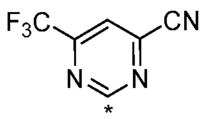 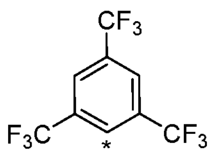 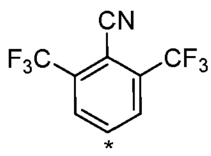 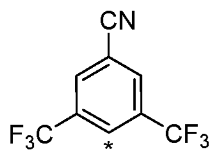

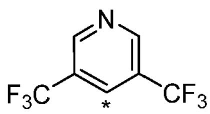 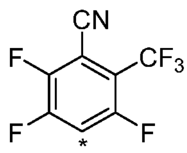 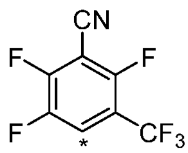

wherein the asterisk "*" denotes the binding position.

According to one embodiment of the present invention, the compound of formula (II) is selected from one of the following compounds A1 to A13, wherein R' is selected from CN and $Ar^1$ of $A^1$, $Ar^2$ of $A^2$, and $Ar^3$ of $A^3$ are selected according to the following:

| | $Ar^1$ of $A^1$ | $Ar^2$ of $A^2$ | $Ar^3$ of $A^3$ |
|---|---|---|---|
| A1 | 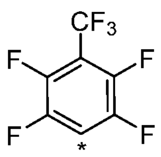 | 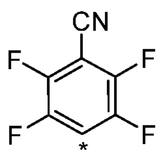 | 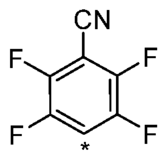 |
| A2 | 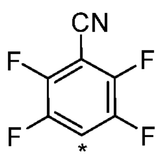 | 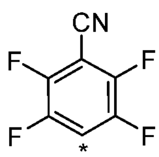 | 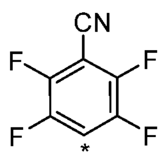 |
| A3 | 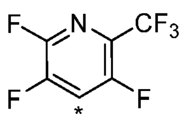 | 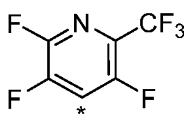 | 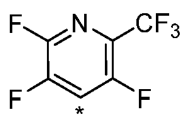 |
| A4 | 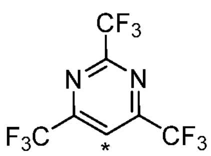 | 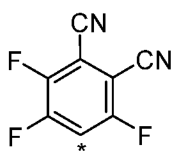 | 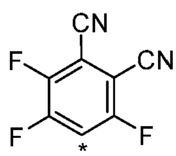 |
| A5 | 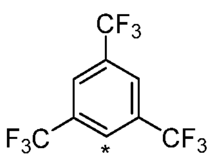 | 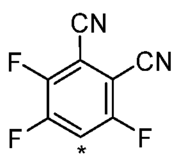 | 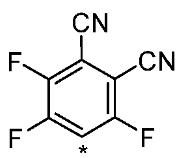 |
| A6 | 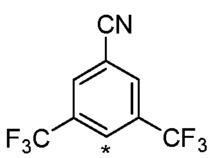 | 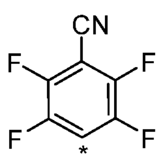 | 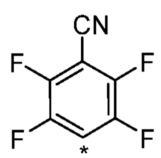 |

(continued)

| | $Ar^1$ of $A^1$ | $Ar^2$ of $A^2$ | $Ar^3$ of $A^3$ |
|---|---|---|---|
| A7 | 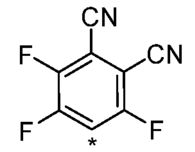 | 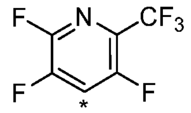 | 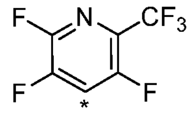 |
| A8 | 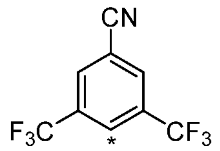 | 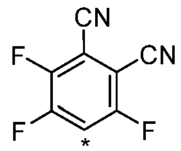 | 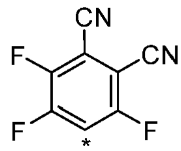 |
| A9 | 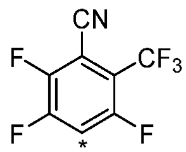 | 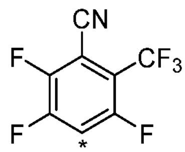 | 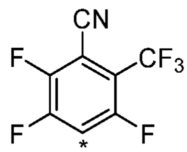 |
| A10 | 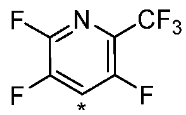 | 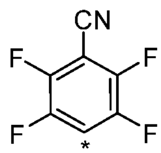 | 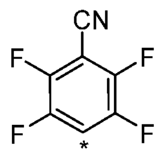 |
| A11 | 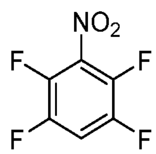 | 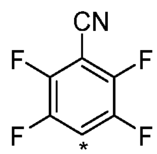 | 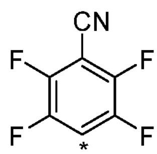 |
| A12 | 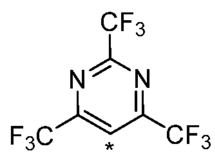 | 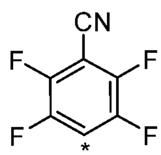 | 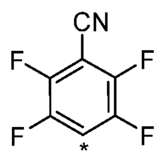 |
| A13 | 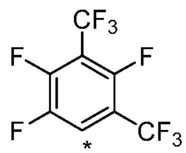 | 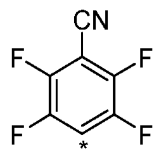 | 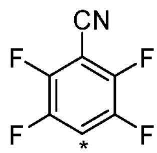 |

wherein the asterisk "*" denotes the binding position.

According to one embodiment of the present invention, the compound of formula (II) is selected from one of the compounds A4 to A7, A10 and A12.

According to one embodiment of the present invention, the compound of formula (I) is represented by one of the following formulae (IIIa) to (IITh):

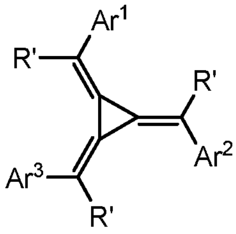

(IIIa)

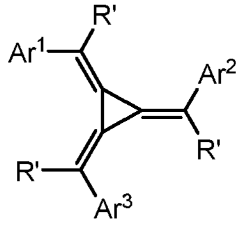

(IIIe)

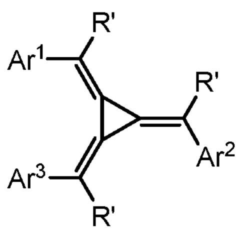

(IIIb)

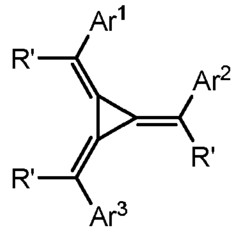

(IIIf)

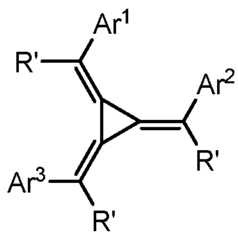

(IIIc)

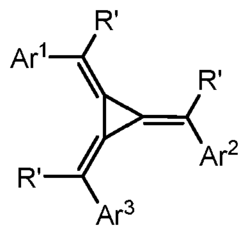

(IIIg)

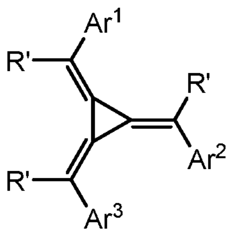

(IIId)

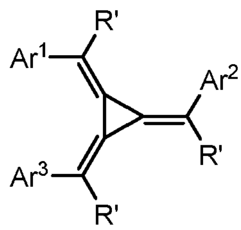

(IIIh)

wherein $Ar^1$, $Ar^2$, $Ar^3$, and R' are independently selected as above.

According to one embodiment of the present invention, the p- type charge generation layer comprises as compound of formula (I) a mixture of at least two compounds selected from formulae (IIIa) to (IIIh) as defined above.

According to one embodiment of the present invention, the compound of formula (II) has a molecular weight of ≥340 g/mol, preferably ≥350 g/mol, more preferably ≥360 g/mol, more preferably ≥370 g/mol, more preferably ≥380 g/mol, more preferably ≥390 g/mol, even more preferably ≥400 g/mol, even more preferably ≥ 450 g/mol, even more preferably ≥ 500 g/mol, even more preferably ≥550 g/mol, even more preferably ≥600 g/mol, even more preferably ≥650 g/mol, and most preferably ≥660 g/mol.

According to one embodiment of the present invention, the compound of formula (II) has a molecular weight in the range of 340 g/mol to 5000 g/mol, preferably ≥370 g/mol to 4500 g/mol, more preferably ≥390 g/mol to 4000 g/mol, even more preferably ≥400 g/mol to 3500 g/mol, even more preferably ≥ 450 g/mol to 3000 /mol, even more preferably ≥ 500 g/mol to 2500 g/mol, even more preferably ≥550 g/mol to 2000 g/mol, even more preferably ≥600 g/mol to 1500 g/mol, even more preferably ≥650 g/mol to 1000 g/mol, and most preferably ≥660 g/mol to 800 g/mol.

According to one embodiment of the present invention, the compound of formula (II) has a calculated LUMO energy level of ≤ -4.90 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ - 4.95 eV; even more preferred ≤ -5.00 eV, even more preferred ≤ -5.10 eV, even more preferred ≤ -5.20 eV, and even more preferred ≤ -5.25 eV.

According to one embodiment of the present invention, the compound of formula (II) has a calculated LUMO energy level in the range of ≤ -4.90 eV to ≥ -5.75 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -4.95 eV to ≥ -5.75 eV; even more preferred ≤ -5.00 eV to ≥ - 5.70 eV, even more preferred ≤ -5.10 eV to ≥ - 5.65 eV, even more preferred ≤ -5.20 eV to ≥ - 5.60 eV, and even more preferred ≤ -5.25 eV to ≥ - 5.55 eV.

According to one embodiment of the invention, the compound of formula (II) when it is pure exhibits a lower volatility than tetrafluorotetracyanoquinonedimethane (F4TCNQ) under the same evaporation conditions.

According to one embodiment of the present invention, the compound of formula (II) is present in the hole injection layer in an amount of ≤99.9 wt% based on the total weight of the p-type charge generation layer, preferably ≤99 wt%, more preferably ≤95 wt%, more preferably ≤90 wt%, more preferably ≤80 wt%, more preferably ≤70 wt%, more preferably ≤60 wt%, more preferably ≤50 wt%, more preferably ≤40 wt%, more preferably <30 wt%, more preferably ≤20 wt%, more preferably ≤ 10 wt.-%, more preferably ≤ 5 wt.-%,

According to one embodiment of the invention, the compound of formula (II) does not include the following compound:

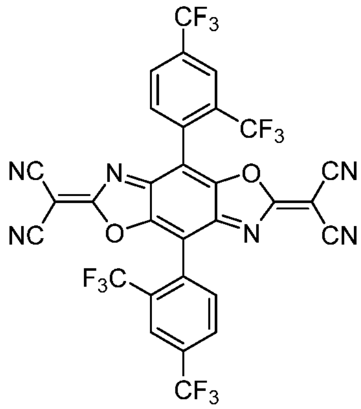

.

According to one embodiment of the present invention, the compound of formula (II) does not include the following compound:

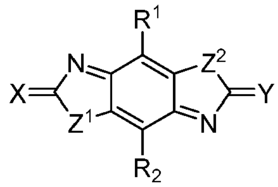

(II-D),

wherein in formula (II-D)

- $R^1$ and $R^2$ are independently selected from substituted or unsubstituted $C_6$ to $C_{30}$ aryl and substituted or unsubstituted $C_3$ to $C_{30}$ heteroaryl;

  wherein the one or more of the substituents on $R^1$ and $R^2$ are independently selected from D, electron-withdrawing group, CN, isocyano, SCN, OCN, $CF_3$, $NO_2$, $SF_5$, halogen, F, substituted or unsubstituted $C_1$ to $C_6$ alkyl, partially fluorinated $C_1$ to $C_6$ alkyl, perfluorinated $C_1$ to $C_6$ alkyl, substituted or unsubstituted $C_1$ to $C_6$ alkoxy, substituted or unsubstituted $C_6$ to $C_{30}$ aryl, substituted or unsubstituted $C_2$ to $C_{30}$ heteroaryl, substituted or unsubstituted $C_1$ to $C_6$ alkylsulfinyl, substituted or unsubstituted $C_6$ to $C_{30}$ arylsulfinly, substituted or unsubstituted $C_2$ to $C_{30}$ heteroarylsulfinyl, substituted or unsubstituted $C_1$ to $C_6$ alkylsulfonyl, substituted or unsubstituted $C_6$ to $C_{30}$ arylsulfonyl, and substituted or unsubstituted $C_2$ to $C_{30}$ heteroarylsulfonyl;
  wherein the one or more substituents thereon are selected from D, electron-withdrawing group, CN, isocyano, SCN, OCN, halogen, F, partially fluorinated $C_1$ to $C_6$ alkyl, perfluorinated $C_1$ to $C_6$ alkyl, $CF_3$, $NO_2$, $SF_5$, partially fluorinated $C_1$ to $C_6$ alkoxy and perfluorinated $C_1$ to $C_6$ alkoxy;

- $Z^1$ and $Z^2$ are independently selected from O, S, Se, S=O, or $SO_2$,
- X and Y are independently selected from $CR^3R^4$ or $NR^5$;

  wherein $R^3$ and $R^4$ are independently selected from CN, isocyano, SCN, OCN, halogen, F, $CF_3$, $NO_2$, $SF_5$, substituted or unsubstituted $C_1$ to $C_6$ alkyl, partially fluorinated $C_1$ to $C_6$ alkyl, perfluorinated $C_1$ to $C_6$ alkyl, substituted or unsubstituted $C_1$ to $C_6$ alkoxy, substituted or unsubstituted $C_1$ to $C_6$ alkylsulfinyl, substituted or unsubstituted $C_6$ to $C_{30}$ arylsulfinly, substituted or unsubstituted $C_2$ to $C_{30}$ heteroarylsulfinyl, substituted or unsubstituted $C_1$ to $C_6$ alkylsulfonyl, substituted or unsubstituted $C_6$ to $C_{30}$ arylsulfonyl, substituted or unsub-

stituted $C_2$ to $C_{30}$ heteroarylsulfonyl, substituted or unsubstituted $C_6$ to $C_{30}$ aryl, and substituted or unsubstituted $C_2$ to $C_{30}$ heteroaryl;

wherein the one or more substituents on $R^3$ and $R^4$ are independently selected from D, CN, isocyano, SCN, OCN partially fluorinated $C_1$ to $C_6$ alkyl, perfluorinated $C_1$ to $C_6$ alkyl, $CF_3$, $NO_2$, and $SF_5$;

wherein $R^5$ is independently selected from CN, partially fluorinated $C_1$ to $C_6$ alkyl, perfluorinated $C_1$ to $C_6$ alkyl, $CF_3$, substituted or unsubstituted $C_6$ to $C_{30}$ aryl, and substituted or unsubstituted $C_2$ to $C_{30}$ heteroaryl; and

wherein the one or more substituents on $R^5$ are independently selected from D, halogen, F, CN, partially fluorinated $C_1$ to $C_6$ alkyl, perfluorinated $C_1$ to $C_6$ alkyl, $NO_2$, and $SF_5$.

According to one embodiment of the present invention, the compound of formula (II) is represented by formula (IIb)

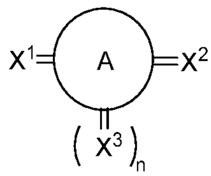

(IIb)

wherein n is an even integer including 0,

wherein $X^1$, $X^2$, and $X^3$ are independently selected from O, S, $CR^{1a}R^{2a}$, $CR^{1b}R^{2b}$, $NR^{3a}$, $NR^{3b}$;

wherein $R^{1a}$, $R^{2a}$, $R^{1b}$, and $R^{2b}$, are independently selected from halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$, substituted or unsubstituted $C_6$ to $C_{30}$ aryl, substituted or unsubstituted $C_3$ to $C_{30}$ heteroaryl,

wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;

wherein $R^{3a}$ and $R^{3b}$ is selected from CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,

wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;

wherein ring A is selected from substituted or unsubstituted $C_6$ to $C_{30}$ carbocycle or substituted or unsubstituted $C_3$ to C30 heterocycle, wherein the carbocycle or hetercycle can be selected from single rings, condensed ring system or rings connected via a double bond,

wherein the one or more substituents are independently selected from D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, $OCF_3$, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$,

wherein the one or more substituents are selected from D, halogen, Cl, F, partially fluorinated $C_1$ to $C_6$ alkyl, perfluorinated $C_1$ to $C_6$ alkyl, partially fluorinated $C_1$ to $C_6$ alkoxy, perfluorinated $C_1$ to $C_6$ alkoxy, $CF_3$, CN, $NO_2$, $SF_5$;

wherein the compound of formula (II) contains at least one substituted or unsubstituted aryl substituent or at least one substituted or unsubstituted heteroaryl substituent preferably at least one substituted aryl substituent or at least one substituted heteroaryl substituent.

According to an embodiment of the invention, the compound of formula (II) is represented by formula (IIc)

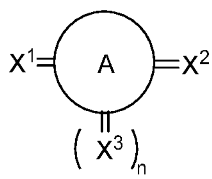

(IIc)

wherein n is an even integer including 0,

wherein $X^1$, $X^2$, and $X^3$ are independently selected from O, S, $CR^{13}R^{23}$, $CR^{1b}R^{2b}$, $NR^{3a}$, $NR^{3b}$;
wherein $R^{1a}$, $R^{2a}$, $R^{1b}$, and $R^{2b}$, are independently selected from halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$, substituted or unsubstituted $C_6$ to $C_{30}$ aryl, substituted or unsubstituted $C_3$ to $C_{30}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;
wherein $R^{3a}$ and $R^{3b}$ is selected from CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$,
wherein ring A is selected from

| | | |
|---|---|---|
| 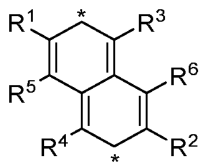 | 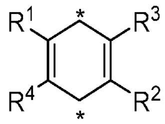 | 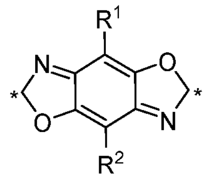 |
| 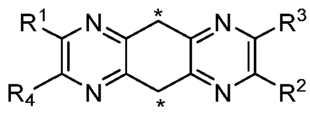 | 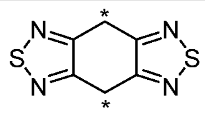 | 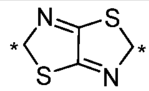 |
| 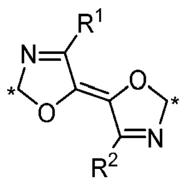 | 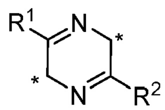 | 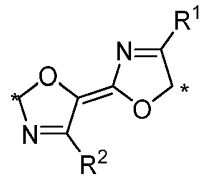 |
| 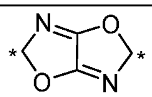 | 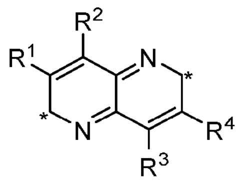 | 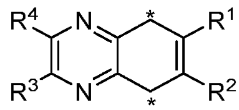 |
| 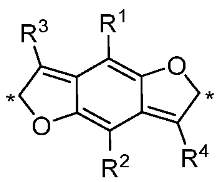 | 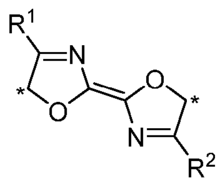 | 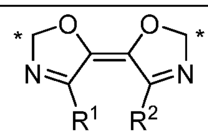 |
| 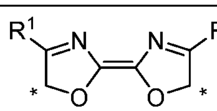 | 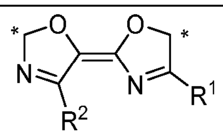 | |

wherein the asterisk "*" denotes the binding position;
wherein $R^1$, $R^2$, $R^3$, $R^4$, $R^5$, $R^6$, $R^7$ and $R^8$ are independently selected from D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, $OCF_3$, partially fluorinated $C_1$ to $C_6$ alkoxy, perfluorinated $C_1$ to $C_6$ alkoxy, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$,

wherein the one or more substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$.

wherein at least one of $R^{1a}$, $R^{2a}$, $R^{1b}$, $R^{2b}$, $R^{3a}$, $R^{3b}$, $R^1$, $R^2$, $R^3$, $R^4$, $R^5$, $R^6$, $R^7$ and $R^8$ is independently selected from a substituted or unsubstituted $C_6$ to $C_{30}$ aryl or substituted or unsubstituted $C_3$ to $C_{30}$ heteroaryl (preferably substituted phenyl or substituted $C_3$ to $C_5$ heteroaryl, and wherein preferably $C_3$ to $C_5$ heteroaryl is a six-member heteroaromatic ring).

According to an embodiment of the invention, the compound of formula (II) is represented by formula (IId)

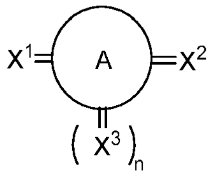

(IId)

wherein n is an even integer including 0,

wherein $X^1$, $X^2$, and $X^3$ are independently selected from O, S, $CR^{13}R^{23}$, $CR^{1b}R^{2b}$, $NR^{3a}$, $NR^{3b}$;

wherein $R^{1a}$, $R^{2a}$, $R^{1b}$, and $R^{2b}$, are independently selected from halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$, substituted or unsubstituted $C_6$ to $C_{30}$ aryl, substituted or unsubstituted $C_3$ to $C_{30}$ heteroaryl,

wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;

wherein $R^{3a}$ and $R^{3b}$ is selected from CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,

wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$,

wherein ring A is selected from

| | | |
|---|---|---|
| 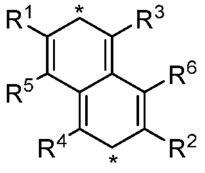 | 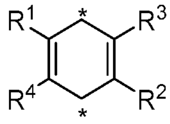 | 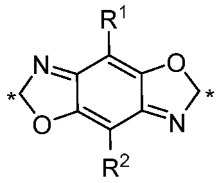 |
| 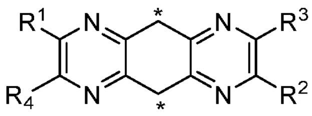 | 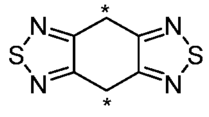 | 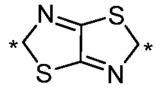 |
| 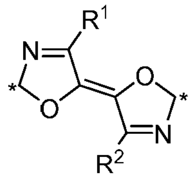 | 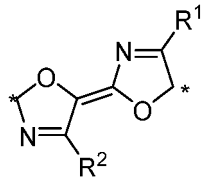 | 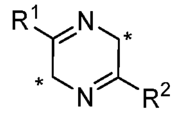 |
| 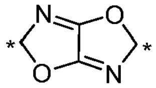 | 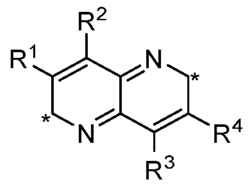 | 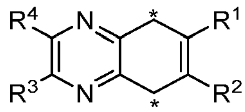 |
| 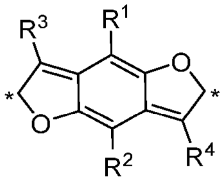 | 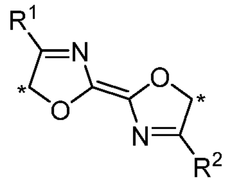 | 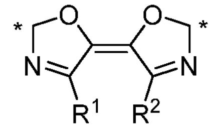 |
| 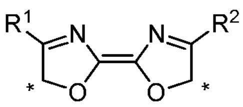 | 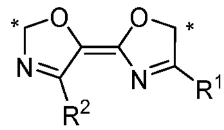 | |

wherein the asterisk "*" denotes the binding position;
wherein $R^1$, $R^2$, $R^3$, $R^4$, $R^5$, and $R^6$ are independently selected from D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, $OCF_3$, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$,
wherein the one or more substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;
wherein at least one of $R^{1a}$, $R^{2a}$, $R^{1b}$, $R^{2b}$, $R^{3a}$, $R^{3b}$, $R^1$, $R^2$, $R^3$, $R^4$, $R^5$, and $R^6$ is independently selected from a substituted or unsubstituted $C_6$ to $C_{30}$ aryl or substituted or unsubstituted $C_3$ to $C_{30}$ heteroaryl (preferably substituted $C_6$ to $C_{30}$ aryl or substituted $C_3$ to $C_{30}$ heteroaryl preferably, and more preferably substituted phenyl or substituted $C_3$ to $C_5$ heteroaryl and wherein preferably $C_3$ to $C_5$ heteroaryl is a six-member heteroaromatic ring).

According to an embodiment of the invention, the compound of formula (II) is represented by formula (IIe)

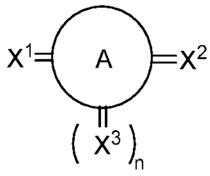

(IIe)

wherein n is an even integer including 0,

wherein $X^1$, $X^2$, and $X^3$ are independently selected from O, S, $CR^{1a}R^{2a}$, $CR^{1b}R^{2b}$, $NR^{3a}$, $NR^{3b}$;
wherein $R^{1a}$, $R^{2a}$, $R^{1b}$, and $R^{2b}$, are independently selected from halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$, substituted or unsubstituted $C_6$ to $C_{30}$ aryl, substituted or unsubstituted $C_3$ to $C_{30}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;
wherein $R^{3a}$ and $R^{3b}$ is selected from CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$,
wherein ring A is selected from

| | | |
|---|---|---|
| 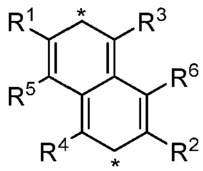 | 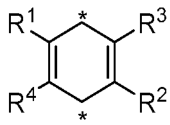 | 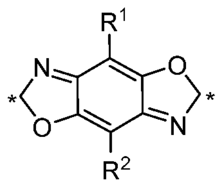 |
| 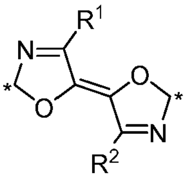 | 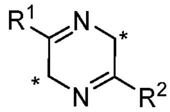 | 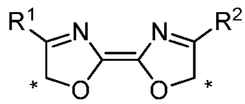 |
| 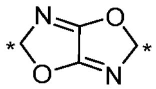 | 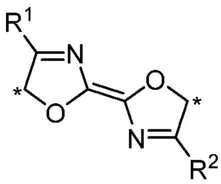 | 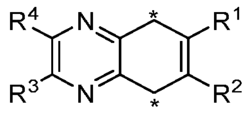 |
| 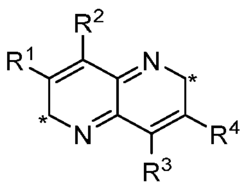 | 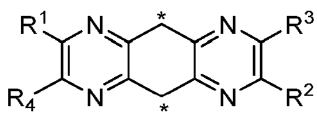 | |

wherein the asterisk "*" denotes the binding position;
wherein $R^1$, $R^2$, $R^3$, $R^4$, $R^5$, and $R^6$ are independently selected from D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, $OCF_3$, CN, isocyano, SCN, OCN, $NO_2$, $SF_5$,

wherein the one or more substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;

wherein at least one of $R^{1a}$, $R^{2a}$, $R^{1b}$, $R^{2b}$, $R^{3a}$, $R^{3b}$, $R^1$, $R^2$, $R^3$, $R^4$, $R^5$, and $R^6$ is independently selected from a substituted or unsubstituted $C_6$ to $C_{30}$ aryl or substituted or unsubstituted $C_3$ to $C_{30}$ heteroaryl (preferably substituted $C_6$ to $C_{30}$ aryl or substituted $C_3$ to $C_{30}$ heteroaryl preferably, and more preferably substituted phenyl or substituted $C_3$ to $C_5$ heteroaryl and wherein preferably $C_3$ to $C_5$ heteroaryl is a six-member heteroaromatic ring).

According to an embodiment of the invention, the compound of formula (II) is represented by formula (IIf)

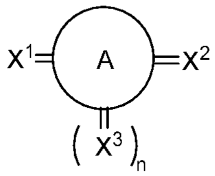

(IIf)

wherein n is an even integer including 0,

wherein $X^1$, $X^2$, and $X^3$ are independently selected from O, S, $CR^{1a}R^{2a}$, $CR^{1b}R^{2b}$, $NR^{3a}$, $NR^{3b}$;

wherein $R^{1a}$, $R^{2a}$, $R^{1b}$, and $R^{2b}$, are independently selected from halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$, substituted or unsubstituted $C_6$ to $C_{30}$ aryl, substituted or unsubstituted $C_3$ to $C_{30}$ heteroaryl,

wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;

wherein $R^{3a}$ and $R^{3b}$ is selected from CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,

wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$,

wherein ring A is selected from

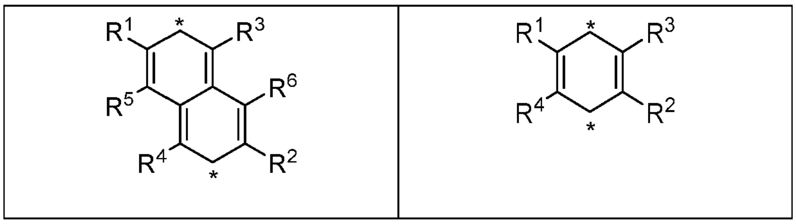

wherein the asterisk "*" denotes the binding position;

wherein $R^1$, $R^2$, $R^3$, $R^4$, $R^5$, and $R^6$ are independently selected from D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, $OCF_3$, CN, isocyano, SCN, OCN, $NO_2$, $SF_5$,

wherein the one or more substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;

wherein at least one of $R^{1a}$, $R^{2a}$, $R^{1b}$, $R^{2b}$, $R^{3a}$, $R^{3b}$, $R^1$, $R^2$, $R^3$, $R^4$, $R^5$, and $R^6$ is independently selected from a substituted or unsubstituted $C_6$ to $C_{30}$ aryl or substituted or unsubstituted $C_3$ to $C_{30}$ heteroaryl (preferably substituted $C_6$ to $C_{30}$ aryl or substituted $C_3$ to $C_{30}$ heteroaryl preferably, and more preferably substituted phenyl or substituted $C_3$ to $C_5$ heteroaryl and wherein preferably $C_3$ to $C_5$ heteroaryl is a six-member heteroaromatic ring).

According to an embodiment of the invention, the compound of formula (II) is represented by formula (IIg)

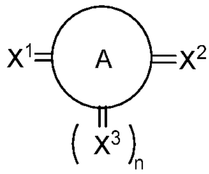

(IIg)

wherein n is an even integer including 0,

wherein $X^1$, $X^2$, and $X^3$ are independently selected from O, S, $CR^{1a}R^{2a}$, $CR^{1b}R^{2b}$, $NR^{3a}$, $NR^{3b}$;

wherein $R^{1a}$, $R^{2a}$, $R^{1b}$, and $R^{2b}$, are independently selected from halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$, substituted or unsubstituted $C_6$ to $C_{30}$ aryl, substituted or unsubstituted $C_3$ to $C_{30}$ heteroaryl,

wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;

wherein $R^{3a}$ and $R^{3b}$ is selected from CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,

wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$,

wherein ring A is selected from

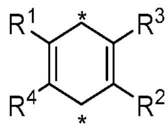

wherein the asterisk "*" denotes the binding position;

wherein $R^1$, $R^2$, $R^3$, and $R^4$ are independently selected from D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, $OCF_3$, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$,

wherein the one or more substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;

wherein at least one of $R^{1a}$, $R^{2a}$, $R^{1b}$, $R^{2b}$, $R^{3a}$, $R^{3b}$, $R^1$, $R^2$, $R^3$, and $R^4$ is independently selected from a substituted or unsubstituted $C_6$ to $C_{30}$ aryl or substituted or unsubstituted $C_3$ to $C_{30}$ heteroaryl (preferably substituted $C_6$ to $C_{30}$ aryl or substituted $C_3$ to $C_{30}$ heteroaryl preferably, and more preferably substituted phenyl or substituted $C_3$ to $C_5$ heteroaryl and wherein preferably $C_3$ to $C_5$ heteroaryl is a six-member heteroaromatic ring).

According to one embodiment of the present invention, in formulae (IIa) to (IIg) - wherever applicable - n is an integer selected from 0, 2, 4, preferably from 0, 2, and most preferably from 0.

According to one embodiment of the present invention, in formulae (IIa) to (IIg) - wherever applicable - the at least one aryl substituent or the at least one heteroaryl substituent is selected from

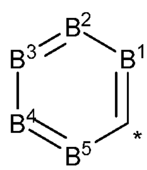

$B^1$ is selected from $CL^1$ or N;
$B^2$ is selected from $CL^2$ or N;
$B^3$ is selected from $CL^3$ or N;

$B^4$ is selected from $CL^4$ or N;
$B^5$ is selected from $CL^5$ or N;
$L^1$, $L^2$, $L^3$, $L^4$, and $L^5$ are independently selected from CN, isocyano, SCN, OCN, $NO_2$, $SF_5$, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H; wherein the asterisk "*" denotes the binding position.

According to one embodiment of the present invention, in formulae (IIa) to (IIg) - wherever applicable - the at least one aryl substituent or the at least one heteroaryl substituent is selected from

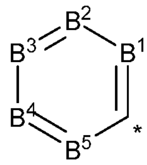

$B^1$ is selected from $CL^1$ or N;
$B^2$ is selected from $CL^2$ or N;
$B^3$ is selected from $CL^3$ or N;
$B^4$ is selected from $CL^4$ or N;
$B^5$ is selected from $CL^5$ or N;
$L^1$, $L^2$, $L^3$, $L^4$, and $L^5$ are independently selected from CN, partially fluorinated $C_1$ to $C_6$ alkyl, perfluorinated $C_1$ to $C_6$ alkyl, $CF_3$, $OCF_3$, halogen, Cl, F, D or H; wherein the asterisk "*" denotes the binding position.

According to one embodiment of the present invention, in formulae (IIa) to (IIg) - wherever applicable - the at least one aryl substituent or the at least one heteroaryl substituent is selected from

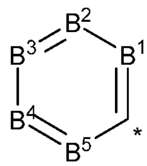

$B^1$ is selected from $CL^1$ or N;
$B^2$ is selected from $CL^2$ or N;
$B^3$ is selected from $CL^3$ or N;
$B^4$ is selected from $CL^4$ or N;
$B^5$ is selected from $CL^5$ or N;
$L^1$, $L^2$, $L^3$, $L^4$, and $L^5$ are independently selected from CN, partially fluorinated $C_1$ to $C_6$ alkyl, perfluorinated $C_1$ to $C_6$ alkyl, $CF_3$, halogen, Cl, F, D or H, wherein the asterisk "*" denotes the binding position.

According to one embodiment of the present invention, in formulae (IIa) to (IIg) - wherever applicable - the at least one aryl substituent or the at least one heteroaryl substituent is selected from

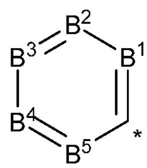

$B^1$ is selected from $CL^1$ or N;
$B^2$ is selected from $CL^2$ or N;
$B^3$ is selected from $CL^3$ or N;
$B^4$ is selected from $CL^4$ or N;
$B^5$ is selected from $CL^5$ or N;
$L^1$, $L^2$, $L^3$, $L^4$, and $L^5$ are independently selected from CN, partially fluorinated $C_1$ to $C_6$ alkyl, perfluorinated $C_1$ to $C_6$ alkyl, $CF_3$, halogen, Cl, F, D or H, wherein the asterisk "*" denotes the binding position.

According to one embodiment of the present invention, in formulae (IIa) to (IIg) - wherever applicable - the at least one aryl substituent or the at least one heteroaryl substituent is selected from

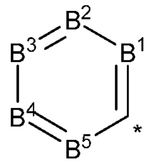

$B^1$ is selected from $CG^1$ or N;
$B^2$ is selected from $CG^2$ or N;
$B^3$ is selected from $CG^3$ or N;
$B^4$ is selected from $CG^4$ or N;
$B^5$ is selected from $CG^5$ or N;
$L^1$, $L^2$, $L^3$, $L^4$, and $L^5$ are independently selected from CN, $CF_3$, halogen, Cl, F, D or H, wherein the asterisk "*" denotes the binding position.

According to one embodiment of the present invention, in formulae (IIa) to (IIg) - wherever applicable - the at least one aryl substituent or the at least one heteroaryl substituent is selected from

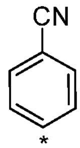 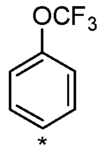 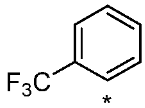 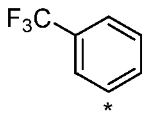 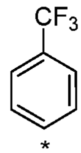

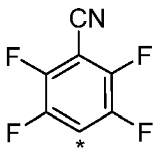 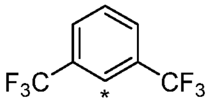 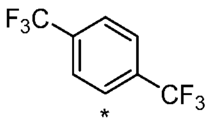 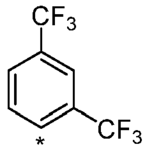 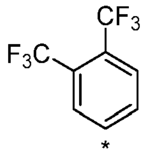

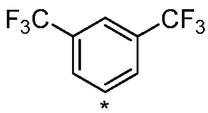 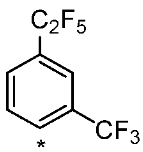 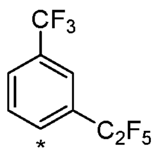 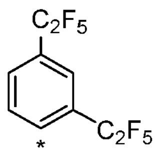 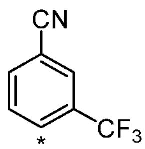

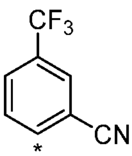 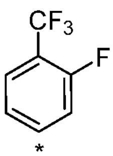 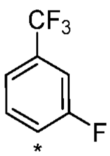 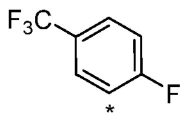 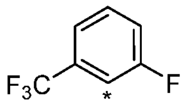

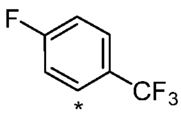 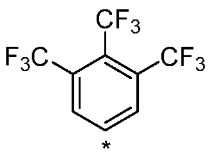 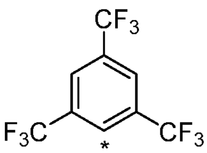 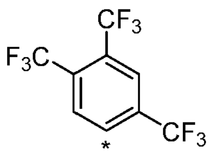 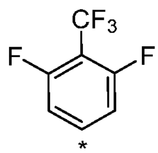

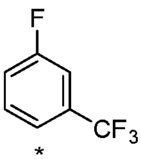 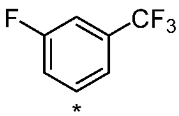 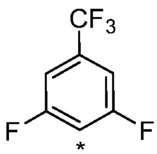 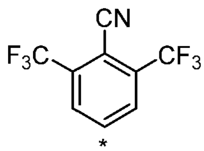

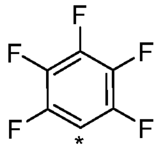 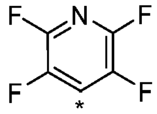 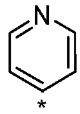 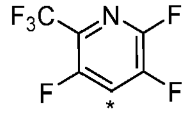 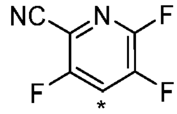

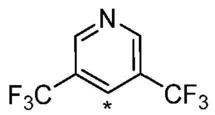 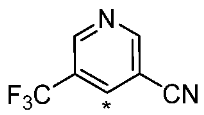 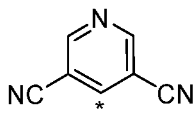 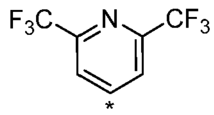 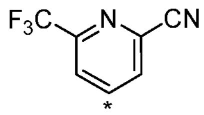

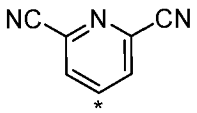 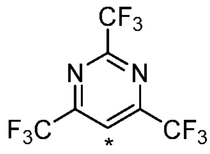 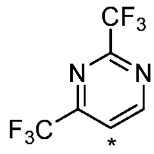 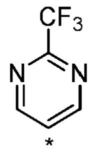 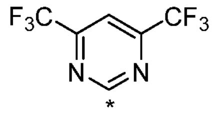

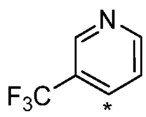 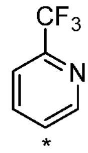 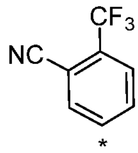 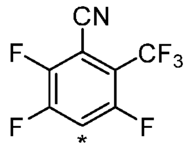 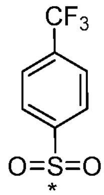

wherein the asterisk "*" denotes the binding position.

According to one embodiment of the present invention, in formulae (IIa) to (IIg) - wherever applicable - $X^1$, $X^2$ and $X^3$ are independently selected from $CR^{1a}R^{2a}$, $CR^{1b}R^{2b}$, $NR^{3a}$, and $NR^{3b}$, preferably from $CR^{1a}R^{2a}$, $CR^{1b}R^{2b}$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, wherein $R^{1a}$, $R^{2a}$, $R^{1b}$, and $R^{2b}$, are independently selected from halogen, Cl, F, partially fluorinated $C_1$ to $C_4$ alkyl, perfluorinated $C_1$ to $C_4$ alkyl, $CF_3$, partially fluorinated $C_1$ to $C_4$ alkoxy, perfluorinated $C_1$ to $C_4$ alkoxy, $OCF_3$, CN, isocyano, SCN, OCN, $NO_2$, $SF_5$, substituted or unsubstituted $C_6$ to $C_{24}$ aryl, substituted or unsubstituted $C_3$ to $C_{24}$ heteroaryl,
wherein the one or more substituents are independently selected from D, halogen, Cl, F, partially fluorinated $C_1$ to $C_4$ alkyl, perfluorinated $C_1$ to $C_4$ alkyl, $CF_3$, partially fluorinated $C_1$ to $C_4$ alkoxy, perfluorinated $C_1$ to $C_4$ alkoxy, $OCF_3$, CN, isocyano, SCN, OCN, $NO_2$, $SF_5$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, wherein $R^{1a}$, $R^{2a}$, $R^{1b}$, and $R^{2b}$ are independently selected from halogen, Cl, F, partially fluorinated $C_1$ to $C_6$ alkyl, perfluorinated $C_1$ to $C_4$ alkyl, $CF_3$, partially fluorinated $C_1$ to $C_4$ alkoxy, perfluorinated $C_1$ to $C_4$ alkoxy, $OCF_3$, CN, isocyano, SCN, OCN, $NO_2$, $SF_5$, substituted or unsubstituted $C_6$ to $C_{18}$ aryl, substituted or unsubstituted $C_3$ to $C_{18}$ heteroaryl,
wherein the one or more substituents are independently selected from D, halogen, Cl, F, partially fluorinated $C_1$ to $C_4$ alkyl, perfluorinated $C_1$ to $C_4$ alkyl, $CF_3$, partially fluorinated $C_1$ to $C_4$ alkoxy, perfluorinated $C_1$ to $C_4$ alkoxy, $OCF_3$, CN, isocyano, SCN, OCN, $NO_2$, $SF_5$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, wherein $R^{1a}$, $R^{2a}$, $R^{1b}$, and $R^{2b}$ are independently selected from halogen, Cl, F, partially fluorinated $C_1$ to $C_6$ alkyl, perfluorinated $C_1$ to $C_4$ alkyl, $CF_3$, partially fluorinated $C_1$ to $C_4$ alkoxy, perfluorinated $C_1$ to $C_4$ alkoxy, $OCF_3$, CN, isocyano, SCN, OCN, $NO_2$, $SF_5$, substituted or unsubstituted $C_6$ to $C_{12}$ aryl, substituted or unsubstituted $C_3$ to $C_{11}$ heteroaryl,
wherein the one or more substituents are independently selected from D, halogen, Cl, F, partially fluorinated $C_1$ to $C_4$ alkyl, perfluorinated $C_1$ to $C_4$ alkyl, $CF_3$, partially fluorinated $C_1$ to $C_4$ alkoxy, perfluorinated $C_1$ to $C_4$ alkoxy, $OCF_3$, CN, isocyano, SCN, OCN, $NO_2$, $SF_5$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, wherein $R^{1a}$, $R^{2a}$, $R^{1b}$, and $R^{2b}$ are independently selected from halogen, Cl, F, partially fluorinated $C_1$ to $C_6$ alkyl, perfluorinated $C_1$ to $C_4$ alkyl, $CF_3$, partially fluorinated $C_1$ to $C_4$ alkoxy, perfluorinated $C_1$ to $C_4$ alkoxy, $OCF_3$, CN, isocyano, SCN, OCN, $NO_2$, $SF_5$, substituted or unsubstituted $C_6$ to $C_{10}$ aryl, substituted or unsubstituted $C_3$ to $C_9$ heteroaryl,
wherein the one or more substituents are independently selected from D, halogen, Cl, F, partially fluorinated $C_1$ to $C_4$ alkyl, perfluorinated $C_1$ to $C_4$ alkyl, $CF_3$, partially fluorinated $C_1$ to $C_4$ alkoxy, perfluorinated $C_1$ to $C_4$ alkoxy, $OCF_3$, CN, isocyano,

SCN, OCN, $NO_2$, $SF_5$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, wherein $R^{1a}$, $R^{2a}$, $R^{1b}$, and $R^{2b}$ are independently selected from halogen, Cl, F, partially fluorinated $C_1$ to $C_6$ alkyl, perfluorinated $C_1$ to $C_4$ alkyl, $CF_3$, partially fluorinated $C_1$ to $C_4$ alkoxy, perfluorinated $C_1$ to $C_4$ alkoxy, $OCF_3$, CN, isocyano, SCN, OCN, $NO_2$, $SF_5$, substituted or unsubstituted $C_6$ aryl, substituted or unsubstituted $C_3$ to $C_5$ heteroaryl, wherein preferably $C_3$ to $C_5$ heteroaryl is a six-member heteroaromatic ring,

wherein the one or more substituents are independently selected from D, halogen, Cl, F, partially fluorinated $C_1$ to $C_4$ alkyl, perfluorinated $C_1$ to $C_4$ alkyl, $CF_3$, partially fluorinated $C_1$ to $C_4$ alkoxy, perfluorinated $C_1$ to $C_4$ alkoxy, $OCF_3$, CN, isocyano, SCN, OCN, $NO_2$, $SF_5$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, $R^{2a}$ and $R^{2b}$ are independently selected from Cl, F, $CF_3$, CN, and

wherein $R^{1a}$, and $R^{1b}$ are selected from substituted or unsubstituted $C_6$ to $C_{30}$ aryl, substituted or unsubstituted $C_3$ to $C_{30}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$.

According to one embodiment of the present invention, $X^1$ and $X^2$ are independently selected from $CR^{1a}R^{2a}$, $CR^{1b}R^{2b}$, wherein $R^{2a}$ and $R^{2b}$ are independently selected from Cl, F, $CF_3$, CN, and

wherein $R^{1a}$, and $R^{1b}$ are selected from substituted or unsubstituted $C_6$ to $C_{24}$ aryl, substituted or unsubstituted $C_3$ to $C_{24}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, wherein $R^{2a}$ and $R^{2b}$ are independently selected from Cl, F, $CF_3$, CN, and

wherein $R^{1a}$, and $R^{1b}$ are selected from substituted or unsubstituted $C_6$ to $C_{18}$ aryl, substituted or unsubstituted $C_3$ to $C_{18}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, wherein $R^{2a}$ and $R^{2b}$ are independently selected from Cl, F, $CF_3$, CN, and

wherein $R^{1a}$, and $R^{1b}$ are selected from substituted or unsubstituted $C_6$ to $C_{12}$ aryl, substituted or unsubstituted $C_3$ to $C_{11}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, wherein $R^{2a}$ and $R^{2b}$ are independently selected from Cl, F, $CF_3$, CN, and

wherein $R^{1a}$, and $R^{1b}$ are selected from substituted or unsubstituted $C_6$ to $C_{10}$ aryl, substituted or unsubstituted $C_3$ to $C_9$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, wherein $R^{2a}$ and $R^{2b}$ are independently selected from Cl, F, $CF_3$, CN, and

wherein $R^{1a}$, and $R^{1b}$ are selected from substituted or unsubstituted $C_6$ aryl, substituted or unsubstituted $C_3$ to $C_5$ heteroaryl, and wherein preferably $C_3$ to $C_5$ heteroaryl is a six-member heteroaromatic ring,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, wherein $R^{2a}$ and $R^{2b}$ are independently selected from CN, and

wherein $R^{1a}$, and $R^{1b}$ are selected from substituted or unsubstituted $C_6$ aryl, substituted or unsubstituted $C_3$ to $C_5$ heteroaryl, and wherein preferably $C_3$ to $C_5$ heteroaryl is a six-member heteroaromatic ring,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$.

According to one embodiment of the present invention, in formulae (IIa) to (IIg) - wherever applicable - $X^1$ and $X^2$ are independently selected from $CR^{1a}R^{2a}$, $CR^{1b}R^{2b}$, wherein $R^{2a}$ and $R^{2b}$ are independently selected from CN, and

wherein $R^{1a}$, and $R^{1b}$ are selected from substituted $C_6$ aryl, substituted $C_3$ to $C_5$ heteroaryl, and wherein preferably $C_3$ to $C_5$ heteroaryl is a six-member heteroaromatic ring,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$.

According to one embodiment of the present invention, in formulae (IIa) to (IIg) - wherever applicable - $X^1$ is selected from formula (XXa)

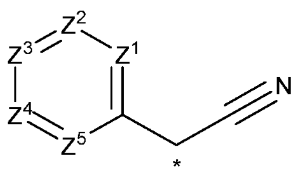

(XXa)

wherein

$Z^1$ is selected from $CY^1$ or N;
$Z^2$ is selected from $CY^2$ or N;
$Z^3$ is selected from $CY^3$ or N;
$Z^4$ is selected from $CY^4$ or N;
$Z^5$ is selected from $CY^5$ or N;
wherein
$Y^1$, $Y^2$, $Y^3$, $Y^4$, and $Y^5$ are independently selected from CN, isocyano, SCN, OCN, $NO_2$, $SF_5$, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H; wherein the asterisk "*" denotes the binding position.

According to one embodiment of the present invention, in formulae (IIa) to (IIg) - wherever applicable - $X^1$ is selected from formula (XXa)

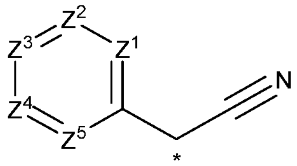

(XXa)

wherein

$Z^1$ is selected from $CY^1$ or N;
$Z^2$ is selected from $CY^2$ or N;
$Z^3$ is selected from $CY^3$ or N;
$Z^4$ is selected from $CY^4$ or N;
$Z^5$ is selected from $CY^5$ or N;
wherein
$Y^1$, $Y^2$, $Y^3$, $Y^4$, and $Y^5$ are independently selected from CN, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H, wherein the asterisk "*" denotes the binding position.

According to one embodiment of the present invention, in formulae (IIa) to (IIg) - wherever applicable - $X^1$ is selected from formula (XXa)

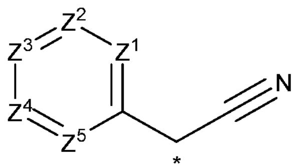

(XXa)

wherein

$Z^1$ is selected from $CY^1$ or N;
$Z^2$ is selected from $CY^2$ or N;
$Z^3$ is selected from $CY^3$ or N;
$Z^4$ is selected from $CY^4$ or N;
$Z^5$ is selected from $CY^5$ or N;
wherein
$Y^1$, $Y^2$, $Y^3$, $Y^4$, and $Y^5$ are independently selected from CN, partially fluorinated $C_1$ to $C_6$ alkyl, perfluorinated $C_1$ to $C_6$ alkyl, $CF_3$, halogen, Cl, F, D or H; wherein the asterisk "*" denotes the binding position.

According to one embodiment of the present invention, in formulae (IIa) to (IIg) - wherever applicable - $X^1$ is selected from formula (XXa)

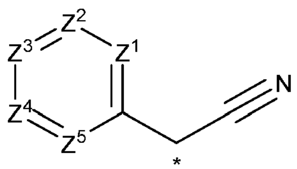

(XXa)

wherein

$Z^1$ is selected from $CY^1$ or N;
$Z^2$ is selected from $CY^2$ or N;
$Z^3$ is selected from $CY^3$ or N;
$Z^4$ is selected from $CY^4$ or N;
$Z^5$ is selected from $CY^5$ or N;

wherein

$Y^1$, $Y^2$, $Y^3$, $Y^4$, and $Y^5$ are independently selected from CN, $CF_3$, halogen, Cl, F, D or H; wherein the asterisk "*" denotes the binding position.

According to one embodiment of the present invention, in formulae (IIa) to (IIg) - wherever applicable - $X^1$ is selected from formula (XXa)

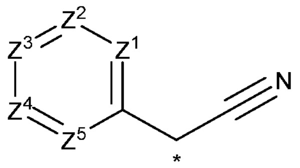

(XXa)

wherein

$Z^1$ is selected from $CY^1$ or N;
$Z^2$ is selected from $CY^2$ or N;
$Z^3$ is selected from $CY^3$ or N;
$Z^4$ is selected from $CY^4$ or N;
$Z^5$ is selected from $CY^5$ or N;
wherein
$Y^1$, $Y^2$, $Y^3$, $Y^4$, and $Y^5$ are independently selected from CN, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H,
$X^2$ is selected from formula (XXb)

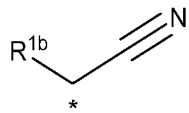

(XXb)

wherein

$R^{1b}$ is selected from substituted or unsubstituted $C_6$ to $C_{19}$ aryl, substituted or unsubstituted $C_6$ to $C_{19}$ aryl with one, two or three aromatic six-member rings, substituted or unsubstituted $C_9$ to $C_{19}$ aryl with two or three fused aromatic six-member rings, substituted or unsubstituted $C_6$ to $C_{12}$ aryl with one or two aromatic six-member rings, substituted or unsubstituted phenyl, substituted or unsubstituted biphenyl, substituted or unsubstituted $C_3$ to $C_{20}$ heteroaryl, substituted or unsubstituted $C_3$ to $C_{20}$ heteroaryl with one, two or three aromatic six-member rings, substituted or unsubstituted $C_7$ to $C_{20}$ heteroaryl with two or three fused aromatic six-member rings or CN, wherein the substituents are selected from CN, partially fluorinated or perfluorinated $C_1$ to $C_6$ alkyl, halogen, Cl, F, C1 to C6 alkyl or D; wherein the asterisk "*" denotes the binding position; wherein the six-member rings are aromatic six member rings.

According to one embodiment of the present invention, in formulae (IIa) to (IIg) - wherever applicable - $X^1$ and/or $X^2$ are independently selected from

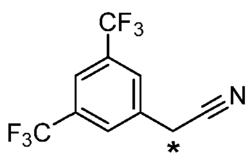

(X1),

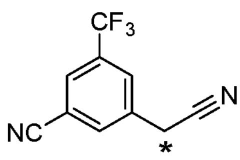

(X2),

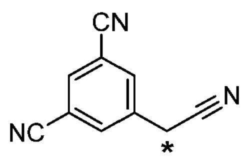

(X3),

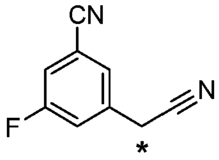 (X4), 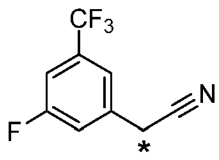 (X5), 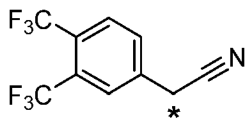 (X6),

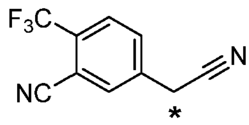 (X7), 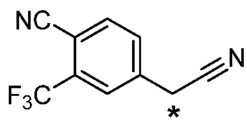 (X8), 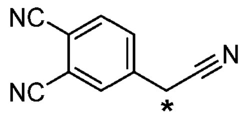 (X9),

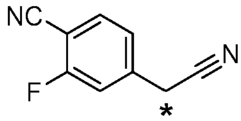 (X10), 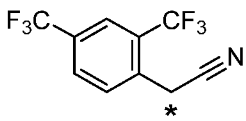 (X11), 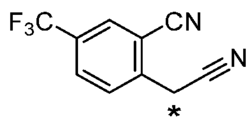 (X12),

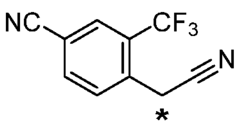 (X13), 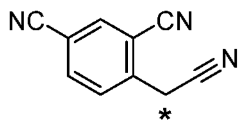 (X14), 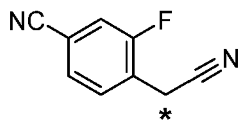 (X15),

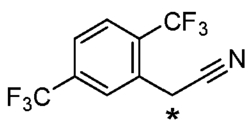 (X16), 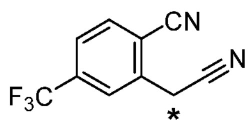 (X17), 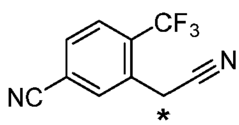 (X18),

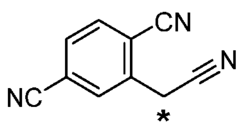 (X19), 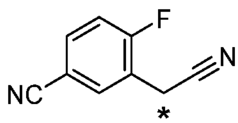 (X20), 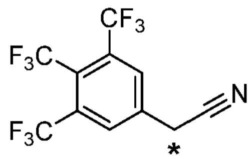 (X21),

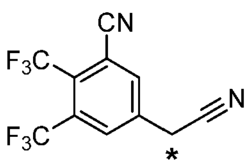 (X22), 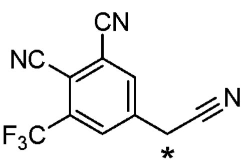 (X23), 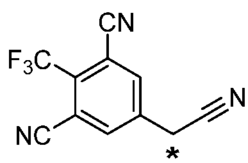 (X24),

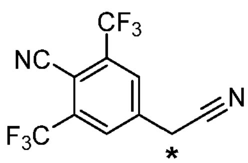 (X25), 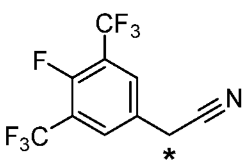 (X26), 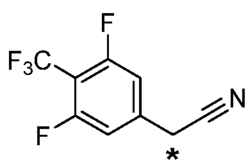 (X27),

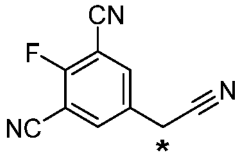 (X28), 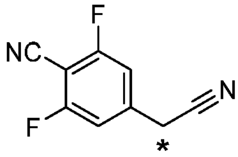 (X29), 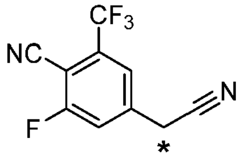 (X30),

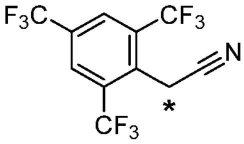 (X31), 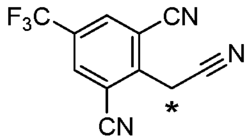 (X32), 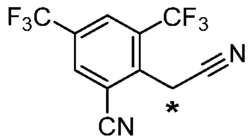 (X33),

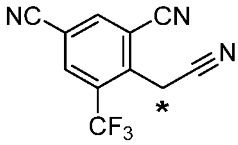 (X34), 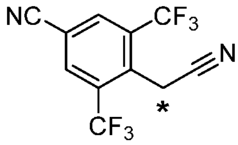 (X35), 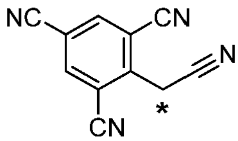 (X36),

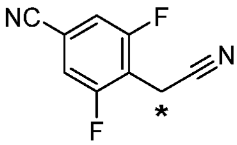 (X37), 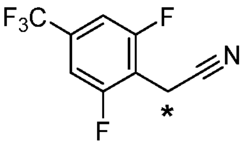 (X38), 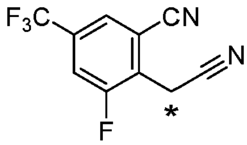 (X39),

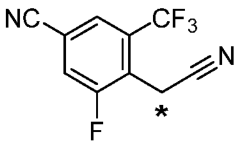 (X40), 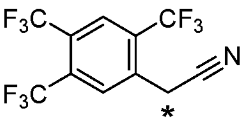 (X41), 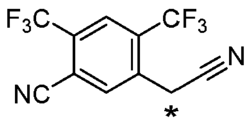 (X42),

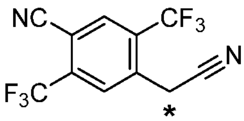 (X43), 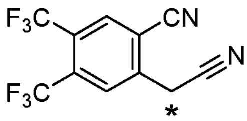 (X44), 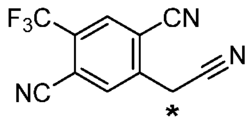 (X45),

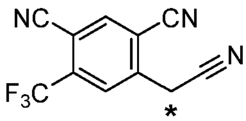 (X46), 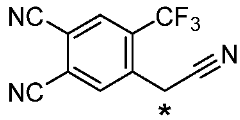 (X47), 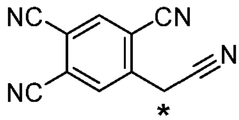 (X48),

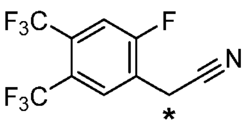 (X49), 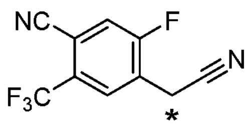 (X50), 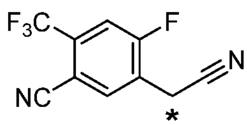 (X51),

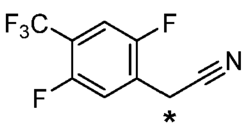 (X52), 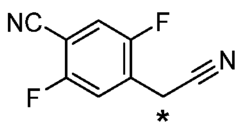 (X53), 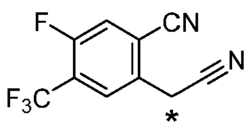 (X54),

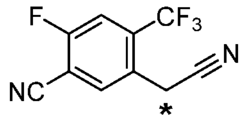 (X55), 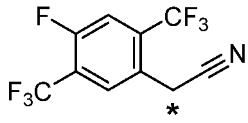 (X56), 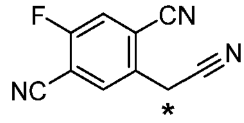 (X57),

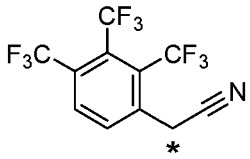 (X58), 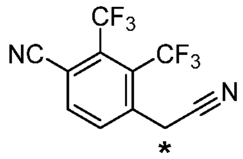 (X59), 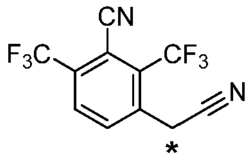 (X60),

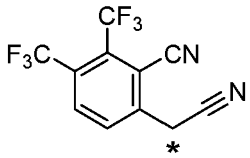 (X61), 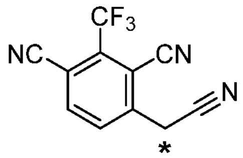 (X62), 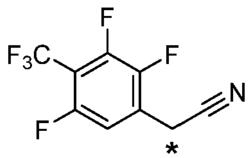 (X63),

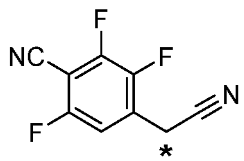 (X64), 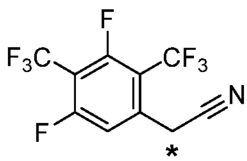 (X65), 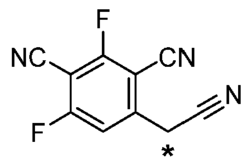 (X66),

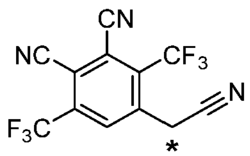 (X67), 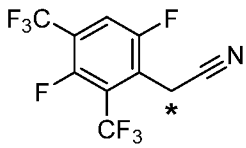 (X68), 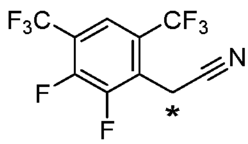 (X69),

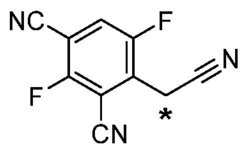 (X70), 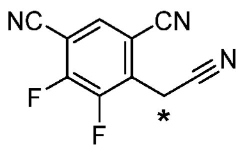 (X71), 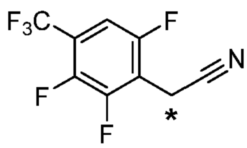 (X72),

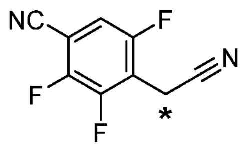 (X73), 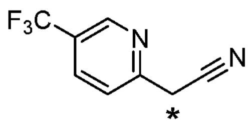 (X74), 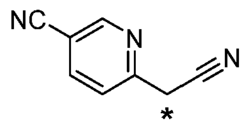 (X75),

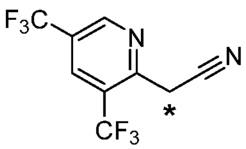 (X76), 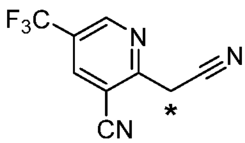 (X77), 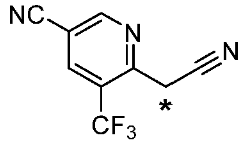 (X78),

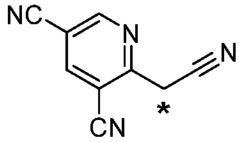 (X79), 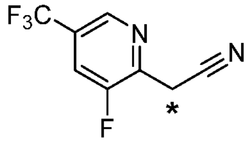 (X80), 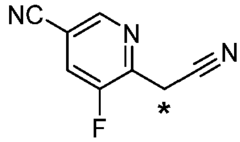 (X81),

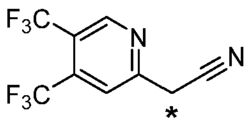 (X82), 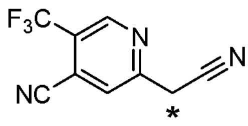 (X83), 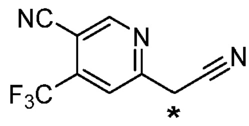 (X84),

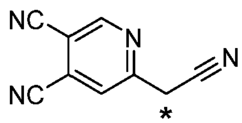 (X85), 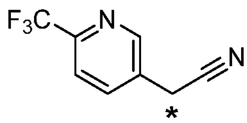 (X86), 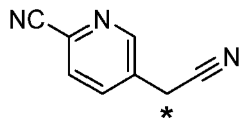 (X87),

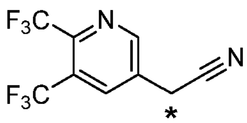 (X88), 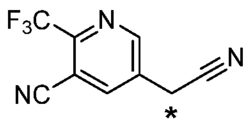 (X89), 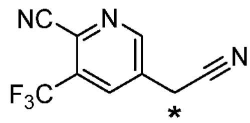 (X90),

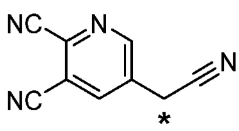 (X91), 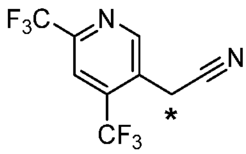 (X92), 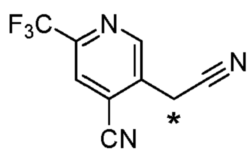 (X93),

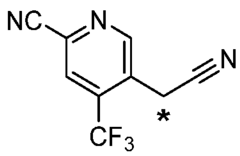 (X94), 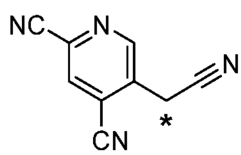 (X95), 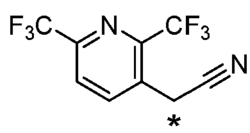 (X96),

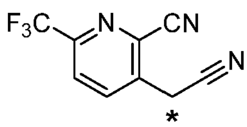 (X97), 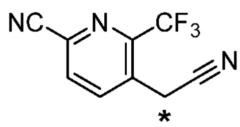 (X98), 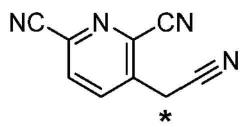 (X99),

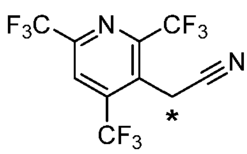 (X100), 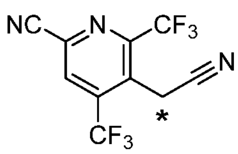 (X101), 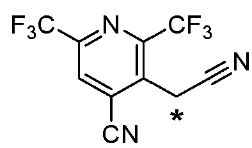 (X102),

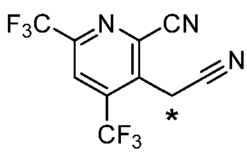 (X103), 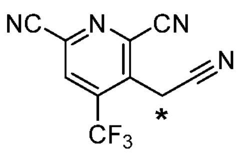 (X104), 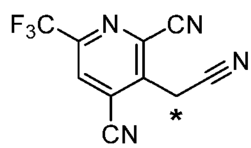 (X105),

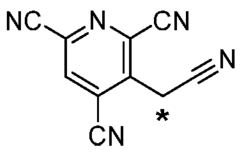 (X106), 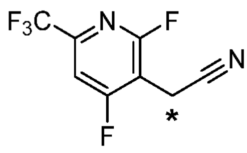 (X107), 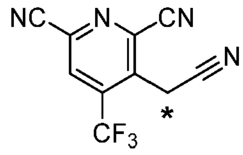 (X108),

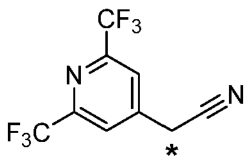 (X109), 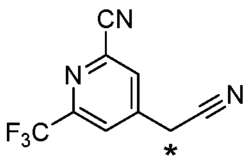 (X110), 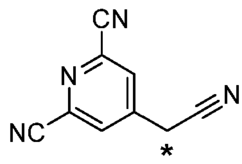 (X111),

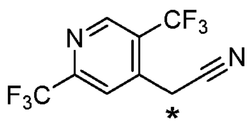 (X112), 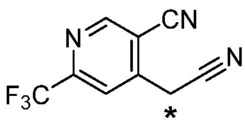 (X113), 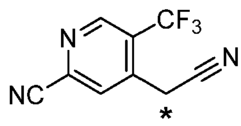 (X114),

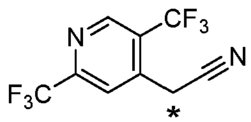 (X115), 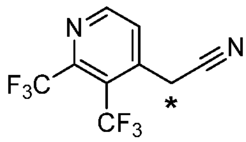 (X116), 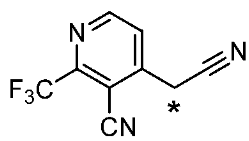 (X117),

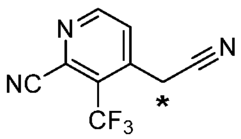 (X118), 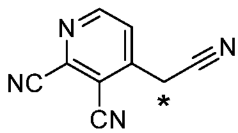 (X119), 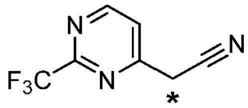 (X120),

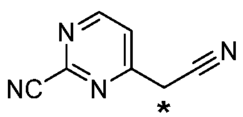 (X121), 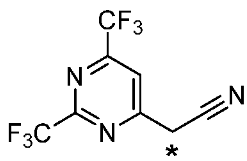 (X122), 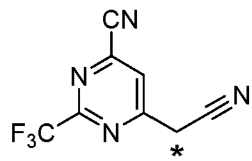 (X123),

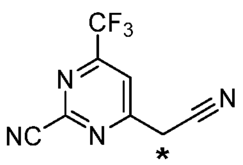 (X124), 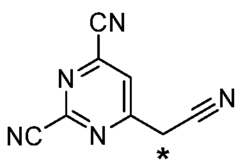 (X125), 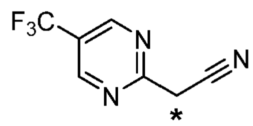 (X126),

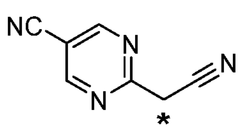 (X127), 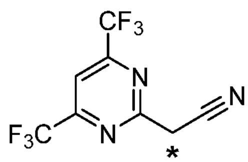 (X128), 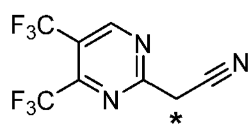 (X129),

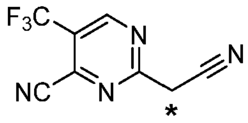 (X130), 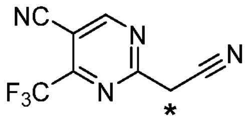 (X131), 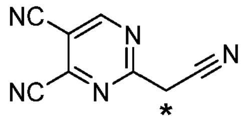 (X132),

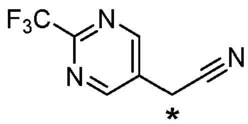 (X133), 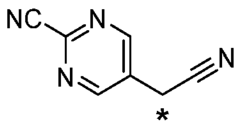 (X134), 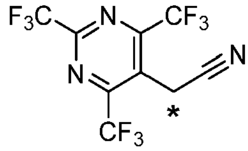 (X135),

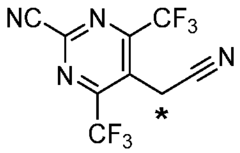 (X136), 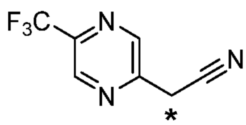 (X137), 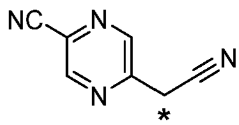 (X138),

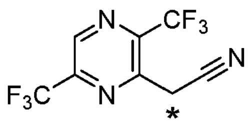 (X139), 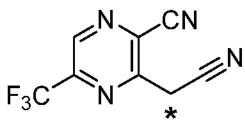 (X140), 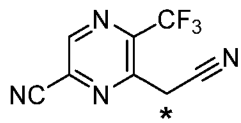 (X141),

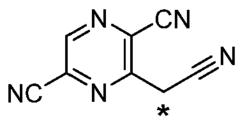 (X142), 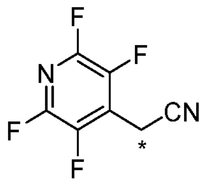 (X143);

wherein the "*" denotes the binding position.

According to one embodiment of the present invention, in formulae (IIa) to (IIg) - wherever applicable - at least one $R^1$, $R^2$, $R^3$, $R^4$, $R^5$, $R^6$, $R^7$ and $R^8$ is selected from

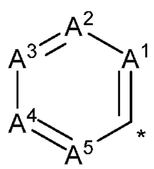

$A^1$ is selected from $CG^1$ or N;
$A^2$ is selected from $CG^2$ or N;
$A^3$ is selected from $CG^3$ or N;
$A^4$ is selected from $CG^4$ or N;
$A^5$ is selected from $CG^5$ or N;
$G^1$, $G^2$, $G^3$, $G^4$, and $G^5$ are independently selected from CN, isocyano, SCN, OCN, $NO_2$, $SF_5$, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H, wherein the asterisk "*" denotes the binding position.

According to one embodiment of the present invention, in formulae (IIa) to (IIg) - wherever applicable - at least one $R^1$, $R^2$, $R^3$, $R^4$, $R^5$, $R^6$, $R^7$ and $R^8$ is selected from

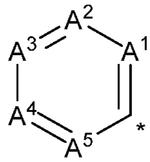

$A^1$ is selected from $CG^1$ or N;
$A^2$ is selected from $CG^2$ or N;
$A^3$ is selected from $CG^3$ or N;
$A^4$ is selected from $CG^4$ or N;
$A^5$ is selected from $CG^5$ or N;
$G^1$, $G^2$, $G^3$, $G^4$, and $G^5$ are independently selected from CN, partially fluorinated $C_1$ to $C_6$ alkyl, perfluorinated $C_1$ to $C_6$ alkyl, $CF_3$, $OCF_3$, halogen, Cl, F, D or H; wherein the asterisk "*" denotes the binding position.

According to one embodiment of the present invention, in formulae (IIa) to (IIg) - wherever applicable - at least one $R^1$, $R^2$, $R^3$, $R^4$, $R^5$, $R^6$, $R^7$ and $R^8$ is selected from

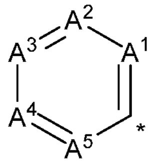

$A^1$ is selected from $CG^1$ or N;
$A^2$ is selected from $CG^2$ or N;
$A^3$ is selected from $CG^3$ or N;
$A^4$ is selected from $CG^4$ or N;
$A^5$ is selected from $CG^5$ or N;
$G^1$, $G^2$, $G^3$, $G^4$, and $G^5$ are independently selected from CN, partially fluorinated $C_1$ to $C_6$ alkyl, perfluorinated $C_1$ to $C_6$ alkyl, $CF_3$, halogen, Cl, F, D or H; wherein the asterisk "*" denotes the binding position.

According to one embodiment of the present invention, in formulae (IIa) to (IIg) - wherever applicable - at least one $R^1$, $R^2$, $R^3$, $R^4$, $R^5$, $R^6$, $R^7$ and $R^8$ is selected from

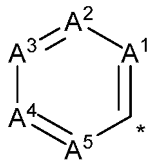

$A^1$ is selected from $CG^1$ or N;
$A^2$ is selected from $CG^2$ or N;
$A^3$ is selected from $CG^3$ or N;
$A^4$ is selected from $CG^4$ or N;
$A^5$ is selected from $CG^5$ or N;
$G^1$, $G^2$, $G^3$, $G^4$, and $G^5$ are independently selected from CN, $CF_3$, halogen, Cl, F, D or H; wherein the asterisk "*" denotes the binding position.

According to one embodiment of the present invention, in formulae (IIa) to (IIg) - wherever applicable - at least one $R^1$, $R^2$, $R^3$, $R^4$, $R^5$, $R^6$, $R^7$ and $R^8$ is independently selected from

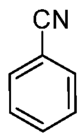 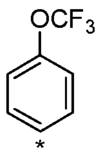 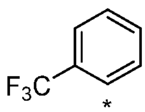 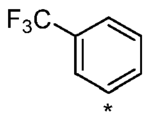 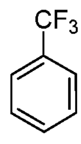

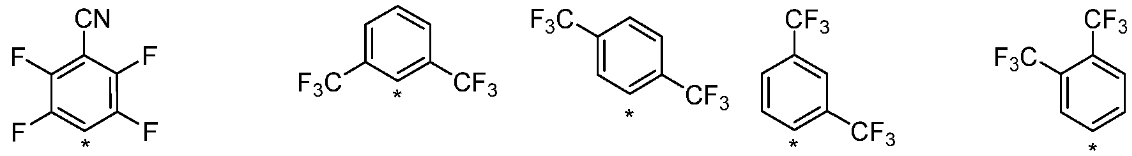

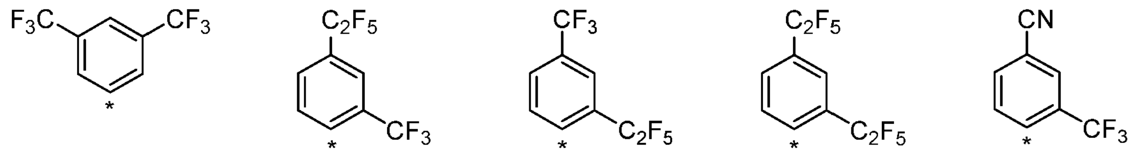

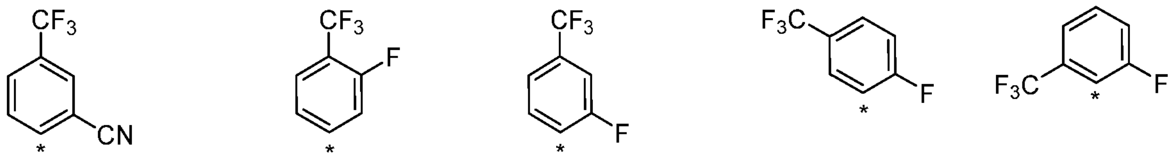

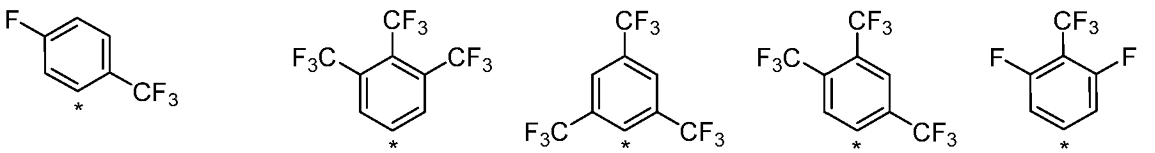

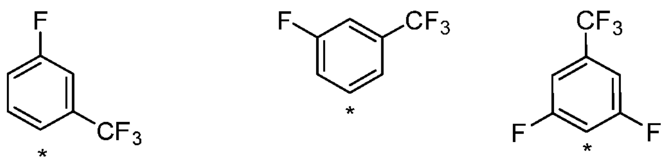

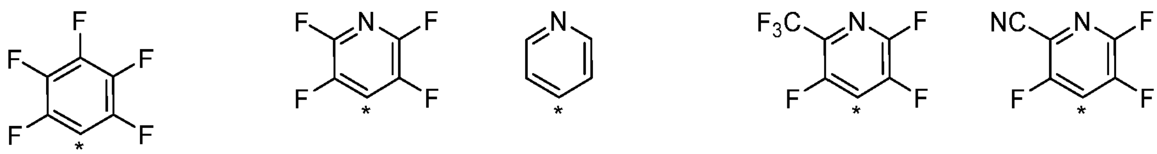

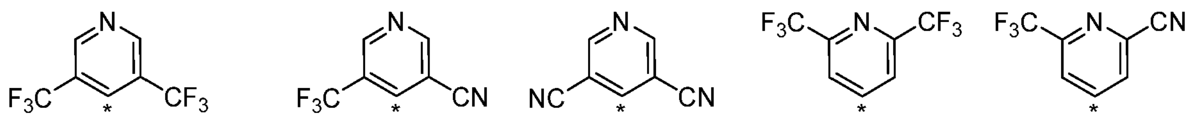

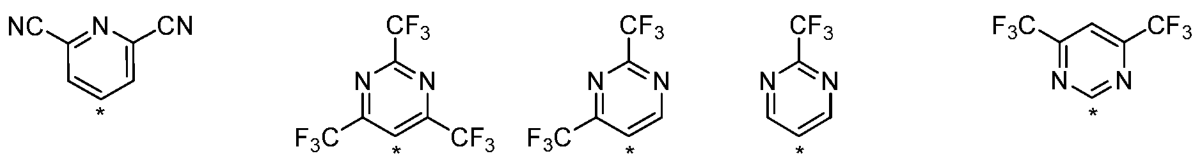

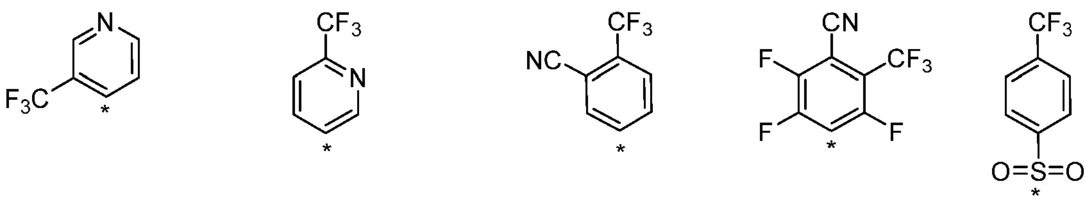

wherein the asterisk "*" denotes the binding position.

According to one embodiment of the present invention, the compound of formula (II) is represented by formula

(IIh):

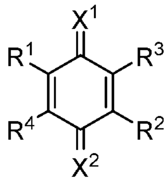

(IIh)

wherein

$R^1$, $R^2$, $R^3$ and $R^4$ are independently selected form F, Cl, CN or $CF_3$;

$X^1$ is selected from formula (XXa)

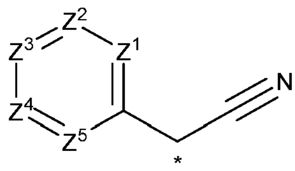

(XXa)

wherein

$Z^1$ is selected from $CY^1$ or N;
$Z^2$ is selected from $CY^2$ or N;
$Z^3$ is selected from $CY^3$ or N;
$Z^4$ is selected from $CY^4$ or N;
$Z^5$ is selected from $CY^5$ or N;
wherein
$Y^1$, $Y^2$, $Y^3$, $Y^4$, and $Y^5$ are independently selected from CN, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H,
$X^2$ is selected from formula (XXb)

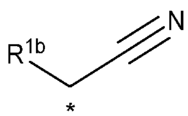

(XXb)

wherein
$R^{1b}$ is selected from substituted or unsubstituted $C_6$ to $C_{19}$ aryl, substituted or unsubstituted $C_6$ to $C_{19}$ aryl with one, two or three aromatic six-member rings, substituted or unsubstituted $C_9$ to $C_{19}$ aryl with two or three fused aromatic six-member rings, substituted or unsubstituted $C_6$ to $C_{12}$ aryl with one or two aromatic six-member rings, substituted or unsubstituted phenyl, substituted or unsubstituted biphenyl, substituted or unsubstituted $C_3$ to $C_{20}$ heteroaryl, substituted or unsubstituted $C_3$ to $C_{20}$ heteroaryl with one, two or three aromatic six-member rings, substituted or unsubstituted $C_7$ to $C_{20}$ heteroaryl with two or three fused aromatic six-member rings or CN, wherein the substituents are selected from CN, partially fluorinated or perfluorinated $C_1$ to $C_6$ alkyl, halogen, Cl, F, $C_1$ to $C_6$ alkyl or D;
wherein the asterisk "*" denotes the binding position; wherein the six-member rings are aromatic six member rings.

According to one embodiment of the present invention, the compound of formula (II) is represented by formula (IIj):

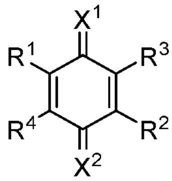

(IIj)

wherein

$R^1$, $R^2$, $R^3$ and $R^4$ are independently selected form F, Cl, CN or $CF_3$;

$X^1$ is selected from formula (XXa)

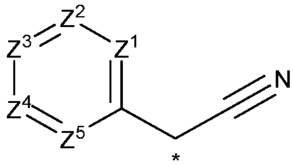

(XXa)

wherein

$Z^1$ is selected from $CY^1$ or N;
$Z^2$ is selected from $CY^2$ or N;
$Z^3$ is selected from $CY^3$ or N;
$Z^4$ is selected from $CY^4$ or N;
$Z^5$ is selected from $CY^5$ or N;
wherein
$Y^1$, $Y^2$, $Y^3$, $Y^4$, and $Y^5$ are independently selected from CN, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H, wherein at least one $Z^1$ to $Z^5$ is selected from CH, CD or N;
$X^2$ is selected from formula (XXb)

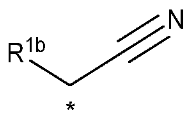

(XXb)

wherein
$R^{1b}$ is selected from substituted or unsubstituted $C_6$ to $C_{19}$ aryl, substituted or unsubstituted $C_6$ to C19 aryl with one, two or three aromatic six-member rings, substituted or unsubstituted $C_9$ to $C_{19}$ aryl with two or three fused aromatic six-member rings, substituted or unsubstituted $C_6$ to $C_{12}$ aryl with one or two aromatic six-member rings, substituted or unsubstituted phenyl, substituted or unsubstituted biphenyl, substituted or unsubstituted $C_3$ to $C_{20}$ heteroaryl, substituted or unsubstituted $C_3$ to $C_{20}$ heteroaryl with one, two or three aromatic six-member rings, substituted or unsubstituted $C_7$ to $C_{20}$ heteroaryl with two or three fused aromatic six-member rings or CN, wherein the substituents are selected from CN, partially fluorinated or perfluorinated $C_1$ to $C_6$ alkyl, halogen, Cl, F, $C_1$ to $C_6$ alkyl or D;
wherein the asterisk "*" denotes the binding position; wherein the six-member rings are aromatic six member rings.

According to one embodiment of the present invention, the compound of formula (II) is represented by formula (IIk):

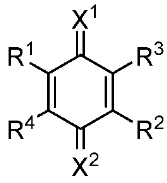

(IIk)

wherein

$R^1$, $R^2$, $R^3$ and $R^4$ are independently selected form F, Cl, CN or $CF_3$,
$X^1$ is selected from formula (XXa)

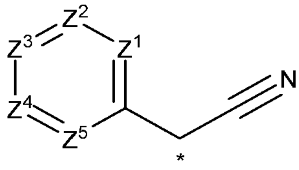

(XXa)

wherein

$Z^1$ is selected from $CY^1$ or N;
$Z^2$ is selected from $CY^2$ or N;
$Z^3$ is selected from $CY^3$ or N;
$Z^4$ is selected from $CY^4$ or N;
$Z^5$ is selected from $CY^5$ or N;
wherein
$Y^1$, $Y^2$, $Y^3$, $Y^4$, and $Y^5$ are independently selected from CN, partially fluorinated $C_1$ to $C_6$ alkyl, perfluorinated $C_1$ to $C_6$ alkyl, halogen, Cl, F, D or H,
wherein at least one $Z^1$ to $Z^5$ is selected from CH, CD or N;
$X^2$ is selected from formula (XXb)

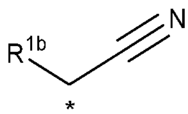

(XXb)

wherein
$R^{1b}$ is selected from substituted or unsubstituted $C_6$ to $C_{19}$ aryl, substituted or unsubstituted $C_6$ to $C_{19}$ aryl with one, two or three aromatic six-member rings, substituted or unsubstituted $C_9$ to $C_{19}$ aryl with two or three fused aromatic six-member rings, substituted or unsubstituted $C_6$ to $C_{12}$ aryl with one or two aromatic six-member rings, substituted or unsubstituted phenyl, substituted or unsubstituted biphenyl, substituted or unsubstituted $C_3$ to $C_{20}$ heteroaryl, substituted or unsubstituted $C_3$ to $C_{20}$ heteroaryl with one, two or three aromatic six-member rings, substituted or unsubstituted $C_7$ to $C_{20}$ heteroaryl with two or three fused aromatic six-member rings or CN, wherein the substituents are selected from CN, partially fluorinated or perfluorinated $C_1$ to $C_6$ alkyl, halogen, Cl, F, $C_1$ to $C_6$ alkyl or D;
wherein the asterisk "*" denotes the binding position; wherein the six-member rings are aromatic six member rings and preferably the following formula (XXX) is excluded:

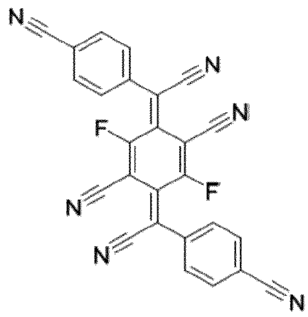 (XXX).

According to one embodiment of the present invention, the compound of formula (II) is represented by formula (IIm):

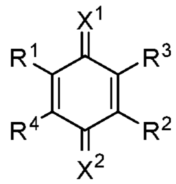 (IIm)

wherein $R^1$ is selected from formula (xxxx)

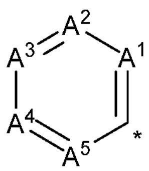 (XXXX)

$A^1$ is selected from $CG^1$ or N;
$A^2$ is selected from $CG^2$ or N;
$A^3$ is selected from $CG^3$ or N;
$A^4$ is selected from $CG^4$ or N;
$A^5$ is selected from $CG^5$ or N;
$G^1$, $G^2$, $G^3$, $G^4$, and $G^5$ are independently selected from CN, partially fluorinated $C_1$ to $C_6$ alkyl, perfluorinated $C_1$ to $C_6$ alkyl, $CF_3$, $OCF_3$, halogen, Cl, F, D or H; wherein the asterisk "*" denotes the binding position.

According to one embodiment of the present invention, in formulae (IIa) to (IIm) - wherever applicable - at least one $R^1$, $R^2$, $R^3$, $R^4$, $R^5$, $R^6$, $R^7$ and $R^8$ is selected from formula (XXXX):

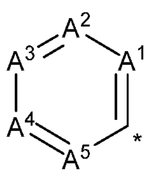 (XXXX)

$A^1$ is selected from $CG^1$ or N;
$A^2$ is selected from $CG^2$ or N;
$A^3$ is selected from $CG^3$ or N;
$A^4$ is selected from $CG^4$ or N;
$A^5$ is selected from $CG^5$ or N;
$G^1$, $G^2$, $G^3$, $G^4$, and $G^5$ are independently selected from CN, isocyano, SCN, OCN, $NO_2$, $SF_5$, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H;
wherein $R^2$, $R^3$, and $R^4$ are independently selected from D, halogen, Cl, F, substituted or unsubstituted $C_1$ to $C_6$ alkyl,

partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, $OCF_3$, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$;
wherein $X^1$, and $X^2$ are independently selected from O, S, $CR^{13}R^{23}$, $CR^{1b}R^{2b}$, $NR^{3a}$, $NR^{3b}$;
wherein $R^{13}$, $R^{2a}$, $R^{1b}$, and $R^{2b}$, are independently selected from halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $NO_2$, $SF_5$, substituted or unsubstituted $C_6$ to $C_{30}$ aryl, substituted or unsubstituted $C_3$ to $C_{30}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;
wherein $R^{3a}$ and $R^{3b}$ is selected from CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;
wherein the asterisk "*" denotes the binding position.

According to one embodiment of the present invention, the compound of formula (II) is selected from

| |
|---|
| 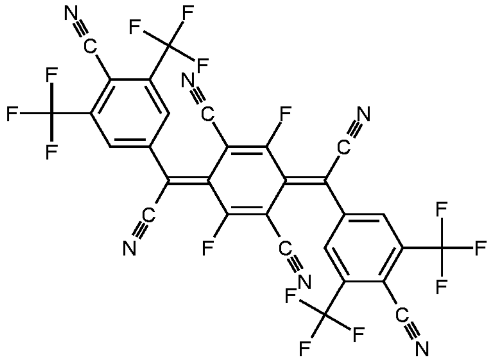 |
| 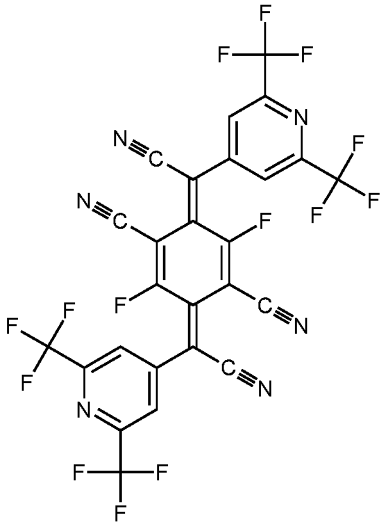 |
| 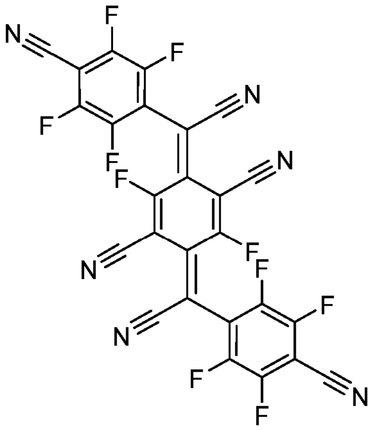 |

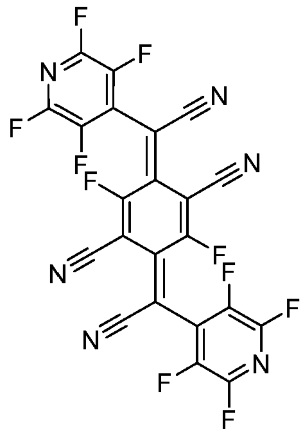

According to one embodiment of the present invention, each of the at least one charge generation layer comprises a p-type charge generation layer.

According to one embodiment of the present invention, the organic electroluminescent device comprises at least three light-emitting units, and at least one charge generation layer, wherein each of the at least one charge generation layer is disposed independently between one set of two adjacent light-emitting units of the at least three light-emitting units.

According to one embodiment of the present invention, between one set of two adjacent light-emitting units, no more than one charge generation layer is arranged, in particular no more than one charge generation layer comprising a p-type charge generation layer and an n-type charge generation layer.

According to one embodiment of the present invention, between each set of two adjacent light-emitting units, no more than one charge generation layer is arranged, in particular no more than one charge generation layer comprising a p-type charge generation layer and an n-type charge generation layer.

According to one embodiment of the present invention, the organic electroluminescent device comprises at least three light-emitting units, and at least one charge generation layer, wherein each of the at least one charge generation layer is disposed independently between one set of two adjacent light-emitting units of the at least three light-emitting units, wherein the at least one charge generation layer comprises a p-type charge generation layer, wherein the p-type charge generation layer comprises an organic hole transport material and a compound of formula (II).

According to one embodiment of the present invention, the organic electroluminescent device comprises at least four light-emitting units, and at least one charge generation layer, wherein each of the at least one charge generation layer is disposed independently between one set of two adjacent light-emitting units of the at least four light-emitting units.

According to one embodiment of the present invention, the organic electroluminescent device comprises at least four light-emitting units, and at least one charge generation layer, wherein each of the at least one charge generation layer is disposed independently between one set of two adjacent light-emitting units of the at least four light-emitting units, wherein the at least one charge generation layer comprises a p-type charge generation layer, wherein the p-type charge generation layer comprises an organic hole transport material and a compound of formula (II).

According to one embodiment of the present invention, the organic electroluminescent device comprises at least three light-emitting units, and at least two charge generation layers, wherein each of the at least two charge generation layers is disposed independently between one set of two adjacent light-emitting units of the at least three light-emitting units, preferably between different sets of two adjacent light-emitting units.

According to one embodiment of the present invention, the organic electroluminescent device comprises at least three light-emitting units, and at least two charge generation layers, wherein each of the at least two charge generation layers is disposed independently between one set of two adjacent light-emitting units of the at least three light-emitting units, preferably between different sets of two adjacent light-emitting units, wherein each of the at least two charge generation layer comprises a p-type charge generation layer, wherein the p-type charge generation layer comprises an organic hole transport material and a compound of formula (II).

According to one embodiment of the present invention, the organic electroluminescent device comprises at least three light-emitting units, and at least two charge generation layers, wherein each of the at least two charge generation layers is disposed independently between one set of two adjacent light-emitting units of the at least three light-emitting units, preferably between different sets of two adjacent light-emitting units, wherein at least one, preferably at least two of the charge generation layers comprise a p-type charge generation layer.

According to one embodiment of the present invention, the organic electroluminescent device comprises at least three light-emitting units, and at least two charge generation layers, wherein each of the at least two charge generation layers is disposed independently between one set of two adjacent light-emitting units of the at least three light-emitting

units, preferably between different sets of two adjacent light-emitting units, wherein at least one, preferably at least two of the charge generation layers comprise a p-type charge generation layer, wherein each of the at least two charge generation layer comprises a p-type charge generation layer, wherein the p-type charge generation layer comprises an organic hole transport material and a compound of formula (II).

According to one embodiment of the present invention, the organic electroluminescent device comprises at least four light-emitting units, and at least three charge generation layers, wherein each of the at least three charge generation layers is disposed independently between one set of two adjacent light-emitting units of the at least four light-emitting units, preferably between different sets of two adjacent light-emitting units.

According to one embodiment of the present invention, the organic electroluminescent device comprises at least four light-emitting units, and at least three charge generation layers, wherein each of the at least three charge generation layers is disposed independently between one set of two adjacent light-emitting units of the at least four light-emitting units, preferably between different sets of two adjacent light-emitting units, wherein each of the at least three charge generation layer comprises a p-type charge generation layer, wherein the p-type charge generation layer comprises an organic hole transport material and a compound of formula (II).

According to one embodiment of the present invention, the organic electroluminescent device comprises at least four light-emitting units, and at least three charge generation layers, wherein each of the at least three charge generation layers is disposed independently between one set of two adjacent light-emitting units of the at least four light-emitting units, preferably between different sets of two adjacent light-emitting units, wherein at least one, preferably at least two, more preferably at least three of the charge generation layers comprise a p-type charge generation layer.

According to one embodiment of the present invention, the organic electroluminescent device comprises at least four light-emitting units, and at least three charge generation layers, wherein each of the at least three charge generation layers is disposed independently between one set of two adjacent light-emitting units of the at least four light-emitting units, preferably between different sets of two adjacent light-emitting units, wherein at least one, preferably at least two, more preferably at least three of the charge generation layers comprise a p-type charge generation layer, wherein each of the at least three charge generation layer comprises a p-type charge generation layer, wherein the p-type charge generation layer comprises an organic hole transport material and a compound of formula (II).

According to one embodiment of the present invention, at least one light-emitting unit comprises at least one electron transport layer, preferably each light-emitting unit.

According to one embodiment of the present invention, at least one light-emitting unit comprises at least one hole transport layer, preferably each light-emitting unit.

According to one embodiment of the present invention, at least one light-emitting unit comprises at least one electron transport layer and at least one hole transport layer, preferably each light-emitting unit.

According to one embodiment of the present invention, at least one light-emitting unit comprises at least one electron transport layer and at least one hole transport layer, preferably each light-emitting unit, wherein the at least one hole transport layer is arranged closer to the anode than the at least one electron transport layer.

According to one embodiment of the present invention, at least one light-emitting unit comprises at least one electron transport layer and at least one hole transport layer, preferably each light-emitting unit, wherein the at least one light-emitting layer is arranged between the at least one hole transport layer and the at least one electron transport layer, wherein preferably, the at least one hole transport layer is arranged closer to the anode than the at least one electron transport layer.

According to one embodiment of the present invention, at least one light-emitting unit comprises an electron blocking layer and a hole blocking layer, wherein the electron blocking layer is preferably arranged between the first hole transport layer and the at least one emission layer and the hole blocking layer is arranged between the first electron transport layer and the at least one emission layer.

According to one embodiment of the present invention, the at least one charge generation layer further comprises an n-type charge generation layer.

According to one embodiment of the present invention, each of the at least one charge generation layer comprises an n-type charge generation layer

According to one embodiment of the present invention, the n-type charge generation layer of the at least one charge generation layer is closer to the anode layer than the p-type charge generation layer of said at least one charge generation layer.

According to one embodiment of the present invention, the n-type charge generation layer of the at least one charge generation layer is adjacent to the p-type charge generation layer of said at least one charge generation layer.

According to one embodiment of the present invention, the n-type charge generation layer of the at least one charge generation layer is in direct contact to the p-type charge generation layer of said at least one charge generation layer.

According to one embodiment of the present invention, the n-type charge generation layer of each of the at least one charge generation layer is closer to the anode layer than the p-type charge generation layer of said at least one charge

generation layer.

According to one embodiment of the present invention, the n-type charge generation layer of each of the at least one charge generation layer is adjacent to the p-type charge generation layer of said at least one charge generation layer.

According to one embodiment of the present invention, the n-type charge generation layer of each of the at least one charge generation layer is in direct contact to the p-type charge generation layer of said at least one charge generation layer.

According to one embodiment of the present invention, the electroluminescent device further comprises at least one electron transport layer.

According to one embodiment of the present invention, the at least one electron transport layer is comprised in one of the at least two light-emitting units.

According to one embodiment of the present invention, each of the at least two light-emitting units comprises an electron transport layer.

According to one embodiment of the present invention, the electron transport layer is free of metal dopant, particularly free of metal dopant in the oxidation state (0).

According to one embodiment of the present invention, the n-type charge generation layer of the at least one charge generation layer is adjacent to the at least one electron transport layer.

According to one embodiment of the present invention, the n-type charge generation layer of the at least one charge generation layer is adjacent to the at least one electron transport layer and adjacent to the p-type charge generation layer of said at least one charge generation layer.

According to one embodiment of the present invention, the n-type charge generation layer of the at least one charge generation layer is in direct contact to the at least one electron transport layer.

According to one embodiment of the present invention, the n-type charge generation layer of the at least one charge generation layer is in direct contact to the at least one electron transport layer and adjacent to the p-type charge generation layer of said at least one charge generation layer.

According to one embodiment of the present invention, the n-type charge generation layer of the at least one charge generation layer is in direct contact to the at least one electron transport layer and in direct contact to the p-type charge generation layer of said at least one charge generation layer.

According to one embodiment of the present invention, the n-type charge generation layer of each of the at least one charge generation layer is adjacent to the at least one electron transport layer.

According to one embodiment of the present invention, the n-type charge generation layer of each of the at least one charge generation layer is adjacent to the at least one electron transport layer and adjacent to the p-type charge generation layer of said at least one charge generation layer.

According to one embodiment of the present invention, the n-type charge generation layer of each of the at least one charge generation layer is in direct contact to the at least one electron transport layer.

According to one embodiment of the present invention, the n-type charge generation layer of each of the at least one charge generation layer is in direct contact to the at least one electron transport layer and adjacent to the p-type charge generation layer of said at least one charge generation layer.

According to one embodiment of the present invention, the n-type charge generation layer of each of the at least one charge generation layer is in direct contact to the at least one electron transport layer and in direct contact to the p-type charge generation layer of said at least one charge generation layer.

According to one embodiment of the present invention, the n-type charge generation layer further comprises an electron transport material.

According to one embodiment of the present invention, the n-type charge generation layer further comprises an organic electron transport material.

According to one embodiment of the present invention, the electron transport material comprises at least one $C_2$ to $C_{24}$ N-heteroaryl or P=X group, with X being O, P, Se, with P=O especially preferred.

According to an embodiment of the present invention, the at least one $C_2$ to $C_{24}$ N-heteroaryl may be selected from a compound comprising at least one azine group, preferably at least two azine groups, also preferred three azine groups.

According to an embodiment of the present invention, the electron transport material comprises at least one group selected from the list consisting of pyridine, pyrimidine, triazine, imidazole, benzimidazole, benzooxazole, quinone, benzoquinone, imidazo[1,5-*a*]pyridine, quinoxaline, benzoquinoxaline, acridine, phenanthroline, benzoacridine, dibenzoacridine phosphine oxide, terpyridine.

According to an embodiment of the present invention, the electron transport material comprises at least one phenanthroline group, preferably two phenanthroline groups, one or more pyridine groups, one or more pyrimidine groups, one or more triazine groups, one or more imidazo[1,5-*a*]pyridine groups, or one or more phosphine oxide groups.

According to an embodiment of the present invention, the organic electron transport material comprises at least one phenanthroline group, preferably two phenanthroline groups, one or more pyridine groups, one or more pyrimidine

groups, or one or more phosphine oxide groups.

According to an embodiment of the present invention, the electron transport material comprises at least one phenanthroline group, preferably two phenanthroline groups, a pyridine group, a pyrimidine groups, or a phosphine oxide group.

According to an embodiment of the present invention, the electron transport material compound comprises at least one phenanthroline group, preferably two phenanthroline groups, one or more pyridine groups, one or more pyrimidine groups, one or more triazine groups.

According to an embodiment of the present invention, the electron transport material is selected from the group comprising 2,2'-(1,3-Phenylene)bis[9-phenyl-1,10-phenanthroline], (3-(10-(3-(2,6-diphenylpyrimidin-4-yl)phenyl)anthracen-9-yl)phenyl)dimethylphosphine oxide, 3-(3-(9,10-diphenylanthracen-2-yl)phenyl)-1-(pyridin-2-yl)imidazo[1,5-a]pyridine, 7-(3-(1,10-phenanthrolin-2-yl)phenyl)dibenzo[c,h]acridine, 7-(3-([2,2':6',2"-terpyridin]-4'-yl)phenyl)dibenzo[c,h]acridine, 4'-(4'-(4,6-diphenyl-1,3,5-triazin-2-yl)-[1,1'-biphenyl]-4-yl)-2,2':6',2"-terpyridine, 4'-(4-(fluoranthen-3-yl)phenyl)-2,2':6',2"-terpyridine, or 3-(9,10-di-2-naphthalenyl-2-anthracenyl)phenyl]dimethylphosphine oxide.

According to an embodiment of the present invention, the electron transport material comprises at least one phenanthroline group, preferably two phenanthroline groups.

According to an embodiment of the present invention, the n-type charge generation comprises a metal dopant.

According to one embodiment of the present invention, the metal dopant is selected from a metal with an electronegativity of ≤ 1.4 eV by Pauling scale or a metal alloy comprising a metal with an electronegativity of ≤ 1.4 eV by Pauling scale.

According to one embodiment of the present invention, the metal dopant is selected from a metal with an electronegativity of ≤ 1.35 eV by Pauling scale or a metal alloy comprising a metal with an electronegativity of ≤ 1.35 eV by Pauling scale.

According to one embodiment of the present invention, the metal dopant is a metal selected from the group consisting of Li, Na, K, Rb, Cs, Mg, Ca, Sr, Ba, Sm, Eu and Yb or a metal alloy comprising a metal selected from the group consisting of Li, Na, K, Rb, Cs, Mg, Ca, Sr, Ba, Sm, Eu and Yb.

According to one embodiment of the present invention, the metal dopant is a metal selected from the group consisting of Li, Na, K, Cs, Mg, Ca, Ba, Sm, Eu and Yb or a metal alloy comprising a metal selected from the group consisting of Li, Na, K, Cs, Mg, Ca, Ba, Sm, Eu and Yb.

According to one embodiment of the present invention, the metal dopant is a metal selected from the group consisting of Li, Mg and Yb or a metal alloy comprising a metal selected from the group consisting of Li, Mg and Yb.

According to one embodiment of the present invention, the metal dopant is a metal selected from the group consisting of Li and Yb or a metal alloy comprising a metal selected from the group consisting of Li, and Yb.

According to one embodiment of the present invention, the metal dopant is Yb or a metal alloy comprising a metal selected from the group consisting of Li and Yb.

According to one embodiment of the present invention, the metal dopant is Yb.

According to one embodiment of the present invention, the metal dopant is present in the n-type charge generation layer in an amount of ≤99.9 wt% based on the total weight of the layer, preferably ≤99 wt%, more preferably ≤95 wt%, more preferably ≤90 wt%, more preferably ≤80 wt%, more preferably ≤70 wt%, more preferably ≤60 wt%, more preferably ≤50 wt%, more preferably ≤40 wt%, more preferably ≤30 wt%, more preferably ≤20 wt%, more preferably ≤ 10 wt.-%, more preferably ≤ 5 wt.-%, more preferably ≤ 3.0 wt.-%, more preferably ≤ 2.75 wt.-%, more preferably ≤ 2.5 wt.-%, more preferably ≤ 2.25 wt.-%, and most preferably ≤ 2.0 wt.-%.

According to one embodiment of the present invention, the electron transport material is present in the n-type charge generation layer in an amount of ≥0.1 wt% based on the total weight of the layer, preferably ≥1 wt%, more preferably ≥5 wt%, more preferably ≥10 wt%, more preferably ≥20 wt%, more preferably ≥30 wt%, more preferably ≥40 wt%, more preferably ≥50 wt%, more preferably ≥60 wt%, more preferably ≥70 wt%, more preferably ≥80 wt%, more preferably ≥90 wt%, more preferably ≥95 wt%, more preferably ≥97.0 wt%, more preferably ≥97.25 wt%, more preferably ≥97.5 wt%, more preferably ≥97.75 wt% and most preferably ≥98.0 wt%.

According to one embodiment of the present invention, the compound of formula (I) is present in the p-type charge generation layer in an amount of ≤99.9 wt% based on the total weight of the p-type charge generation layer, preferably ≤99 wt%, more preferably ≤95 wt%, more preferably ≤90 wt%, more preferably ≤80 wt%, more preferably ≤70 wt%, more preferably ≤60 wt%, more preferably ≤50 wt%, more preferably ≤40 wt%, more preferably ≤30 wt%, more preferably ≤20 wt%, more preferably ≤ 10 wt.-%, more preferably ≤ 5 wt.-%, more preferably ≤ 3.0 wt.-%, more preferably ≤ 2.75 wt.-%, more preferably ≤ 2.5 wt.-%, more preferably ≤ 2.25 wt.-%, and most preferably ≤ 2.0 wt.-%.

According to one embodiment of the present invention, the organic hole transport material is present in the p-type charge generation layer in an amount of ≥0.1 wt% based on the total weight of the p-type charge generation layer, preferably ≥1 wt%, more preferably ≥5 wt%, more preferably ≥10 wt%, more preferably ≥20 wt%, more preferably ≥30 wt%, more preferably ≥40 wt%, more preferably ≥50 wt%, more preferably ≥60 wt%, more preferably ≥70 wt%, more preferably ≥80 wt%, more preferably ≥90 wt%, more preferably ≥95 wt%, more preferably ≥97.0 wt%, more preferably ≥97.25 wt%,

more preferably ≥97.5 wt%, more preferably ≥97.75 wt% and most preferably ≥98.0 wt%.

According to one embodiment of the present invention, the p-type charge generation layer of the at least one charge generation layer is adjacent to the n-type charge generation layer of said at least one charge generation layer.

According to one embodiment of the present invention, the p-type charge generation layer of the at least one charge generation layer is in direct contact to the n-type charge generation layer of said at least one charge generation layer.

According to one embodiment of the present invention, the electroluminescent device further comprises at least one hole transport layer.

According to one embodiment of the present invention, the at least one hole transport layer is comprised in one of the at least two light-emitting units.

According to one embodiment of the present invention, a hole transport layer is comprised in each of the at least two light-emitting units.

According to one embodiment of the present invention, the p-type charge generation layer of at least one charge generation layer is adjacent to the at least one hole transport layer.

According to one embodiment of the present invention, the p-type charge generation layer of at least one charge generation layer is in direct contact to the at least one hole transport layer.

According to one embodiment of the present invention, the p-type charge generation layer of the at least one charge generation layer is adjacent to the n-type charge generation layer of said at least one charge generation layer and adjacent to the at least one hole transport layer.

According to one embodiment of the present invention, the p-type charge generation layer of the at least one charge generation layer is in direct contact to the n-type charge generation layer of said at least one charge generation layer and in direct contact to the at least one hole transport layer.

According to one embodiment of the present invention, the p-type charge generation layer of each of the at least one charge generation layer is adjacent to the n-type charge generation layer of said at least one charge generation layer.

According to one embodiment of the present invention, the p-type charge generation layer of each of the at least one charge generation layer is in direct contact to the n-type charge generation layer of said at least one charge generation layer.

According to one embodiment of the present invention, the p-type charge generation layer of each of the at least one charge generation layer is adjacent to the at least one hole transport layer.

According to one embodiment of the present invention, the p-type charge generation layer of each of the at least one charge generation layer is in direct contact to the at least one hole transport layer.

According to one embodiment of the present invention, the p-type charge generation layer of each of the at least one charge generation layer is adjacent to the n-type charge generation layer of said at least one charge generation layer and adjacent to the at least one hole transport layer.

According to one embodiment of the present invention, the p-type charge generation layer of each of the at least one charge generation layer is in direct contact to the n-type charge generation layer of said at least one charge generation layer and in direct contact to the at least one hole transport layer.

According to one embodiment of the present invention, the hole transport matrix compound of the p-type charge generation layer is a substantially covalent matrix compound.

According to one embodiment of the present invention, the hole transport matrix compound of the charge generation layer is the same as the organic hole transport matrix compound of the p-type charge generation layer.

According to one embodiment of the present invention, the hole transport matrix compound of the p-type charge generation layer is the same as the hole transport matrix compound of the hole injection layer.

According to one embodiment of the present invention, the first hole transport matrix compound of the p-type charge generation layer has a calculated HOMO energy level in the range of ≤ -4.27 eV to ≥ -5.1 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -4.3 eV to ≥ -5.0 eV, more preferably ≤ -4.4 eV and ≥ -5.0 eV, more preferably ≤ -4.5 eV and ≥ -5.0 eV, more preferably ≤ - 4.5 eV and ≥ -4.9 eV and most preferably ≤ -4.6 eV and ≥ -4.9 eV.

According to one embodiment of the present invention, the first hole transport matrix compound is a substantially covalent matrix compound.

According to one embodiment of the present invention, the first hole transport matrix compound is an organic hole transport matrix compound.

According to one embodiment of the present invention, the first hole transport matrix compound is a substantially covalent organic matrix compound.

According to one embodiment of the present invention, the first hole transport matrix compound is present in the p-type charge generation layer in an amount of ≥0.1 wt% based on the total weight of the hole injection layer, preferably ≥1 wt%, more preferably ≥5 wt%, more preferably ≥10 wt%, more preferably ≥20 wt%, more preferably ≥30 wt%, more

preferably ≥40 wt%, more preferably ≥50 wt%, more preferably ≥60 wt%, more preferably ≥70 wt%, more preferably ≥80 wt%, more preferably ≥90 wt%, more preferably ≥95 wt%, more preferably ≥97.0 wt%, more preferably ≥97.25 wt%, more preferably ≥97.5 wt%, more preferably ≥97.75 wt% and most preferably ≥98.0 wt%.

According to one embodiment of the present invention, the organic hole transport matrix compound of the p-type charge generation layer is the same as the organic hole transport layer of the hole injection layer.

According to one embodiment of the present invention, the second hole transport matrix compound of the hole injection layer has a calculated HOMO energy level in the range of ≤ -4.27 eV to ≥ -5.1 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -4.3 eV to ≥ -5.0 eV, more preferably ≤ -4.4 eV to ≥ -5.0 eV, more preferably ≤ -4.5 eV and ≥ -5.0 eV, more preferably ≤ -4.5 eV and ≥ -4.9 eV and most preferably ≤ -4.6 eV and ≥ -4.9 eV.

According to one embodiment of the present invention, the second hole transport matrix compound is a substantially covalent matrix compound.

According to one embodiment of the present invention, the second hole transport matrix compound is an organic hole transport matrix compound.

According to one embodiment of the present invention, the second hole transport matrix compound is a substantially covalent organic matrix compound.

According to one embodiment of the present invention, the second hole transport matrix compound is present in the hole injection layer in an amount of ≥0.1 wt% based on the total weight of the p-type charge generation layer, preferably ≥1 wt%, more preferably ≥5 wt%, more preferably ≥10 wt%, more preferably ≥20 wt%, more preferably ≥30 wt%, more preferably ≥40 wt%, more preferably ≥50 wt%, more preferably ≥60 wt%, more preferably ≥70 wt%, more preferably ≥80 wt%, more preferably ≥90 wt%, and more preferably ≥95 wt%.

According to one embodiment of the present invention, the organic electroluminescent device comprises at least one electron injection layer (EIL).

According to one embodiment of the present invention, the electron injection layer is disposed a light-emitting unit.

According to one embodiment of the present invention, the electron injection layer is disposed on the light-emitting unit closest to the cathode of the organic electroluminescent device.

According to one embodiment of the present invention, the electron injection layer is disposed between the light-emitting unit closest to the cathode and the cathode.

According to one embodiment of the present invention, the electron injection layer is adjacent to the light-emitting unit closest to the cathode.

According to one embodiment of the present invention, the electron injection layer is disposed between the light-emitting unit closest to the cathode and the cathode, and is adjacent to the light-emitting unit closest to the cathode.

According to one embodiment of the present invention, the electron injection layer is disposed between the light-emitting unit closest to the cathode and the cathode, and is adjacent to the cathode.

According to one embodiment of the present invention, the electron injection layer is disposed between the light-emitting unit closest to the cathode and the cathode, and is adjacent to the light-emitting unit closest to the cathode and the cathode.

According to one embodiment of the present invention, the electron injection layer is disposed between the light-emitting unit closest to the cathode and the cathode, and is in contact with the light-emitting unit closest to the cathode and the cathode.

According to one embodiment of the present invention, the organic hole transport matrix compound of the p-type charge generation layer is a substantially covalent matrix compound and the same as the organic hole transport matrix compound of the hole injection layer.

According to one embodiment of the present invention, the organic hole transport matrix compound of the p-type charge generation layer is a substantially covalent matrix compound and the same as the organic hole transport layer of the hole injection layer.

## Substantially covalent matrix compound

According to one embodiment of the present invention, the substantially covalent matrix compound may be selected from at least one organic compound. The substantially covalent matrix may consists substantially from covalently bound C, H, O, N, S, which optionally comprise in addition covalently bound B, P, As and/or Se.

According to one embodiment of the present invention, the substantially covalent matrix compound may be selected from organic compounds consisting substantially from covalently bound C, H, O, N, S, which optionally comprise in addition covalently bound B, P, As and/or Se.

Organometallic compounds comprising covalent bonds carbon-metal, metal complexes comprising organic

ligands and metal salts of organic acids are further examples of organic compounds that may serve as substantially covalent matrix compounds of the hole injection layer.

In one embodiment, the substantially covalent matrix compound lacks metal atoms and majority of its skeletal atoms may be selected from C, O, S, N. Alternatively, the substantially covalent matrix compound lacks metal atoms and majority of its skeletal atoms may be selected from C and N.

According to one embodiment, the substantially covalent matrix compound may have a molecular weight Mw of $\geq$ 400 and $\leq$ 2000 g/mol, preferably a molecular weight Mw of $\geq$ 450 and $\leq$ 1500 g/mol, further preferred a molecular weight Mw of $\geq$ 500 and $\leq$ 1000 g/mol, in addition preferred a molecular weight Mw of $\geq$ 550 and $\leq$ 900 g/mol, also preferred a molecular weight Mw of $\geq$ 600 and $\leq$ 800 g/mol.

Preferably, the substantially covalent matrix compound comprises at least one arylamine moiety, alternatively a diarylamine moiety, alternatively a triarylamine moiety.

Preferably, the substantially covalent matrix compound is free of metals and/or ionic bonds.

<u>Compound of formula (VII) or a compound of formula (VIII)</u>

According to another aspect of the present invention, the substantially covalent matrix compound, may comprises at least one arylamine compound, diarylamine compound, triarylamine compound, a compound of formula (VII) or a compound of formula (VIII):

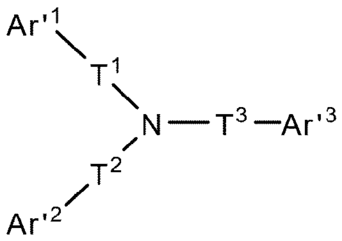
(VII),
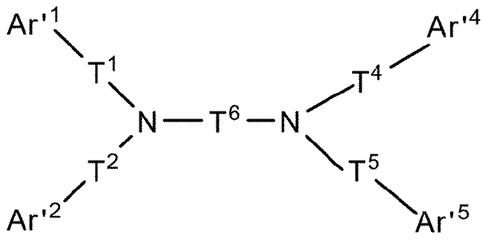
(VIII),

wherein:

$T^1$, $T^2$, $T^3$, $T^4$ and $T^5$ are independently selected from a single bond, phenylene, biphenylene, terphenylene or naphthenylene, preferably a single bond or phenylene;

$T^6$ is phenylene, biphenylene, terphenylene or naphthenylene;

Ar'$^1$, Ar'$^2$, Ar'$^3$, Ar'$^4$ and Ar'$^5$are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein

the substituents of Ar'$^1$, Ar'$^2$, Ar'$^3$, Ar'$^4$ and Ar'$^5$ are selected the same or different from the group comprising H, D, F, C(=O)R'$^2$, CN, Si(R'$^2$)$_3$, P(=O)(R'$^2$)$_2$, OR'$^2$, S(=O)R'$^2$, S(=O)$_2$R'$^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from

the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle, wherein $R'^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

According to an embodiment wherein $T^1$, $T^2$, $T^3$, $T^4$ and $T^5$ may be independently selected from a single bond, phenylene, biphenylene or terphenylene. According to an embodiment wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and two of $T^1$, $T^2$, $T^3$, $T^4$ and $T^5$ are a single bond.

According to an embodiment wherein $T^1$, $T^2$ and $T^3$ may be independently selected from phenylene and one of $T^1$, $T^2$ and $T^3$ are a single bond. According to an embodiment wherein $T^1$, $T^2$ and $T^3$ may be independently selected from phenylene and two of $T^1$, $T^2$ and $T^3$ are a single bond.

According to an embodiment wherein $T^6$ may be phenylene, biphenylene, terphenylene. According to an embodiment wherein $T^6$ may be phenylene. According to an embodiment wherein $T^6$ may be biphenylene. According to an embodiment wherein $T^6$ may be terphenylene.

According to an embodiment wherein $Ar'^1$, $Ar'^2$, $Ar'^3$, $Ar'^4$ and $Ar'^5$ may be independently selected from D1 to D16:

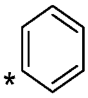 (D1), 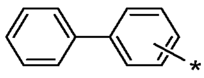 (D2), 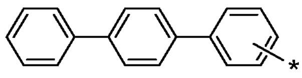 (D3), 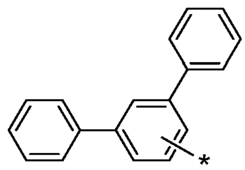 (D4),

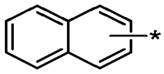 (D5), 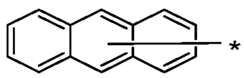 (D6), 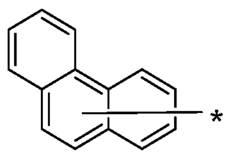 (D7), 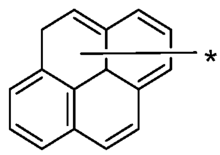 (D8),

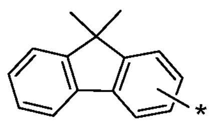 (D9), 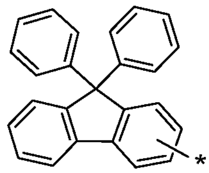 (D10), 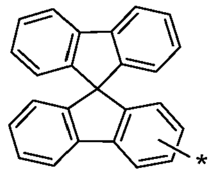 (D11),

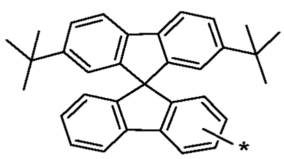 (D12), 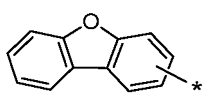 (D13), 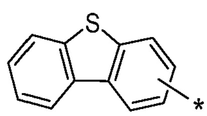 (D14),

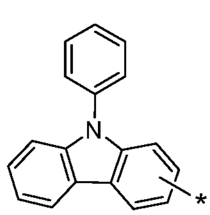 (D15), 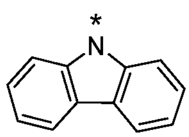 (D16),

wherein the asterix "*" denotes the binding position.

According to an embodiment, wherein Ar'[1], Ar'[2], Ar'[3], Ar'[4] and Ar'[5] may be independently selected from D1 to D15; alternatively selected from D1 to D10 and D13 to D15.

According to an embodiment, wherein Ar'[1], Ar'[2], Ar'[3], Ar'[4] and Ar'[5] may be independently selected from the group consisting of D1, D2, D5, D7, D9, D10, D13 to D16.

The rate onset temperature may be in a range particularly suited to mass production, when Ar'[1], Ar'[2], Ar'[3], Ar'[4] and Ar'[5] are selected in this range.

The "matrix compound of formula (VII) or formula (VIII)" may be also referred to as "hole transport compound".

According to one embodiment, the substantially covalent matrix compound comprises at least one naphthyl group, carbazole group, dibenzofuran group, dibenzothiophene group and/or substituted fluorenyl group, wherein the substituents are independently selected from methyl, phenyl or fluorenyl.

According to an embodiment of the electronic device, wherein the matrix compound of formula (VII) or formula (VIII) are selected from F1 to F18:

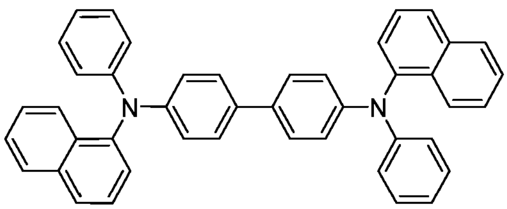
(F1),
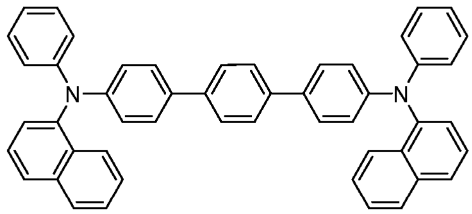
(F2),

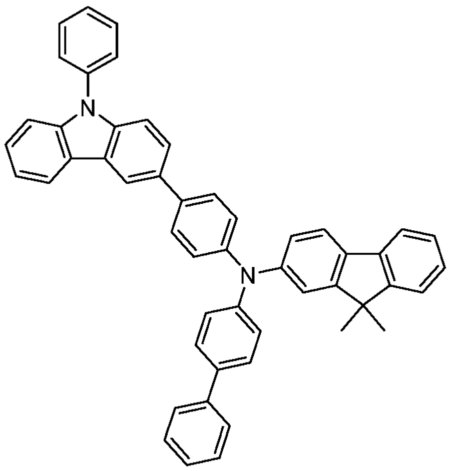
(F3),
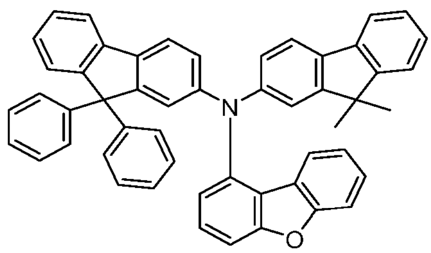
(F4),

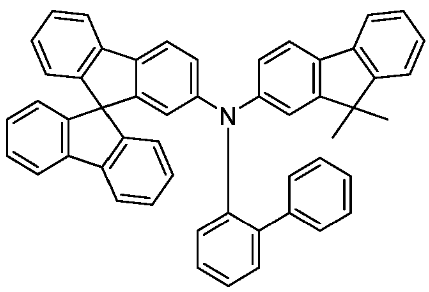
(F5),
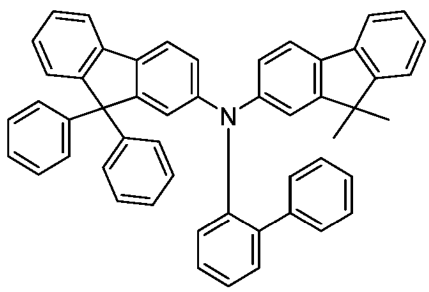
(F6),

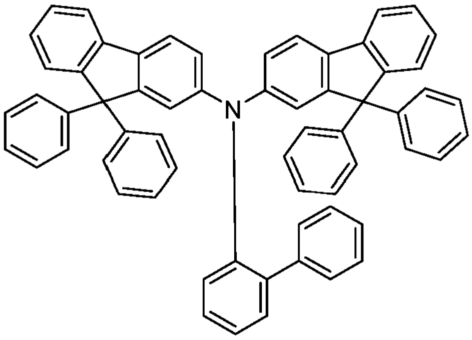
(F7),

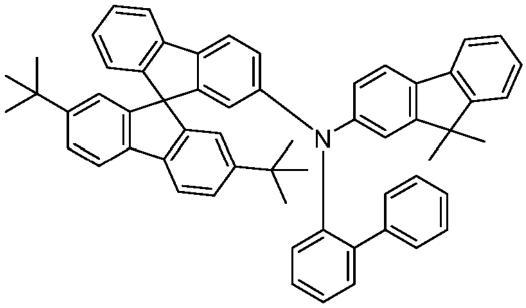
(F8),

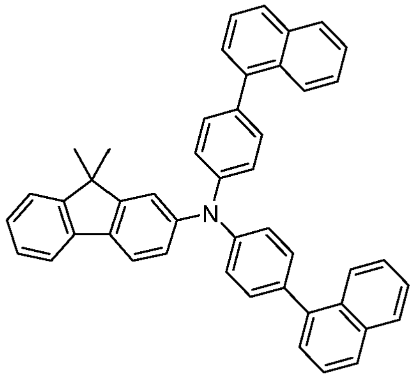
(F9),

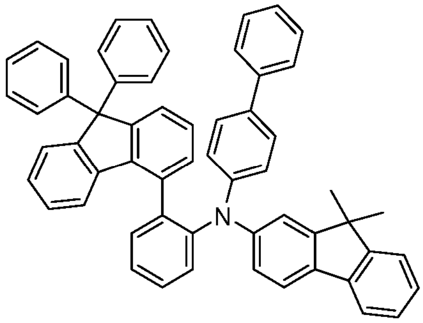
(F10),

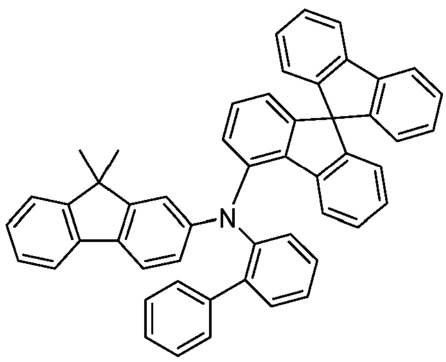
(F11),

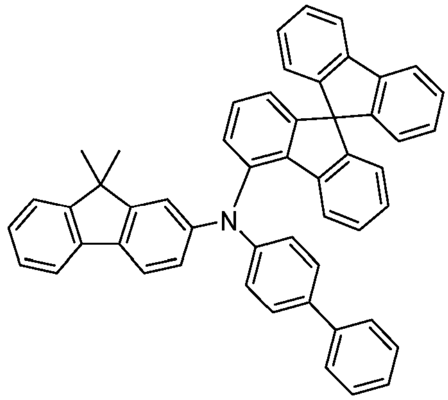
(F12),

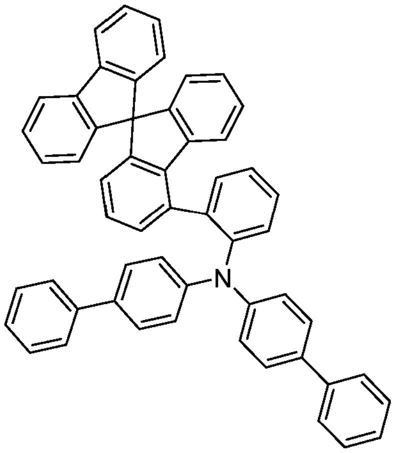
(F13),

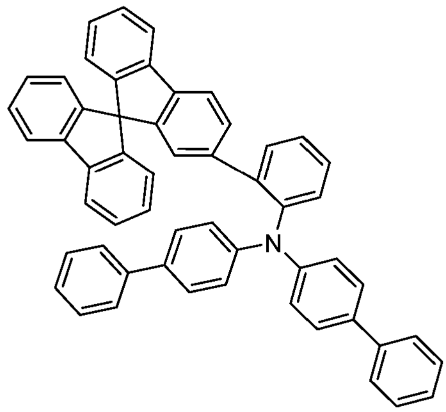
(F14),

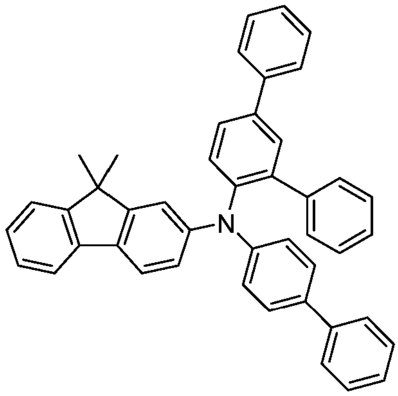 (F15), 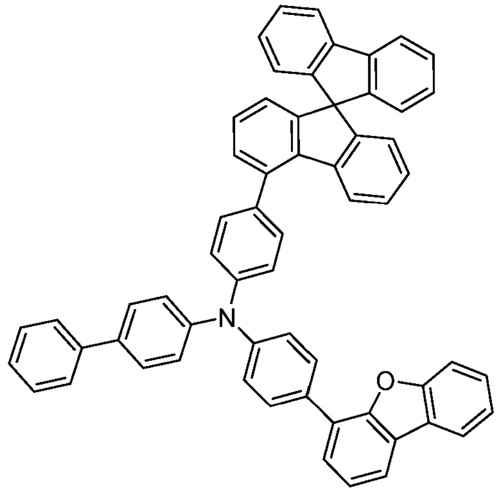 (F16),

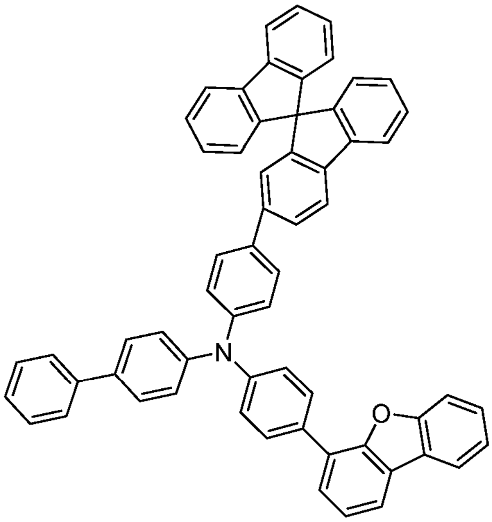 (F17) 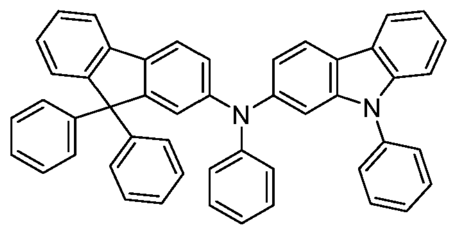 (F18).

According to one embodiment of the invention the electronic organic device is an organic light emitting diode.

According to a preferred embodiment of the invention, the electroluminescent device is an organic light emitting diode, wherein light is emitted through the cathode layer.

The present invention furthermore relates to a display device comprising an organic electroluminescent device according to the present invention.

According to a preferred embodiment of the invention, the display device comprising an organic electroluminescent device according to the present invention, wherein the cathode layer is transparent.

p-type charge generation layer

The p-type charge generation layer may be formed on the anode layer or cathode layer by vacuum deposition, spin coating, printing, casting, slot-die coating, Langmuir-Blodgett (LB) deposition, or the like. When the a p-type charge generation layer is formed using vacuum deposition, the deposition conditions may vary according to the compound(s) that are used to form the layer, and the desired structure and thermal properties of the layer. In general, however, conditions for vacuum deposition may include a deposition temperature of 100° C to 350° C, a pressure of $10^{-8}$ to $10^{-3}$ Torr (1 Torr equals 133.322 Pa), and a deposition rate of 0.1 to 10 nm/sec.

When the a p-type charge generation layer is formed using spin coating or printing, coating conditions may vary according to the compound(s) that are used to form the layer, and the desired structure and thermal properties of the organic semiconductor layer. For example, the coating conditions may include a coating speed of about 2000 rpm to about 5000 rpm, and a thermal treatment temperature of about 80° C to about 200° C. Thermal treatment removes a solvent after the coating is performed.

The thickness of the p-type charge generation layer may be in the range from about 1 nm to about 20 nm, and for

example, from about 2 nm to about 15 nm, alternatively about 2 nm to about 12 nm.

Hole injection layer

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

According to one embodiment of the present invention, the hole injection layer is adjacent to the anode layer.

According to one embodiment of the present invention, the hole injection layer is in direct contact to the anode layer.

Further layers

In accordance with the invention, the organic electroluminescent device may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

*Anode layer*

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

*Hole transport layer*

The organic electronic device according to the present invention may further comprise at least one hole transport layer (HTL). According to one embodiment of the present invention, the at least one hole transport layer is comprised in one of the at least two light-emitting units, wherein preferably at least one hole transport layer is comprised in each light-emitting unit.

A hole transport layer (HTL) may be formed on the HIL or CGL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL or CGL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can

transport holes and inhibit excitons from being diffused into the EML.

According to one embodiment of the present invention, the hole transport layer may comprise a substantially covalent matrix compound as described above.

According to a preferred embodiment of the present invention, the hole injection layer and the hole transport layer may comprise an identical substantially covalent matrix compound as described above.

According to one embodiment of the present invention, the hole transport layer may comprise a compound of formula (VII) or (VIII) as described above.

According to a preferred embodiment of the present invention, the hole injection layer and the hole transport layer may comprise an identical compound of formula (VII) or (VIII) as described above.

According to a preferred embodiment of the present invention, the p-type charge generation layer, the hole injection layer and the hole transport layer may comprise an identical substantially covalent matrix compound.

According to a preferred embodiment of the present invention, the p-type charge generation layer, the hole injection layer and the hole transport layer may comprise an identical an identical compound of formula (VII) or (VIII) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Photoactive layer (PAL)*

According to an embodiment of the present invention, the organic electronic device may further comprise a photoactive layer, wherein the photoactive layer is arranged between the anode layer and the cathode layer.

The photoactive layer converts an electrical current into photons or photons into an electrical current.

The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

The photoactive layer may be a light-emitting layer or a light-absorbing layer, in particular a light-emitting layer.

*Emission layer (EML)*

According to an embodiment of the present invention, the organic electronic device may further comprise an emission layer, wherein the emission layer is arranged between the anode layer and the cathode layer.

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp) 3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The organic electronic device according to the present invention may further comprise at least one electron transport layer (ETL). According to one embodiment of the present invention, the at least one electron transport layer is comprised in one of the at least two light-emitting units, wherein preferably at least one electron transport layer is comprised in each light-emitting unit.

According to another embodiment of the present invention, the electron transport layer may further comprise an azine compound, preferably a pyridine, pyrimidine or triazine compound, and most preferably a triazine compound or a pyrimidine compound.

According to another embodiment of the present invention, the electron transport layer may further comprise 2-([1,1'-biphenyl]-4-yl)-4-(9,9-diphenyl-9H-fluoren-4-yl)-6-phenyl-1,3,5-triazine, 2-(3-(2,6-dimethylpyridin-3-yl)-5-(phenanthren-9-yl)phenyl)-4,6-diphenyl-1,3,5-triazine, 3'-(4-phenyl-6-(spiro[fluorene-9,9'-xanthen]-2'-yl)-1,3,5-triazin-2-yl)-[1,1'-biphenyl]-4-carbonitrile, and 4'-(4-(4-(4,6-diphenyl-1,3,5-triazin-2-yl)phenyl)naphthalen-1-yl)-[1,1'-biphenyl]-4-carbonitrile.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the ETL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a pyridine, pyrimidine or triazine compound, and most preferably a triazine compound.

*Electron injection layer (EIL)*

An optional EIL, which may facilitates injection of electrons from the cathode, may be formed on the ETL preferably closest to the cathode, and more preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.
The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

*Cathode layer*

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.
The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.
In a preferred embodiment, the cathode layer comprises a metal or metal alloy and is transparent.
It is to be understood that the cathode layer is not part of an electron injection layer or the electron transport layer.

**Description of the Drawings**

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.
Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an organic electroluminescent device according to an exemplary embodiment of the present invention.
FIG. 2 is a schematic sectional view of a stacked organic electroluminescent device according to another exemplary embodiment of the present invention.
FIG. 3 is a schematic sectional view of a stacked organic electroluminescent device according to another exemplary embodiment of the present invention.
FIG. 4 is a schematic sectional view of an anode layer 120 on a substrate 110.

Hereinafter, the figures are illustrated in more detail with reference to examples. However, the present disclosure is not limited to the following figures.
Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.
Fig. 1 is a schematic sectional view of an organic electroluminescent device 100, according to one exemplary embodiment of the present invention.
Referring to Fig. 1 the organic electroluminescent device 100 includes a substrate 110, an anode layer 120, a hole injection layer (HIL) 130 comprising the compound of formula (I), and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145. The organic electroluminescent device 100 further comprising a first charge generation layer (CGL1) 150 comprising a first n-type charge generation layer (n-CGL1) 151 and

a first p-type charge generation layer (p-GCL1) 152, wherein the first p-type charge generation layer (p-CGL1) 152 comprises the compound of formula (II) and an organic hole transport material. The organic electronic device 100 further comprising, a second light-emitting unit 240, comprising a second hole transport layer (HTL2) 241, a second electron blocking layer (EBL2) 242, a second emission layer (EML2) 243, a second hole blocking layer (HBL2) 244, and a second electron transport layer (ETL2) 245. The organic electroluminescent device 100 further comprising and electron injection layer (EIL) 180, a cathode layer (CAT) 190.

Fig. 2 is a schematic sectional view of a stacked organic electroluminescent device 100, according to another exemplary embodiment of the present invention. Fig. 2 differs from Fig. 1 in that the organic electroluminescent device 100 of Fig. 1 further comprises a second charge generation layer (CGL2) 250 disposed on the second light-emitting unit 240, comprising a second n-type charge generation layer (n-CGL2) 251 and a second p-type charge generation layer (p-GCL2) 252, wherein the second p-type charge generation layer (p-CGL2) 252 may optionally also comprise the compound of formula (II) and an organic hole transport material. Wherein the organic electroluminescent device 100 of Fig. 2 further differs from Fig. 1 in that it further comprises a third light-emitting unit 340 disposed on the second charge generation layer (CGL2) 250, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

Fig. 3 is a schematic sectional view of a stacked organic electroluminescent device 100, according to another exemplary embodiment of the present invention. Fig. 3 differs from Fig. 2 in that the organic electroluminescent device 100 of Fig. 2 further comprises a third charge generation layer (CGL3) 350 disposed on the third light-emitting unit 340, comprising a third n-type charge generation layer (n-CGL3) 351 and a third p-type charge generation layer (p-GCL3) 352, wherein the third p-type charge generation layer (p-CGL3) 352 may optionally also comprise the compound of formula (II) and an organic hole transport material. Wherein the organic electroluminescent device 100 of Fig. 3 further differs from Fig. 2 in that it further comprises a fourth light-emitting unit 440 disposed on the third charge generation layer (CGL3) 350, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

While not shown in Fig. 1, 2, and 3 a capping and/or a sealing layer may further be formed on the cathode layer 190, in order to seal the organic electronic device 100. In addition, various other modifications may be applied thereto.

FIG. 4 is a schematic sectional view of an anode layer 120 on a substrate 110. The anode layer 120 that comprises a first anode sub-layer 121, a second anode sub-layer 122 and a third anode sub-layer 123.

Hereinafter, one or more exemplary embodiments of the present invention will be described in detail with, reference to the following examples. However, these examples are not intended to limit the purpose and scope of the one or more exemplary embodiments of the present invention.

**Detailed description**

The invention is furthermore illustrated by the following examples which are illustrative only and non-binding.

Compounds of formula (I) may be prepared as described in EP2180029A1 and WO2016097017A1.

Compounds of formula (II) may be prepared by methods known in the art, for example US2005121667A1, or as described below.

Scheme 1: Method for preparation of compounds of formula (II)

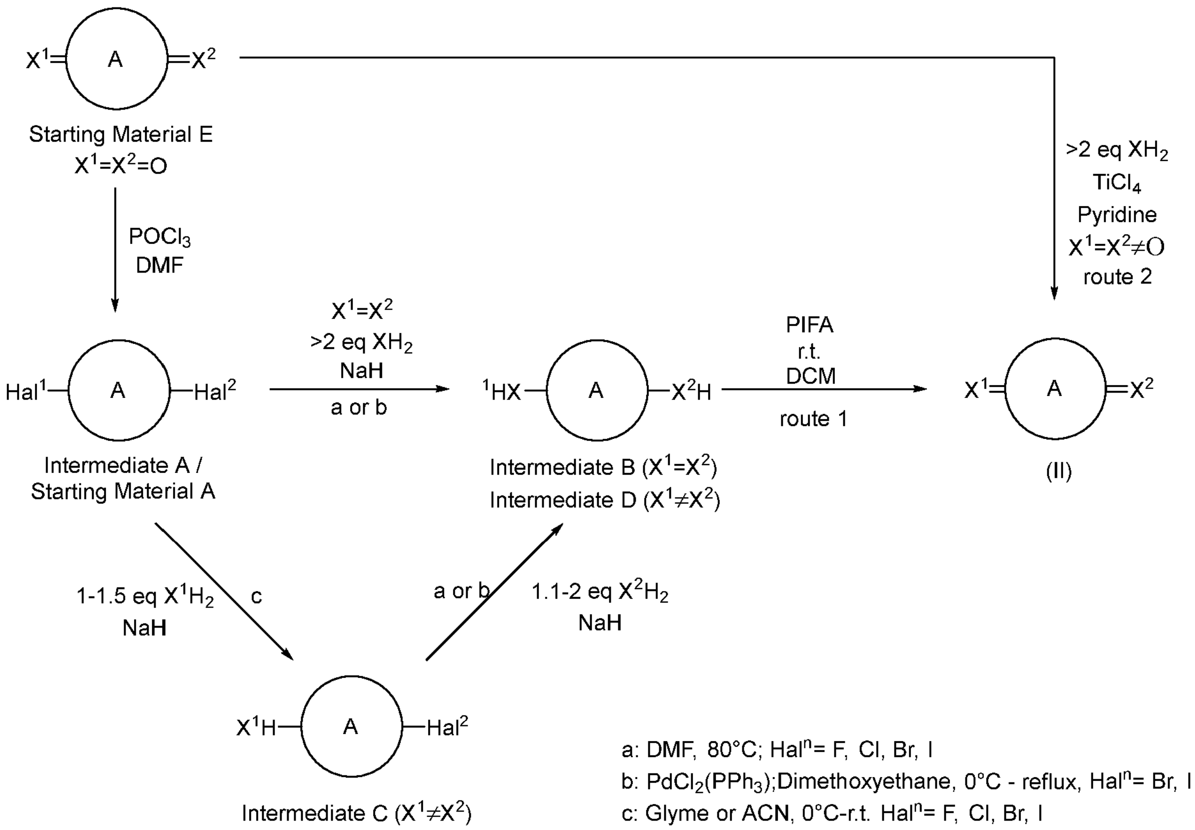


**Conversion of starting material E into Intermediate** A

The conversion from diketones to dihalides was achieved using Bucsis and Friedrichs protocol as published in Chem. Ber. 1976, 109, 2462 - 2468.

**Intermediate** B **(condition a/b)**

In a 3-neck round-bottle flask equipped with a reflux condenser dropping funnel and a septum, 2.4 equivalents of sodium hydride was suspended in dry DMF and cooled below 10°C using an ice bath under inert gas atmosphere. After dropwise addition of a solution of 2.3 equivalents of $XH_2$ in anhydrous DMF (condition b: anhydrous DME), the mixture was stirred for 15 minutes at 0 to 10°C. Then 1 equivalent Compound A (starting material or intermediate) was added in one portion (condition b: followed by 0.05 equivalents catalyst) and the mixture was stirred for 15 minutes at 0°C, 15 minutes at room temperature and at 80°C (at reflux for condition b) overnight. If the reaction was incomplete on the next morning, the reaction mixture was added dropwise to a suspension of 0.5 to 2 equivalents of additional Compound B deprotonated with a small excess of sodium hydride (0.6 to 2.1 equivalents respectively) and stirred at 80°C for further 24 hours. After completion of the reaction, the mixture was poured on an ice/water mixture and acidified with hydrochloric acid. The aqueous phase was extracted with ethyl acetate twice and the organic phase was then washed with half-concentrated brine three times and additionally with concentrated brine and dried using sodium sulfate. After removal of solvents, the product was stirred in DCM over night at room temperature, filtered and dissolved in a small amount of ethyl acetate again. The concentrated solution was then added dropwise into an 8-fold excess of dichloromethane. The precipitated product was filtered, washed with dichloromethane twice, and dried.

**Intermediate C**

In a 3-neck round-bottle flask equipped with a reflux condenser dropping funnel and a septum, 1.2-1.6 equivalents of sodium hydride was suspended in dry DME and cooled below 10°C using an ice bath under inert gas atmosphere. After dropwise addition of a solution of 1.1-1.5 equivalent of $XH_2$ in dry DME, the mixture was stirred for 15 minutes at 0 to 10°C. Then 1 equivalent Compound A (starting material or intermediate) was added as a solid in one portion and the mixture was stirred for 15 minutes at 0°C and at room temperature overnight. If the reaction was found to be incomplete on the next morning, the reaction mixture was added dropwise to a suspension of 0.5 to 1 equivalents of

additional $XH_2$ deprotonated with a small excess of sodium hydride (0.6 to 1.1 equivalents respectively) and stirred for further 24 hours at room temperature. After completion of the reaction, the mixture was poured on an ice/water mixture and acidified with hydrochloric acid. The aqueous phase was extracted with ethyl acetate twice and the organic phase was then washed with half-concentrated brine three times and additionally with concentrated brine and dried using sodium sulfate. After removal of solvents, the product was stirred in toluene over night at room temperature, filtered off, washed with toluene several times and dried.

**Intermediate D**

In a 3-neck round-bottle flask equipped with a reflux condenser dropping funnel and a septum, 1.5 equivalents of sodium hydride was suspended in dry DMF and cooled down below 10°C using an ice bath under inert gas atmosphere. After dropwise addition of a solution of 1.4 equivalents of $XH_2$ in anhydrous DMF, the mixture was stirred for 15 minutes at 0° to 10°C. Then 1 equivalent Intermediate C was added as a solid in one portion and the mixture was stirred for 15 minutes at 0°C, 15 minutes at room temperature and overnight at 80°C. If the reactions was incomplete on the next morning, the reaction mixture was added dropwise to a suspension of 0.5 to 1.5 equivalents of additional Compound $XH_2$ deprotonated with a small excess of sodium hydride (0.6 to 1.6 equivalents respectively) and stirred at 80°C for additional 24 hours. After completion of the reaction, the mixture was poured on an ice/water mixture and acidified with hydrochloric acid. The aqueous phase was extracted with ethyl acetate twice and the organic phase was then washed with half-concentrated brine three times and additionally with concentrated brine and dried using sodium sulfate. After removal of solvents, the product was stirred in DCM over night at room temperature, filtered and dissolved in a small amount of ethyl acetate again. The concentrated solution was then added dropwise into an 8-fold excess of dichloromethane. The precipitated product was filtered, washed with dichloromethane twice, and dried.

**Compound (II) from intermediate B/D**

Prior to oxidation, the Intermediate B / Intermediate D was converted into a potassium salt by suspending in a potassium carbonate solution. The salt was then extracted with ethyl acetate and the solution was concentrated in vacuum. By dropwise addition of the concentrated solution into an excess of n-hexane, the potassium salt was precipitated and filtered off. After drying in vacuum for two hours, the potassium salt was suspended in dry DCM under inert gas atmosphere, 1.1 equivalents of PIFA were added in one portion and the mixture was stirred under exclusion of light over night at room temperature. The product was filtered off, washed with DCM three times and purified by stirring in 50% acetic acid followed by stirring in hot chloroform, filtration from the mother liquor washing with chloroform. The product may be purified further by methods known in the art, for example US2005121667A1.

**Compound (II) from starting material E**

The conversion from diketones to quinodimethanes was achieved by following J. Org. Chem. 1995, 60, 13, 4077-4084 using Lehnerts reagent. The synthesis of N,N-dicyanoquinonediimines was performed using bis(trimethylsilyl) carbodiimide following Hünigs and Aumüllers protocol (Liebigs Annalen der Chemie 1986 (1), 142-164).

Calculated HOMO and LUMO

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

General procedure for fabrication of OLEDs

For the Examples, a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes. The liquid film was removed in a nitrogen stream, followed by plasma treatment, to prepare the anode layer. The plasma treatment was performed in nitrogen atmosphere or in an atmosphere comprising 98 vol.-% nitrogen and 2 vol.-% oxygen.

Then, a hole injection layer (HIL) having a thickness of 10 nm is formed on the anode layer by co-depositing 97 wt.-% F3 (N-([1,1'-biphenyl]-4-yl)-9,9-dimethyl-N-(4-(9-phenyl-9H-carbazol-3-yl)phenyl)-9H-fluoren-2-amine) and 3 wt.-% of quinoid or comparative example according to Table 3.

Then, a first hole transport layer (HTL1) having a thickness of 27 nm is formed on the HIL by depositing F3

(N-([1,1'-biphenyl]-4-yl)-9,9-dimethyl-N-(4-(9-phenyl-9H-carbazol-3-yl)phenyl)-9H-fluoren-2-amine).

Then, a first electron blocking layer (EBL1) having a thickness of 5 nm is formed on the HTL1 by depositing N-([1,1'-biphenyl]-4-yl)-9,9-diphenyl-N-(4-(triphenylsilyl)phenyl)-9H-fluoren-2-amine.

Then, a first emission layer (EML1) having a thickness of 20 nm is formed on the EBL1 by co-depositing 97 vol.-% H09 (Sun Fine Chemicals, Korea) as EML host and 3 vol.-% BD200 (Sun Fine Chemicals, Korea) as fluorescent blue dopant.

Then, a first hole blocking layer (HBL1) having a thickness of 5 nm is formed on the first emission layer by depositing 2-(3'-(9,9-dimethyl-9H-fluoren-2-yl)-[1,1'-biphenyl]-3-yl)-4,6-diphenyl-1,3,5-triazine.

Then, a first electron transport layer (ETL1) having a thickness of 20 nm is formed on the first emission layer by co-depositing 4'-(4-(4-(4,6-diphenyl-1,3,5-triazin-2-yl)phenyl)naphthalen-1-yl)-[1,1'-biphenyl]-4-carbonitrile and LiQ in a ratio of 50:50 wt.-%.

Then, the n-CGL having a thickness of 10 nm is formed on the ETL by co-depositing 99 vol.-% 2,2'-(1,3-Phenylene)bis[9-phenyl-1,10-phenanthroline] and 1 vol.-% Yb.

Then, the p-CGL having a thickness of 10 nm is formed on the n-CGL by co-depositing 93 wt.-% of F3 (N-([1,1'-biphenyl]-4-yl)-9,9-dimethyl-N-(4-(9-phenyl-9H-carbazol-3-yl)phenyl)-9H-fluoren-2-amine) as a matrix compound and 7 wt.-% of a compound of formula (II) or comparative examples according to Table 3. The composition of the p-CGL can be seen in Tables 1 and 2.

Then, a second hole transport layer (HTL2) having a thickness of 24 nm is formed on the p-CGL by depositing F3 (N-([1,1'-biphenyl]-4-yl)-9,9-dimethyl-N-(4-(9-phenyl-9H-carbazol-3-yl)phenyl)-9H-fluoren-2-amine).

Then, a second electron blocking layer (EBL2) having a thickness of 5 nm is formed on the HTL2 by depositing N-([1,1'-biphenyl]-4-yl)-9,9-diphenyl-N-(4-(triphenylsilyl)phenyl)-9H-fluoren-2-amine.

Then, a second emission layer (EML2) having a thickness of 20 nm is formed on the EBL2 by co-depositing 97 vol.-% H09 (Sun Fine Chemicals, Korea) as EML host and 3 vol.-% BD200 (Sun Fine Chemicals, Korea) as fluorescent blue dopant.

Then, a second hole blocking layer (HBL2) having a thickness of 5 nm is formed on the EML2 by depositing 2-(3'-(9,9-dimethyl-9H-fluoren-2-yl)-[1,1'-biphenyl]-3-yl)-4,6-diphenyl-1,3,5-triazine.

Then, a second electron transport layer (ETL2) having a thickness of 30 nm is formed on the HBL by co-depositing 4'-(4-(4-(4,6-diphenyl-1,3,5-triazin-2-yl)phenyl)naphthalen-1-yl)-[1,1'-biphenyl]-4-carbonitrile and LiQ in a ratio of 50:50 wt.-%.

Then, an electron injection layer (EIL) having a thickness of 2 nm is formed on the ETL2 by depositing Yb.

Then, the cathode layer having a thickness of 13 nm is formed on the EIL by co-depositing Ag:Mg (90:10 vol.-%) at a rate of 0.01 to 1 Å/s at $10^{-7}$ mbar.

Then, a capping layer having a thickness of 75 nm is formed on the cathode layer by depositing compound F3 (N-([1,1'-biphenyl]-4-yl)-9,9-dimethyl-N-(4-(9-phenyl-9H-carbazol-3-yl)phenyl)-9H-fluoren-2-amine).

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/$m^2$ using an Instrument Systems CAS-140CT array spectrometer (calibrated by Deutsche Akkreditierungsstelle (DAkkS)) for each of the voltage values. The cd/A efficiency at 15 mA/$cm^2$ is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 15 mA/$cm^2$.

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at at 15 mA/$cm^2$.

Lifetime LT of the device is measured at ambient conditions (20°C) and 30 mA/$cm^2$, using a Keithley 2400 sourcemeter, and recorded in hours.

The brightness of the device is measured using a calibrated photo diode. The lifetime LT is defined as the time till the brightness of the device is reduced to 97 % of its initial value.

The increase in operating voltage $\Delta U$ is used as a measure of the operational voltage stability of the device. This increase is determined during the LT measurement and by subtracting the operating voltage after 1 hour after the start of operation of the device from the operating voltage after 50 hours.

$$\Delta U=[U50\ h)-\ U(1h)]$$

This increase is also determined during the LT measurement and by subtracting the operating voltage after 1 hour after the start of operation of the device from the operating voltage after 100 hours.

$$\Delta U=[U100\ h)-\ U(1h)]$$

The smaller the value of ΔU the better is the operating voltage stability.

**Technical Effect of the invention**

Table 1: Calculated LUMO of compounds

The LUMO is calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

Table 1 shows the LUMO for selected quinoid compounds

Table 1: LUMOs for selected quinoid compounds

| No. | Structure | LUMO [eV] DFT |
|---|---|---|
| QC-1 | 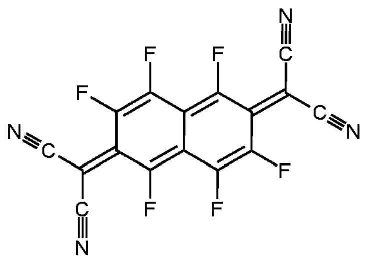 | -5.29 |
| QC-2 | 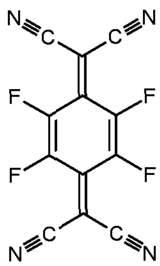 | -5.25 |
| QE-1 | 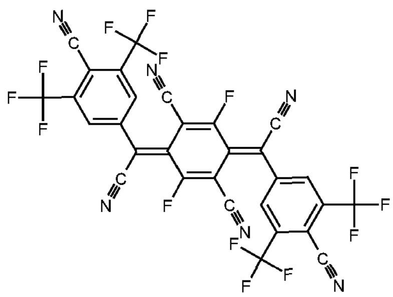 | -5.25 |

(continued)

| No. | Structure | LUMO [eV] DFT |
|---|---|---|
| QE-2 | 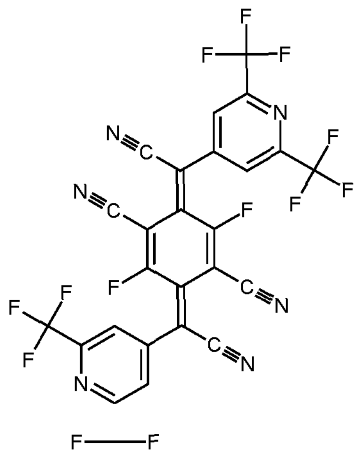 | -5.31 |
| QE-3 | 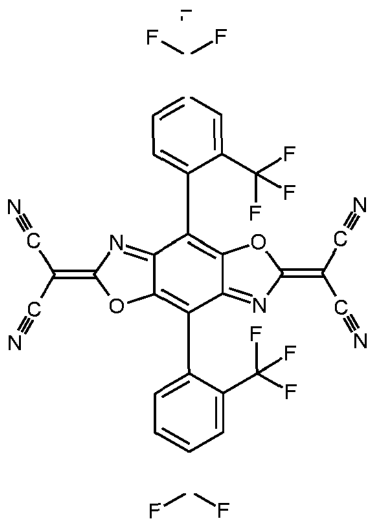 | -5.35 |
| QE-4 | 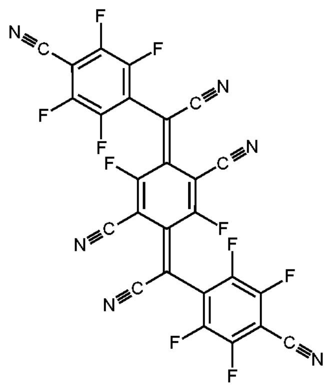 | -5.21 |

(continued)

| No. | Structure | LUMO [eV] DFT |
|---|---|---|
| QE-5 | 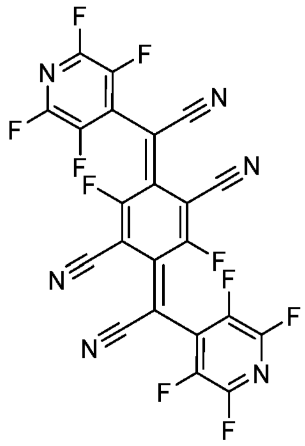 | -5.13 |

Table 2 shows the LUMO values for selected radialene compounds

Table 2: LUMO values for selected radialene compounds

| | $Ar^1$ of $A^1$ | $Ar^2$ of $A^2$ | $Ar^3$ of $A^3$ | LUMO [eV] DFT |
|---|---|---|---|---|
| A1 | 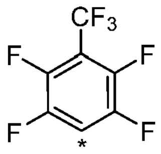 | 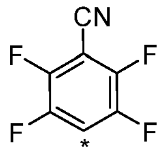 | 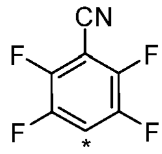 | -5.10 |
| A2 | 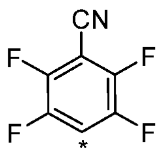 | 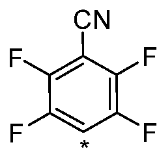 | 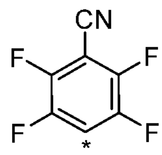 | -5.19 |
| A3 | 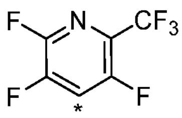 | 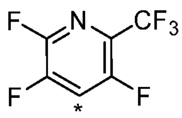 | 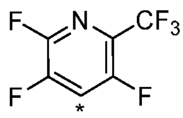 | -5.29 |
| A4 | 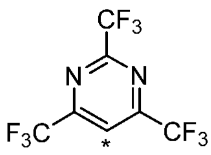 | 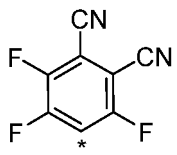 | 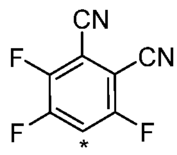 | -5.44 |
| A5 | 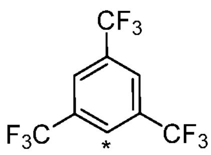 | 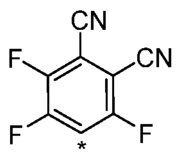 | 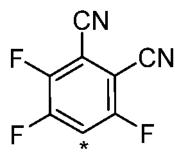 | -5.22 |
| A6 | 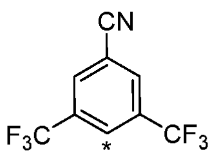 | 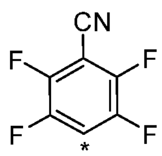 | 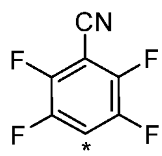 | -5.07 |

(continued)

| | $Ar^1$ of $A^1$ | $Ar^2$ of $A^2$ | $Ar^3$ of $A^3$ | **LUMO [eV] DFT** |
|---|---|---|---|---|
| A7 | 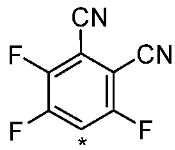 | 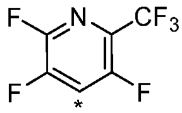 | 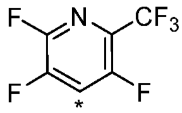 | -5.34 |
| A8 | 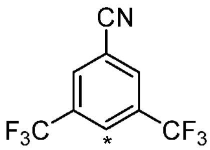 | 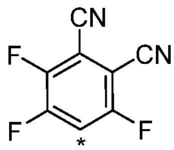 | 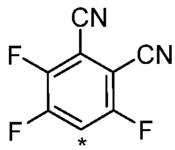 | -5.32 |
| A9 | 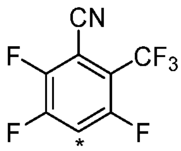 | 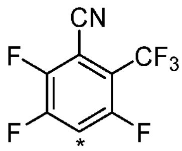 | 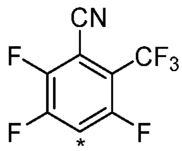 | -5.32 |
| A10 | 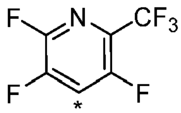 | 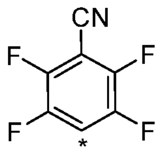 | 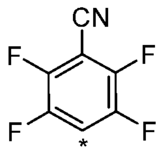 | -5.23 |
| A11 | 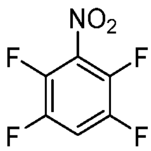 | 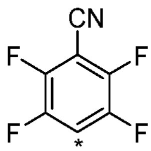 | 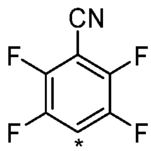 | -5.21 |
| A12 | 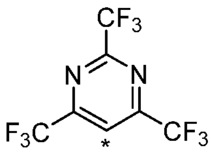 | 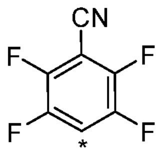 | 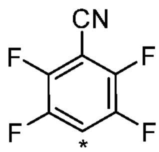 | -5.19 |
| A13 | 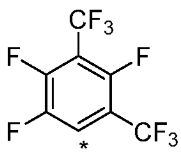 | 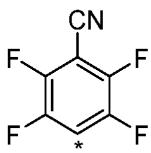 | 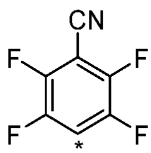 | -5.10 |

The setup as well as the properties of selected organic devices is shown in Table 3:

Table 3: Setup and properties of selected organic devices.

| | **Hole injection layer** | **p-Type charge generation layer** | **Voltage at 15mA/cm$^2$ [V]** | **LT97 at 30mA/cm$^2$ [h]** | **Vrise (1-50h) at 30mA/cm$^2$ [V]** | **Vrise (1-100h) at 30mA/cm$^2$ [V]** |
|---|---|---|---|---|---|---|
| Comp. 1 | QC-1 | QC-1 | 8.37 | 88 | 0.209 | 0.300 |
| Comp. 2 | QC-1 | A1 | 7.60 | 116 | 0.143 | 0.201 |
| Comp. 3 | A1 | QC-1 | 8.28 | 100 | 0.116 | 0.161 |
| Comp. 4 | QE-1 | QC-1 | 8.37 | 86 | 0.185 | 0.269 |
| Inv. ex. 1 | QE-1 | A1 | 7.58 | 114 | 0.092 | 0.112 |
| Inv. ex. 2 | QE-1 | A5 | 7.55 | 114 | 0.089 | 0.109 |

(continued)

| | Hole injection layer | p-Type charge generation layer | Voltage at 15mA/cm$^2$ [V] | LT97 at 30mA/cm$^2$ [h] | Vrise (1-50h) at 30mA/cm$^2$ [V] | Vrise (1-100h) at 30mA/cm$^2$ [V] |
|---|---|---|---|---|---|---|
| Inv. ex. 3 | QE-1 | A4 | 7.50 | 115 | 0.093 | 0.113 |
| Inv. ex. 4 | QE-1 | A7 | 7.51 | 108 | 0.091 | 0.120 |
| Inv. ex. 5 | QE-1 | A10 | 7.48 | 110 | 0.084 | 0.109 |
| Inv. ex. 6 | QE-1 | A12 | 7.50 | 110 | 0.083 | 0.106 |

The inventive examples 1 to 6 exhibit a lower operational voltage than the comparative examples 1 and 2.

The comparative device 1 (comparative example 1) contains the same quinoid F6-TCNNQ in the hole injection layer and in the p-type charge generation layer exhibit a very high operational voltage.

When a radialene is used in the p-type charge generation layer (comparative example 2) instead of F6-TCNNQ, the operational voltage is high.

When using a radialene in the hole injection layer instead of a quinone (comparative example 3), the operational voltage over time is as high as the comparative device 1 (comparative example 1).

When using another quinoid in the hole injection layer instead of F6-TCNNQ (comparative example 4), the operational voltage is as high as the comparative device 1 (comparative example 1).

However, when a quinoid having an aryl substituent is used (inventive example 1), the operational voltage can be improved in comparison to comparative example 1 but also to comparative example 2.

A lower operating voltage may be important for the battery life of organic electronic devices, in particular mobile devices.

The inventive examples 1 to 6 exhibit a lower voltage rise over time than the comparative examples 1 and 2.

The comparative device 1 (comparative example 1) containing the same quinoid F6-TCNNQ exhibit a very high voltage rise over time.

When using a radialene in the p-type charge generation layer instead of F6-TCNNQ (comparative example 2), the voltage rise over time is very high.

When using a radialene in the hole injection layer instead of a quinone (comparative example 3), the voltage rise over time is very high (comparative example 1).

When using another quinoid in the hole injection layer instead of F6-TCNNQ (comparative example 4), the voltage rise over time is very high.

However, when using a quinoid having an aryl substituent in the hole injection layer and a radialene in the p-type charge generation layer, the voltage rise over time can lowered remarkably in comparison the comparative examples.

It is known by the skilled person in the art that the stability is decreased at layers with more interfaces, the voltage rise is determined by the layers with more interfaces. Since the CGL contains a n-CGL and p-CGL, it is assumed by the skilled person in the art that the CGL is the important factor for influencing the voltage rise over time.

Thus, it could surprisingly be demonstrated that a radialene having a lower LUMO in the hole injection layer has an effect on the voltage rise over time which is even higher than the use of a radialene having a lower LUMO in the p-type charge generation layer.

A low voltage rise over time may result in improved long-term stability of electronic devices.

## Claims

**1.** An organic electronic device comprising an anode layer, a cathode layer, a hole injection layer, at least two light-emitting units, and at least one charge generation layer, wherein at least one charge generation layer comprises a p-type charge generation layer;

wherein each light-emitting unit comprises at least one light-emitting layer,
wherein each of the at least one charge generation layers is disposed independently between a set of two adjacent light-emitting units of the at least two light emitting-units,
wherein the hole injection layer is closer to the anode layer than the p-type charge generation layer,
wherein the p-type charge generation layer comprises a first hole transport matrix compound and a radialene of formula (I),

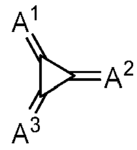

(I),

wherein in formula (I)

- $A^1$ is independently selected from a group of formula (Ia)

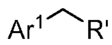

(Ia)

wherein $Ar^1$ is independently selected from substituted or unsubstituted $C_6$ to $C_{36}$ aryl, and substituted or unsubstituted $C_2$ to $C_{36}$ heteroaryl;
wherein for the case that $Ar^1$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^2$ is independently selected from a group of formula (Ib)

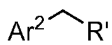

(Ib),

wherein $Ar^2$ is independently selected from substituted or unsubstituted $C_6$ to $C_{36}$ aryl, and substituted or unsubstituted $C_2$ to $C_{36}$ heteroaryl;
wherein for the case that $Ar^2$ is substituted, one or more of the substituents are independently selected from the group consisting of D, an electron-withdrawing group, halogen, Cl, F, CN, $NO_2$,substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^3$ is independently selected from a group of formula (Ic)

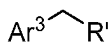

(Ic),

wherein $Ar^3$ is independently selected from substituted or unsubstituted $C_6$ to $C_{36}$ aryl, and substituted or unsubstituted $C_2$ to $C_{36}$ heteroaryl;
wherein for the case that $Ar^3$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$

aryl, and substituted or unsubstituted $C_6$ to $C_{30}$ heteroaryl,
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
and wherein in $A^1$, $A^2$, and $A^3$ each R' is independently selected from substituted or unsubstituted $C_6$ to $C_{18}$ aryl, substituted or unsubstituted $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN;
wherein the one or more substituents of $C_6$ to $C_{18}$ aryl, $C_6$ to $C_{18}$ heteroaryl, $C_1$ to $C_8$ alkyl, are independently selected from D, an electron-withdrawing group, halogen, Cl, F, CN, - $NO_2$, partially fluorinated $C_1$ to $C_6$ alkyl, perfluorinated $C_1$ to $C_6$ alkyl, partially fluorinated $C_1$ to $C_6$ alkoxy, perfluorinated $C_1$ to $C_6$ alkoxy;
**characterized in that** the hole injection layer comprises a second hole transport matrix compound and a compound of formula (II), whereby the compound of formula (II) is a quinoide compound, whereby the term "quinoide compound" means and/includes a compound which contains a moiety which is (formally) derived from a compound comprising an annelated aromatic system or non-annelated aromatic system whereby an even number of carbon atoms of said annelated aromatic system or non-annelated aromatic system are double bonded to an atom or a group outside said annelated aromatic system or non-annelated aromatic system with any necessary rearrangement of double bonds, and whereby the compound of formula (II) contains at least one substituted or unsubstituted aryl substituent or at least one substituted or unsubstituted heteroaryl substituent; preferably substituted aryl substituent or substituted heteroaryl substituent, more preferably substituted $C_6$ to $C_{30}$ aryl or substituted $C_3$ to $C_{30}$ heteroaryl preferably, and more preferably substituted phenyl or substituted $C_3$ to $C_5$ heteroaryl and wherein preferably $C_3$ to $C_5$ heteroaryl is a six-member heteroaromatic ring.

2. The organic electroluminescent device according to claim 1, wherein in the compound of formula (II) the necessary rearrangement of double bonds results in at least a partial lift of aromaticity in the annelated aromatic system or non-annelated aromatic system.

3. The organic electroluminescent device of Claim 1 or 2 wherein the compound of formula (II) is a compound according to formula (IIa):

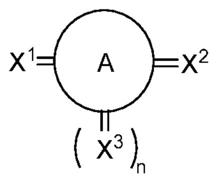

(IIa)

wherein n is an even integer including 0,
wherein $X^1$, $X^2$, and $X^3$ are independently selected from O, S, $CR^{1a}R^{2a}$, $CR^{1b}R^{2b}$, $NR^{3a}$, $NR^{3b}$;
wherein $R^{1a}$, $R^{2a}$, $R^{1b}$, and $R^{2b}$, are independently selected from halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $NO_2$, $SF_5$, substituted or unsubstituted $C_6$ to $C_{30}$ aryl, substituted or unsubstituted $C_3$ to $C_{30}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$;
wherein $R^{3a}$ and $R^{3b}$ is selected from CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,
wherein the one or more substituents are independently selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$,
wherein ring A is selected from

| | | |
|---|---|---|
| 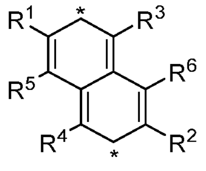 | 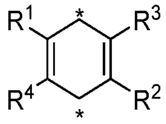 | 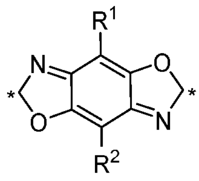 |
| 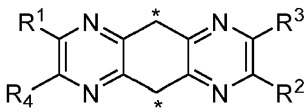 | 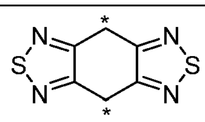 | 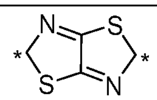 |
| 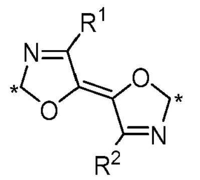 | 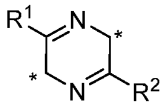 | |
| 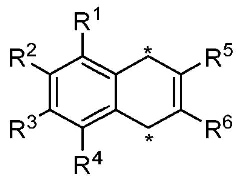 | 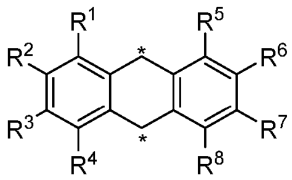 | 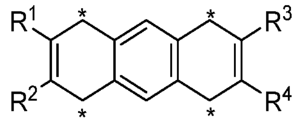 |
| 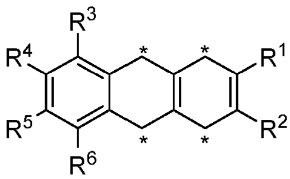 | 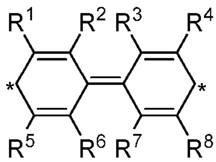 | 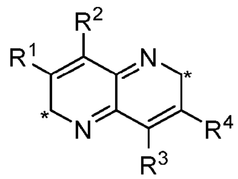 |
| 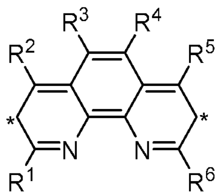 | 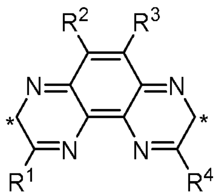 | 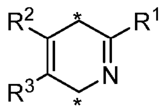 |
| 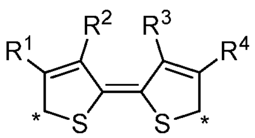 | 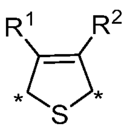 | 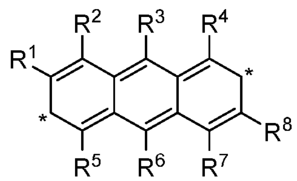 |

| | | |
|---|---|---|
| 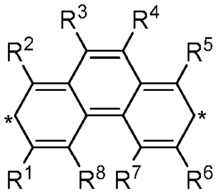 | 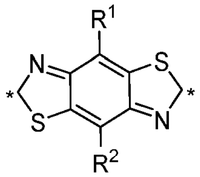 | 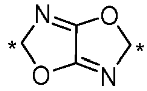 |
| 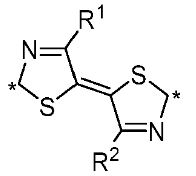 | 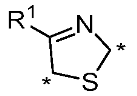 | 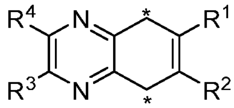 |
| 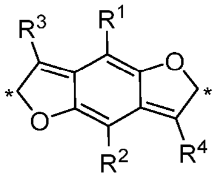 | 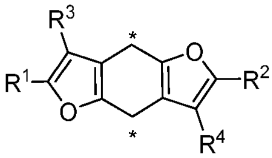 | 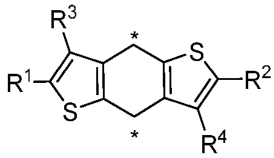 |
| 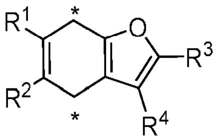 | 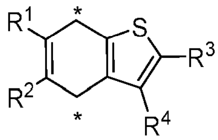 | 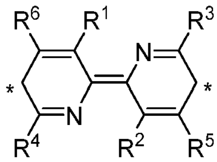 |
| 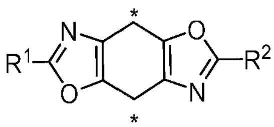 | 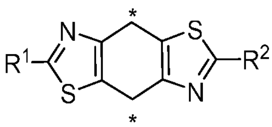 | 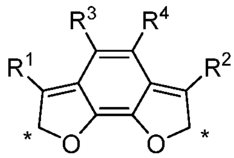 |
| 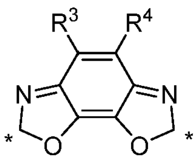 | 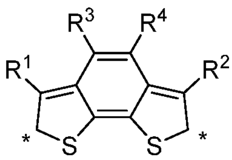 | 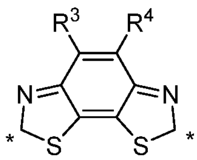 |
| 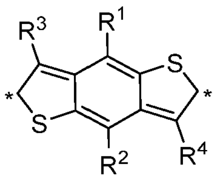 | 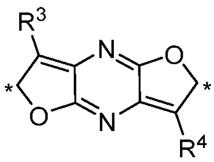 | 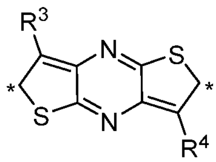 |
| 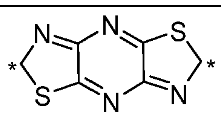 | 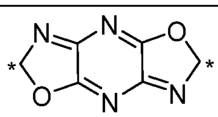 | 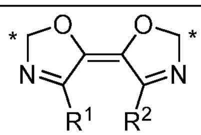 |
| 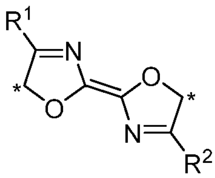 | 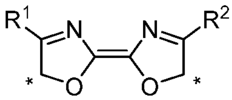 | 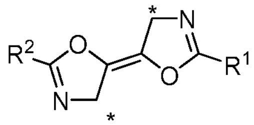 |

| | | |
|---|---|---|
| 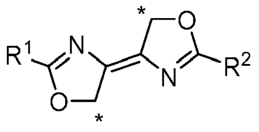 | 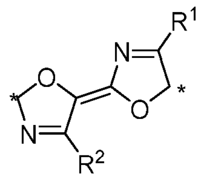 | 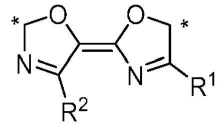 |
| 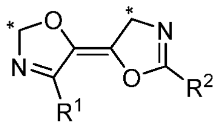 | 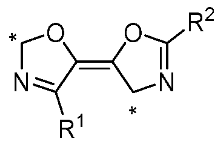 | 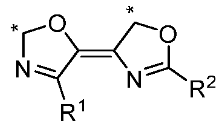 |
| 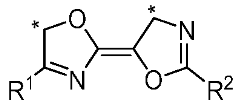 | 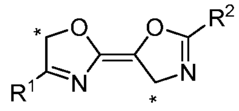 | 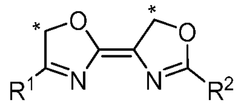 |
| 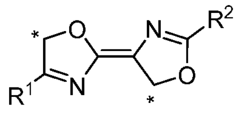 | 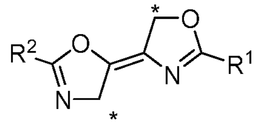 | 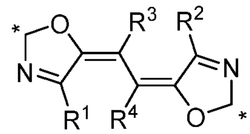 |
| 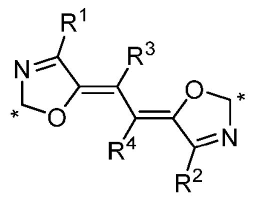 | 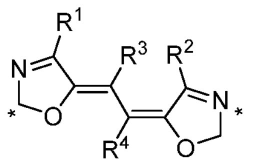 | 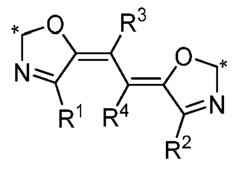 |
| 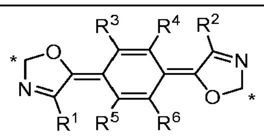 | 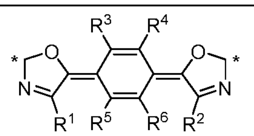 | 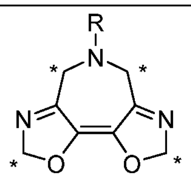 |

wherein the asterisk "*" denotes the binding position;
wherein $R^1$, $R^2$, $R^3$, $R^4$, $R^5$, $R^6$, $R^7$ and $R^8$ are independently selected from D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, $OCF_3$, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$,
wherein the one or more substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$; and
wherein at least one of $R^{1a}$, $R^{2a}$, $R^{1b}$, $R^{2b}$, $R^{3a}$, $R^{3b}$, $R^1$, $R^2$, $R^3$, $R^4$, $R^5$, $R^6$, $R^7$ and $R^8$ is independently selected from a substituted or unsubstituted $C_6$ to $C_{30}$ aryl or substituted or unsubstituted $C_3$ to $C_{30}$ heteroaryl preferably substituted $C_6$ to $C_{30}$ aryl or substituted $C_3$ to $C_{30}$ heteroarylmore preferably substituted phenyl or substituted $C_3$ to $C_5$ heteroaryl and wherein preferably $C_3$ to $C_5$ heteroaryl is a six-member heteroaromatic ring.

4. The organic electroluminescent device according to any one of claims 1 or 3, wherein the at least one charge generation layer further comprises an n-type charge generation layer.

5. The organic electroluminescent device according to any one of claims 1 to 4, wherein in formula (I), R' is selected from CN.

6. The organic electroluminescent device according to any of the claims 1 to 5, whereby the compound of formula (I) has

a calculated LUMO energy level, of ≤ -4.60 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase; preferably ≤ -4.75 eV; more preferably ≤ -5.00 eV; even more preferred ≤ -5.10 eV; even more preferred ≤ -5.15 eV; even more preferred ≤ -5.19 eV; even more preferred ≤ -5.20 eV, and even more preferred ≤ -5.22 eV.

**7.** The organic electroluminescent device according to any of the claims 1 to 6, wherein in formula (I), $Ar^1$, $Ar^2$ and $Ar^3$ are independently selected from one of the following groups:

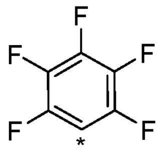 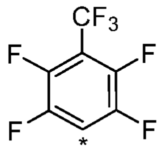 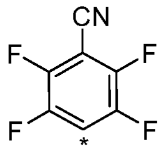 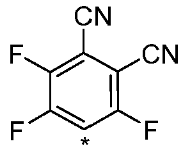 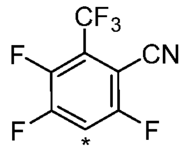

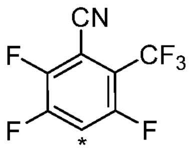 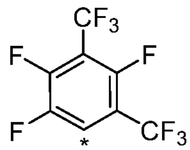 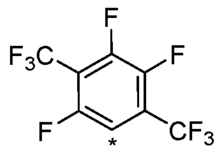 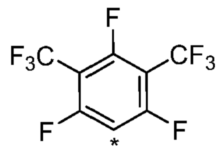 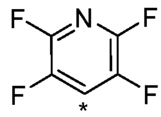

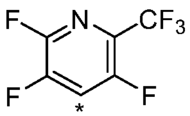 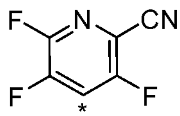 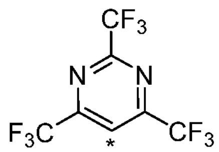 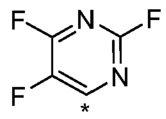 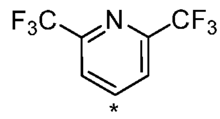

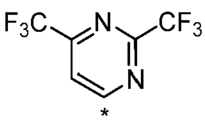 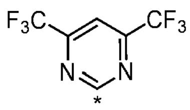 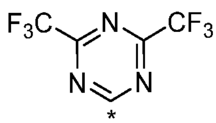 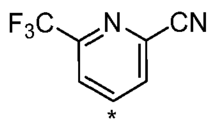 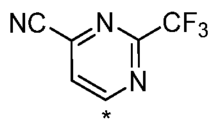

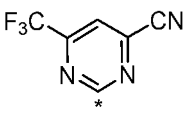 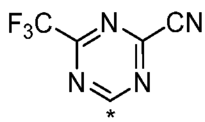 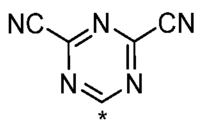 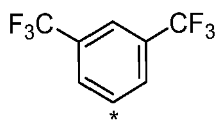 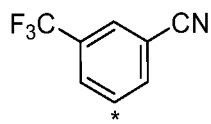

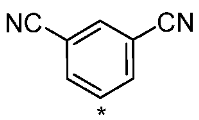 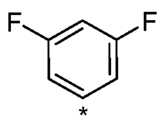 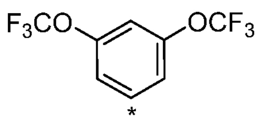 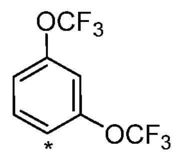 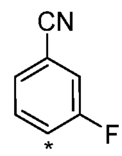

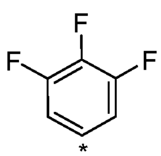 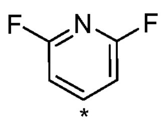 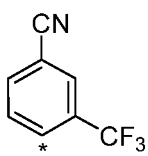 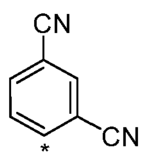 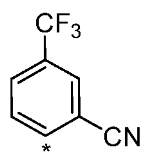

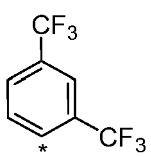 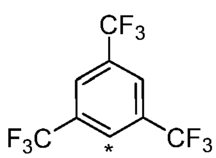 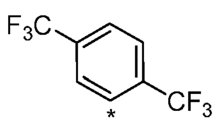 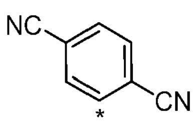 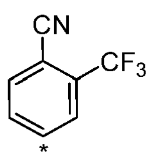

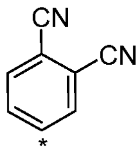 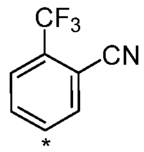 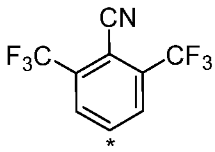 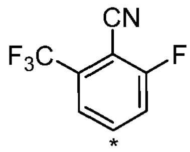 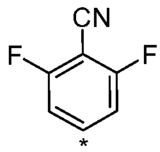

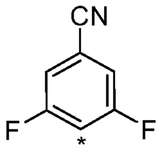 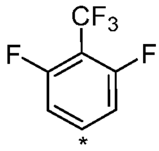 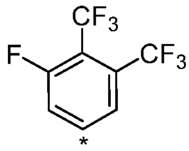 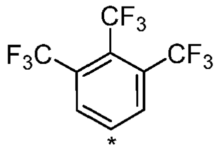 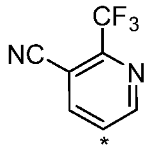

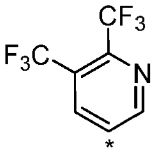 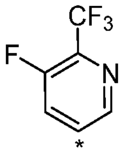 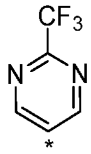 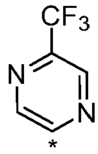 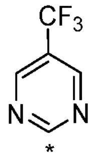

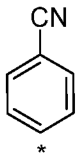 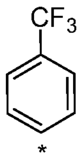 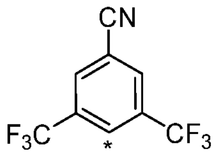 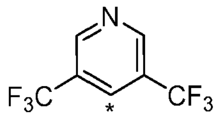 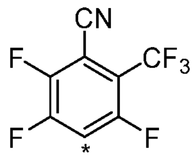

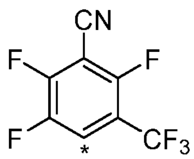 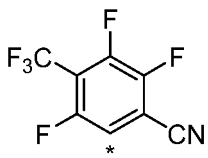 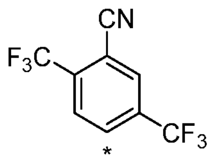

wherein the asterisk "*" denotes the binding position.

8. The organic electroluminescent device according to any one of claims 1 to 7, the compound of formula (II) has a molecular weight of ≥340 g/mol.

9. The organic electroluminescent device according to any one of claims 1 to 8, wherein the compound of formula (II) has a calculated LUMO energy level of ≥ -5.75 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

10. The organic electroluminescent device according to any one of claims 3 to 9, wherein the compound of formula (IIa), Ring A is selected from:

| | | |
|---|---|---|
| 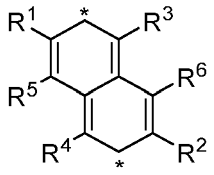 | 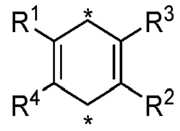 | 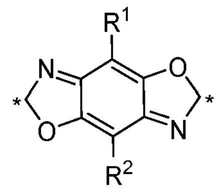 |
| 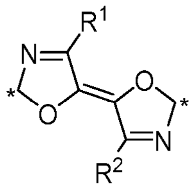 | 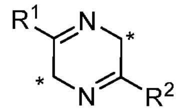 | |
| 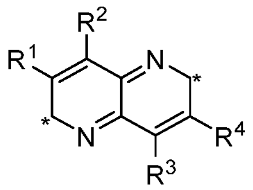 | 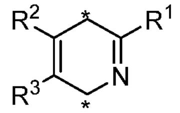 | 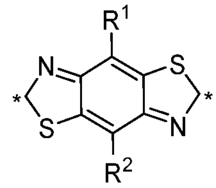 |
| 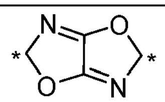 | 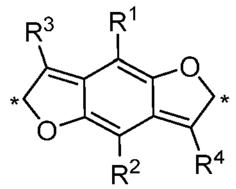 | 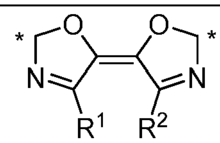 |
| 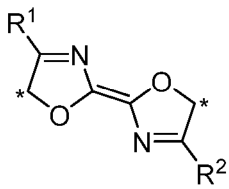 | 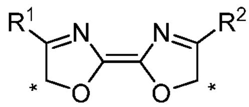 | 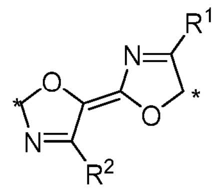 |

| | | |
|---|---|---|
| 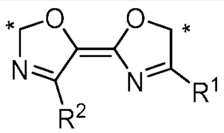 | | |

wherein the asterisk "*" denotes the binding position.

**11.** The organic electroluminescent device according to any one of claims 3 to 10, whereby in formulae (IIa) the at least one aryl substituent or the at least one heteroaryl substituent is selected from

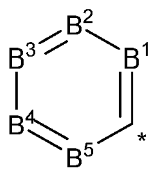 (XXXx)

$B^1$ is selected from $CL^1$ or N;
$B^2$ is selected from $CL^2$ or N;
$B^3$ is selected from $CL^3$ or N;
$B^4$ is selected from $CL^4$ or N;
$B^5$ is selected from $CL^5$ or N;

$L^1$, $L^2$, $L^3$, $L^4$, and $L^5$ are independently selected from CN, isocyano, SCN, OCN, $NO_2$, $SF_5$, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H; wherein the asterisk "*" denotes the binding position.

**12.** The organic electroluminescent device according to any one of claims 3 + to 11, whereby in formulae (IIa) the at least one aryl substituent or the at least one heteroaryl substituent is selected from

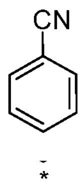 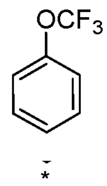 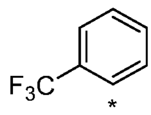 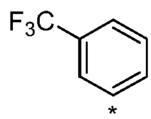 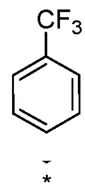

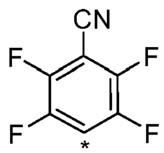 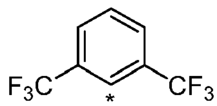 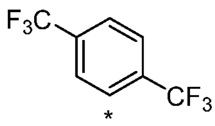 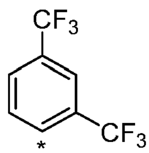 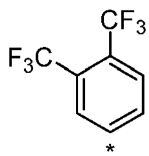

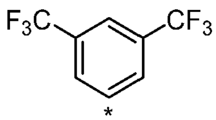 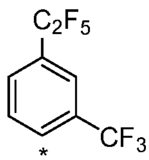 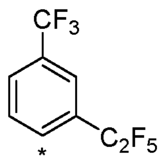 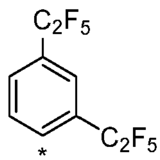 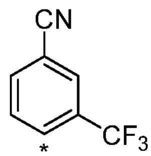

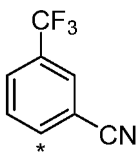 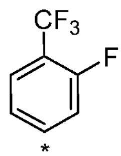 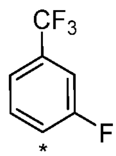 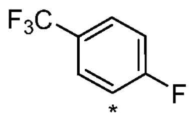 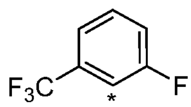

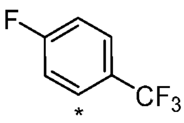 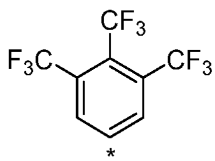 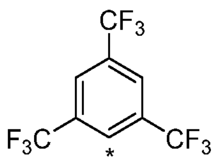 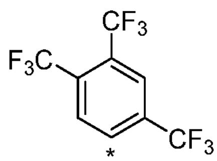 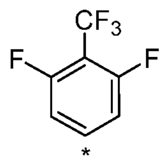

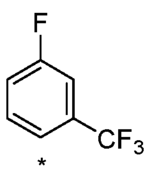 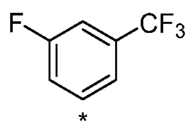 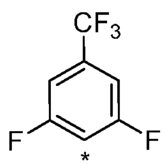 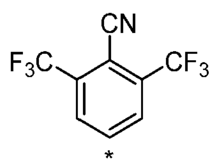

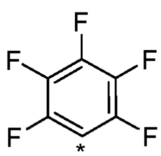 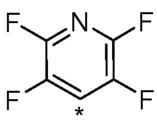 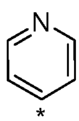 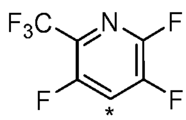 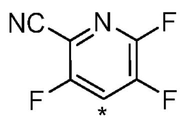

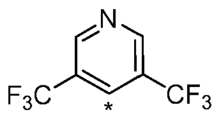 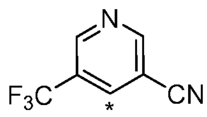 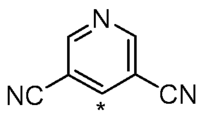 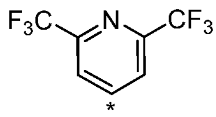 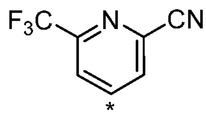

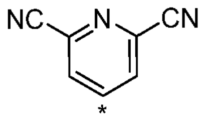 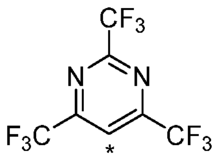 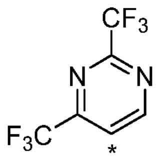 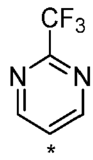 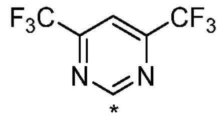

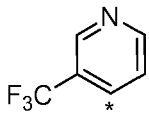 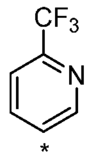 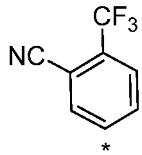 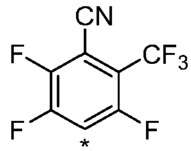 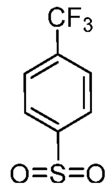

wherein the asterisk "*" denotes the binding position.

**13.** The organic electroluminescent device according to any one of claims 3 to 12, whereby in formulae (IIa) $X^1$ is selected from;

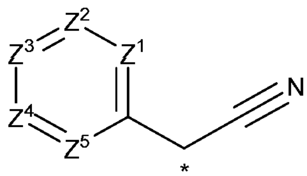

(XXa)

wherein

$Z^1$ is selected from $CY^1$ or N;
$Z^2$ is selected from $CY^2$ or N;
$Z^3$ is selected from $CY^3$ or N;
$Z^4$ is selected from $CY^4$ or N;
$Z^5$ is selected from $CY^5$ or N;
wherein
$Y^1$, $Y^2$, $Y^3$, $Y^4$, and $Y^5$ are independently selected from CN, isocyano, SCN, OCN, $NO_2$, $SF_5$, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, halogen, Cl, F, D or H, wherein the asterisk "*" denotes the binding position.

**14.** The organic electroluminescent device according to any one of claims 3 + to 12, in formula (IIa) $X^1$ and/or $X^2$ are independently selected from:

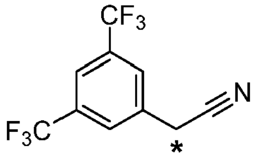 (X1), 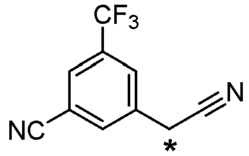 (X2), 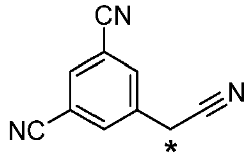 (X3),

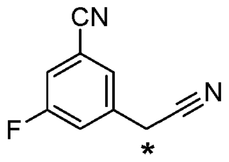 (X4), 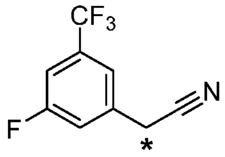 (X5), 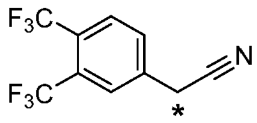 (X6),

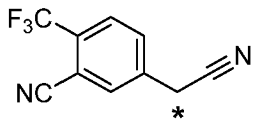 (X7), 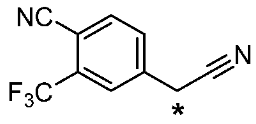 (X8), 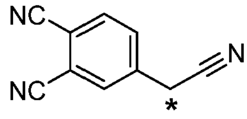 (X9),

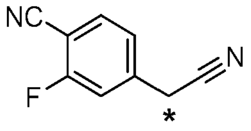 (X10), 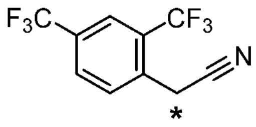 (X11), 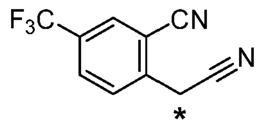 (X12),

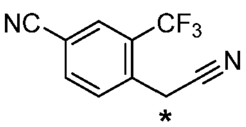 (X13), 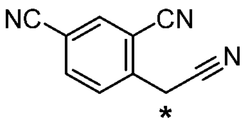 (X14), 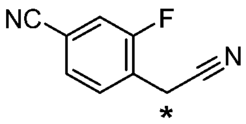 (X15),

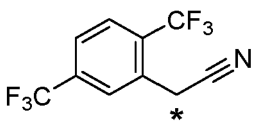 (X16), 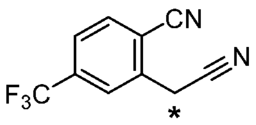 (X17), 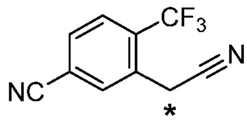 (X18),

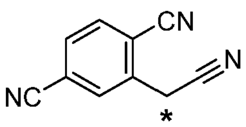 (X19), 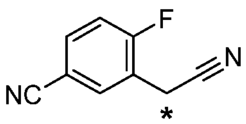 (X20), 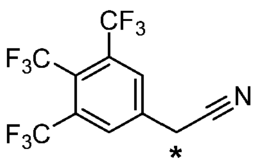 (X21),

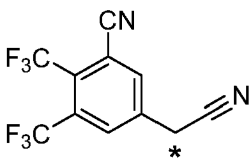 (X22), 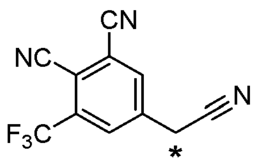 (X23), 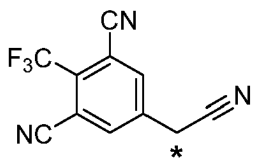 (X24),

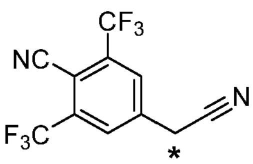 (X25), 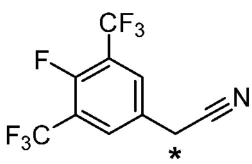 (X26), 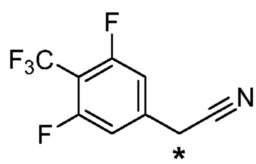 (X27),

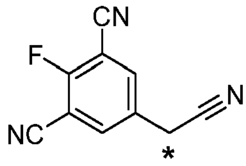 (X28), 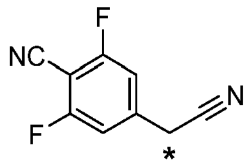 (X29), 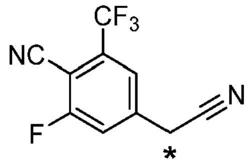 (X30),

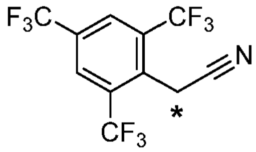 (X31), 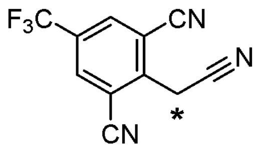 (X32), 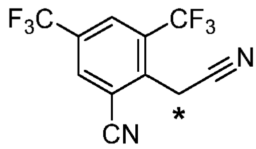 (X33),

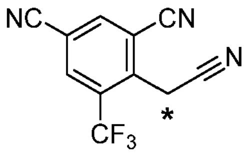 (X34), 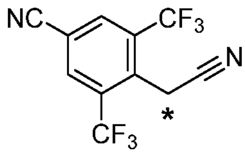 (X35), 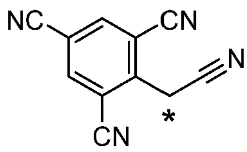 (X36),

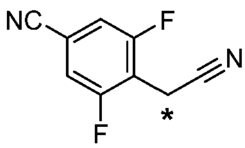 (X37), 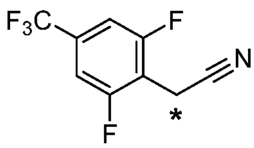 (X38), 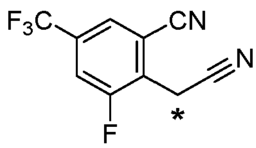 (X39),

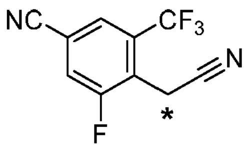 (X40), 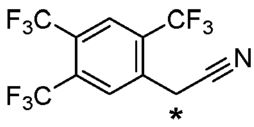 (X41), 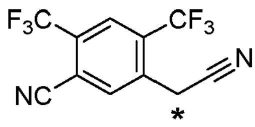 (X42),

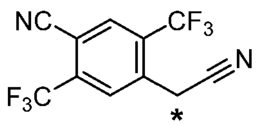 (X43), 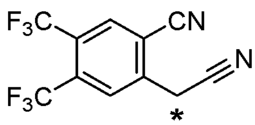 (X44), 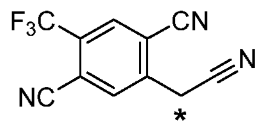 (X45),

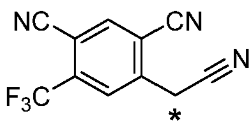 (X46), 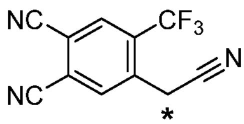 (X47), 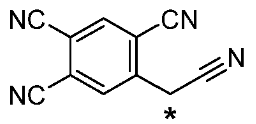 (X48),

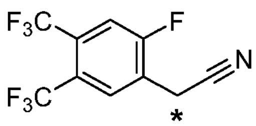 (X49), 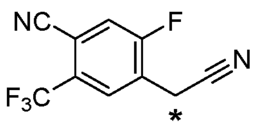 (X50), 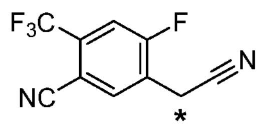 (X51),

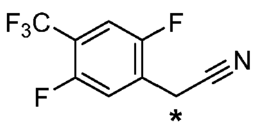 (X52), 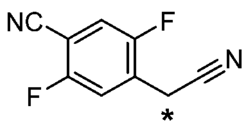 (X53), 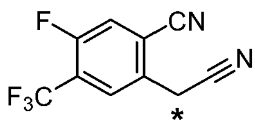 (X54),

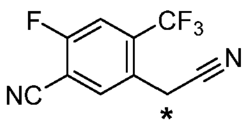 (X55), 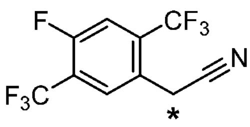 (X56), 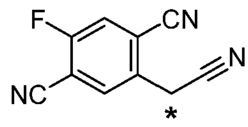 (X57),

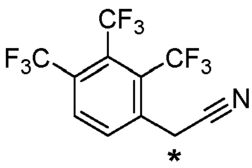 (X58), 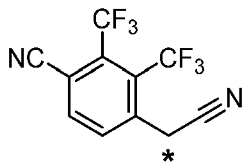 (X59), 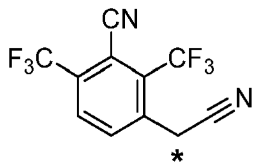 (X60),

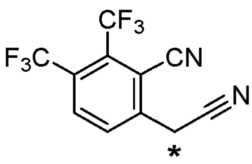 (X61), 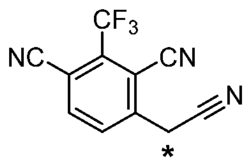 (X62), 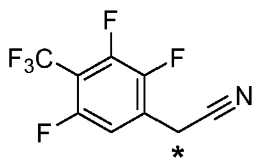 (X63),

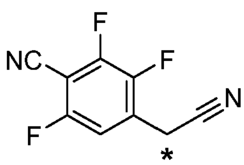 (X64), 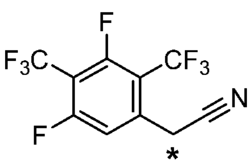 (X65), 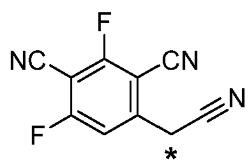 (X66),

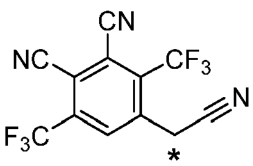 (X67), 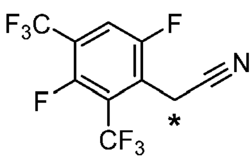 (X68), 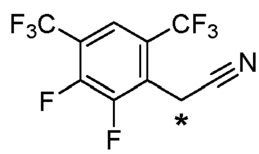 (X69),

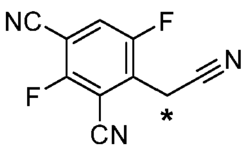 (X70), 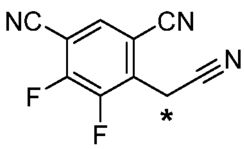 (X71), 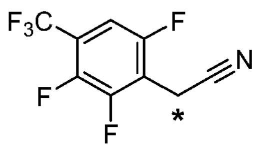 (X72),

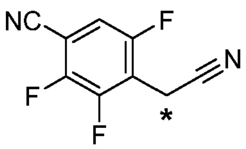 (X73), 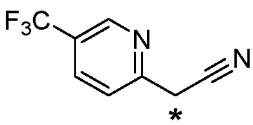 (X74), 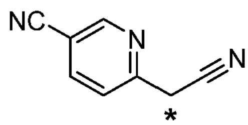 (X75),

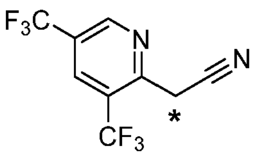 (X76), 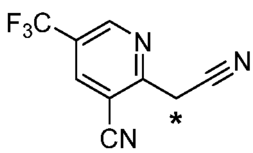 (X77), 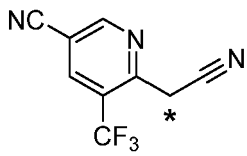 (X78),

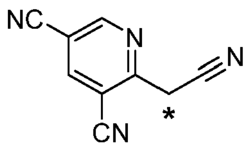 (X79), 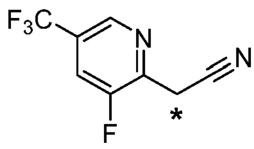 (X80), 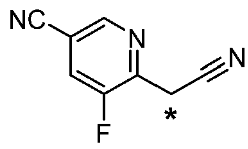 (X81),

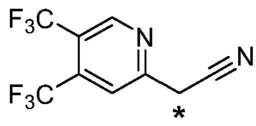 (X82), 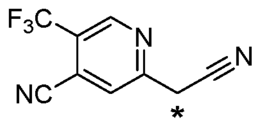 (X83), 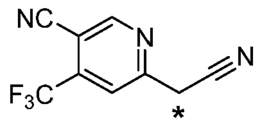 (X84),

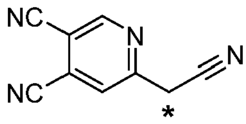 (X85), 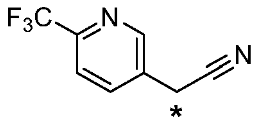 (X86), 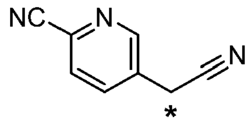 (X87),

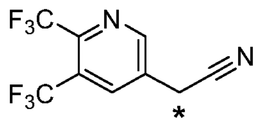 (X88), 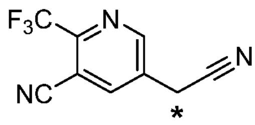 (X89), 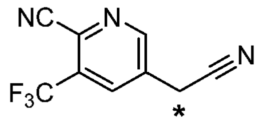 (X90),

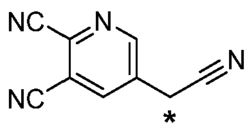 (X91), 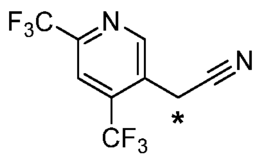 (X92), 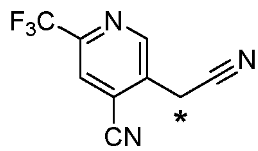 (X93),

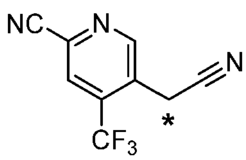 (X94), 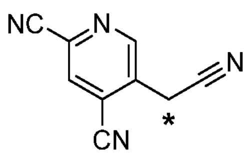 (X95), 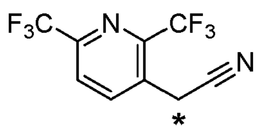 (X96),

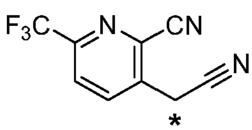 (X97), 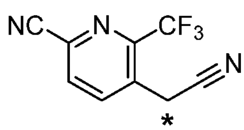 (X98), 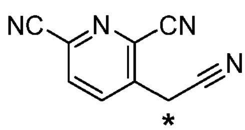 (X99),

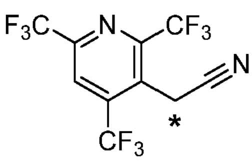 (X100), 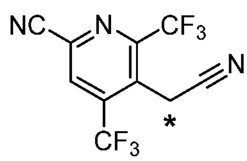 (X101), 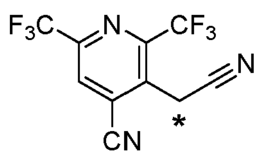 (X102),

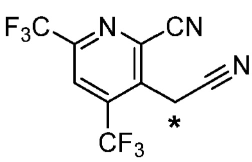 (X103), 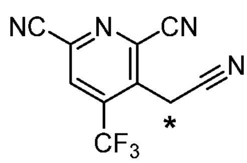 (X104), 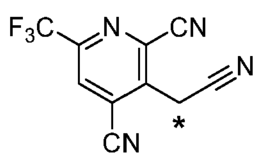 (X105),

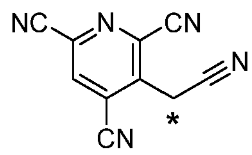 (X106), 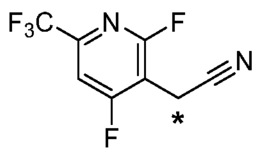 (X107), 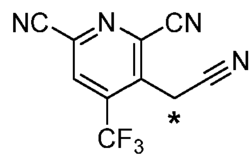 (X108),

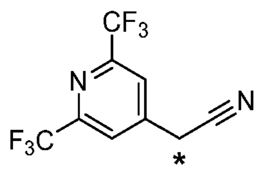 (X109), 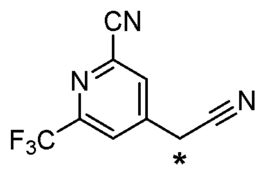 (X110), 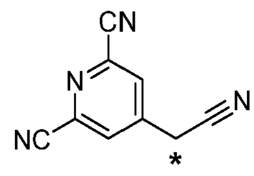 (X111),

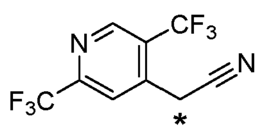 (X112), 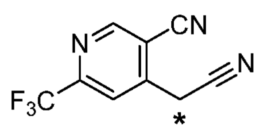 (X113), 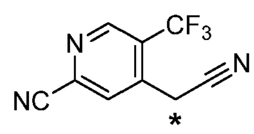 (X114),

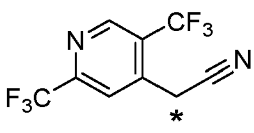 (X115), 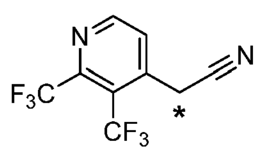 (X116), 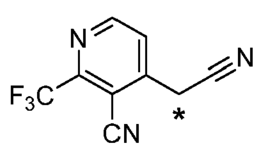 (X117),

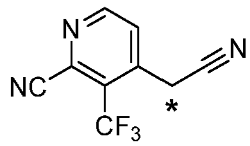 (X118), 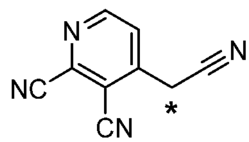 (X119), 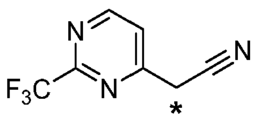 (X120),

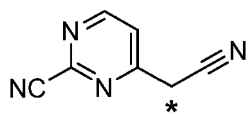 (X121), 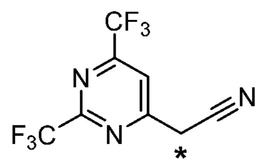 (X122), 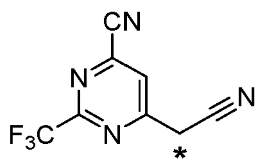 (X123),

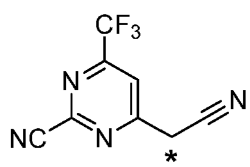 (X124), 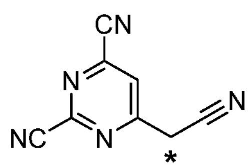 (X125), 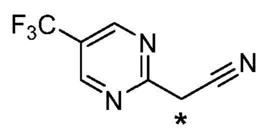 (X126),

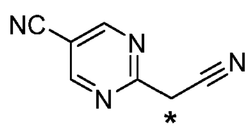 (X127), 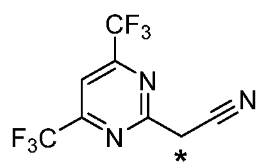 (X128), 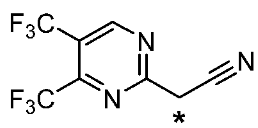 (X129),

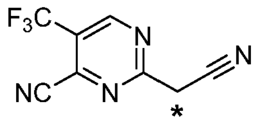 (X130), 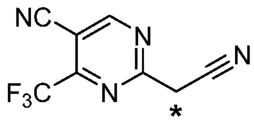 (X131), 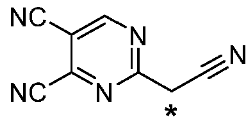 (X132),

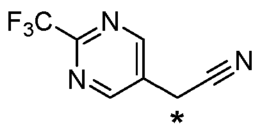 (X133), 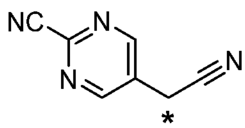 (X134), 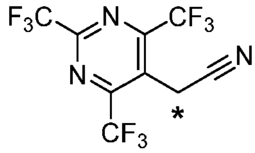 (X135),

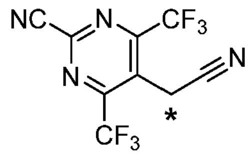 (X136), 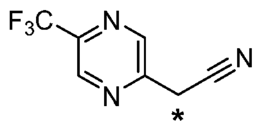 (X137), 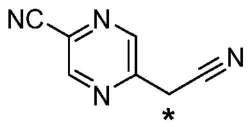 (X138),

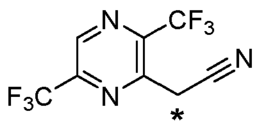 (X139), 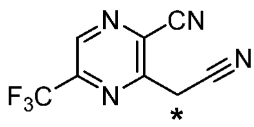 (X140), 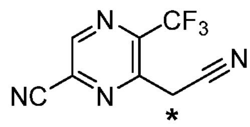 (X141),

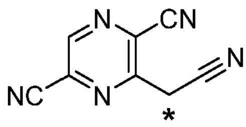 (X142), 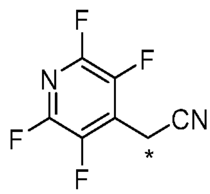 (X143);

wherein the "*" denotes the binding position.

**15.** A display device comprising an organic electroluminescent device according to any of the claims 1 to 14.

**Patentansprüche**

**1.** Organische elektronische Vorrichtung, umfassend eine Anodenschicht, eine Kathodenschicht, eine Lochinjektionsschicht, mindestens zwei lichtemittierende Einheiten und mindestens eine Ladungserzeugungsschicht, wobei mindestens eine Ladungserzeugungsschicht eine Ladungserzeugungsschicht vom p-Typ umfasst;

wobei jede lichtemittierende Einheit mindestens eine lichtemittierende Schicht umfasst,
wobei jede der mindestens einen Ladungserzeugungsschichten unabhängig zwischen einem Satz von zwei benachbarten lichtemittierenden Einheiten der mindestens zwei lichtemittierenden Einheiten angeordnet ist,
wobei sich die Lochinjektionsschicht näher an der Anodenschicht befindet als die Ladungserzeugungsschicht vom p-Typ,
wobei die Ladungserzeugungsschicht vom p-Typ eine erste Lochtransportmatrixverbindung und ein Radialen der Formel (I) umfasst,

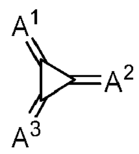

(I),

wobei in Formel (I)

- $A^1$ unabhängig aus einer Gruppe der Formel (Ia) ausgewählt ist:

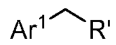

(Ia)

wobei $Ar^1$ unabhängig aus substituiertem oder unsubstituiertem $C_6$- bis $C_{36}$-Aryl und substituiertem oder unsubstituiertem $C_2$- bis $C_{36}$-Heteroaryl ausgewählt ist; wobei für den Fall, dass $Ar^1$ substituiert ist, einer oder mehrere der Substituenten unabhängig aus der Gruppe bestehend aus D, einer elektronenziehenden Gruppe, Halogen, Cl, F, CN, $-NO_2$, substituiertem oder unsubstituiertem $C_1$- bis $C_8$-Alkyl, teilfluoriertem $C_1$- bis $C_8$-Alkyl, perfluoriertem $C_1$- bis $C_8$-Alkyl, substituiertem oder unsubstituiertem $C_1$- bis $C_8$-Alkoxy, teilfluoriertem $C_1$- bis $C_8$-Alkoxy, perfluoriertem $C_1$- bis $C_8$-Alkoxy, substituiertem oder unsubstituiertem $C_6$- bis $C_{30}$-Aryl und substituiertem oder unsubstituiertem $C_6$- bis $C_{30}$-Heteroaryl ausgewählt sind und
wobei der eine oder die mehreren Substituenten von $C_6$-bis $C_{30}$-Aryl, $C_6$- bis $C_{30}$-Heteroaryl, $C_1$- bis $C_8$-Alkyl, $C_1$- bis $C_8$-Alkoxy unabhängig aus D, einer elektronenziehenden Gruppe, Halogen, Cl, F, CN, $-NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;

- $A^2$ unabhängig aus einer Gruppe der Formel (Ib) ausgewählt ist:

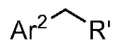

(Ib),

wobei $Ar^2$ unabhängig aus substituiertem oder unsubstituiertem $C_6$- bis $C_{36}$-Aryl und substituiertem oder unsubstituiertem $C_2$- bis $C_{36}$-Heteroaryl ausgewählt ist;
wobei für den Fall, dass $Ar^2$ substituiert ist, einer oder mehrere der Substituenten unabhängig aus der Gruppe bestehend aus D, einer elektronenziehenden Gruppe, Halogen, Cl, F, CN, $NO_2$, substituiertem oder unsubstituiertem $C_1$- bis $C_8$-Alkyl, teilfluoriertem $C_1$- bis $C_8$-Alkyl, perfluoriertem $C_1$- bis $C_8$-Alkyl, substituiertem oder unsubstituiertem $C_1$- bis $C_8$-Alkoxy, teilfluoriertem $C_1$- bis $C_8$-Alkoxy, perfluoriertem $C_1$- bis $C_8$-Alkoxy, substituiertem oder unsubstituiertem $C_6$- bis $C_{30}$-Aryl und substituiertem oder unsubstituiertem $C_6$- bis $C_{30}$-Heteroaryl ausgewählt sind;
wobei der eine oder die mehreren Substituenten von $C_6$-bis $C_{30}$-Aryl, $C_6$- bis $C_{30}$-Heteroaryl, $C_1$- bis $C_8$-Alkyl, $C_1$- bis $C_8$-Alkoxy unabhängig aus D, einer elektronenziehenden Gruppe, Halogen, Cl, F, CN, $-NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;

- $A^3$ unabhängig aus einer Gruppe der Formel (Ic) ausgewählt ist:

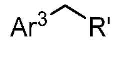

(Ic),

wobei $Ar^3$ unabhängig aus substituiertem oder unsubstituiertem $C_6$- bis $C_{36}$-Aryl und substituiertem oder unsubstituiertem $C_2$- bis $C_{36}$-Heteroaryl ausgewählt ist; wobei für den Fall, dass $Ar^3$ substituiert ist, einer oder mehrere der Substituenten unabhängig aus der Gruppe bestehend aus D, einer elektronenziehenden Gruppe,

Halogen, Cl, F, CN, $-NO_2$, substituiertem oder unsubstituiertem $C_1$- bis $C_8$-Alkyl, teilfluoriertem $C_1$- bis $C_8$-Alkyl, perfluoriertem $C_1$- bis $C_8$-Alkyl, substituiertem oder unsubstituiertem $C_1$- bis $C_8$-Alkoxy, teilfluoriertem $C_1$- bis $C_8$-Alkoxy, perfluoriertem $C_1$- bis $C_8$-Alkoxy, substituiertem oder unsubstituiertem $C_6$- bis $C_{30}$-Aryl und substituiertem oder unsubstituiertem $C_6$- bis $C_{30}$-Heteroaryl ausgewählt sind,

wobei der eine oder die mehreren Substituenten von $C_6$-bis $C_{30}$-Aryl, $C_6$- bis $C_{30}$-Heteroaryl, $C_1$- bis $C_8$-Alkyl, $C_1$- bis $C_8$-Alkoxy unabhängig aus D, einer elektronenziehenden Gruppe, Halogen, Cl, F, CN, $-NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;

und wobei in $A^1$, $A^2$ und $A^3$ jedes R' unabhängig aus substituiertem oder unsubstituiertem $C_6$- bis $C_{18}$-Aryl, substituiertem oder unsubstituiertem $C_3$- bis $C_{18}$-Heteroaryl, einer elektronenziehenden Gruppe, substituiertem oder unsubstituiertem $C_1$- bis $C_8$-Alkyl, teilfluoriertem $C_1$- bis $C_8$-Alkyl, perfluoriertem $C_1$- bis $C_8$-Alkyl, Halogen, F und CN ausgewählt ist;

wobei der eine oder die mehreren Substituenten von $C_6$-bis $C_{18}$-Aryl, $C_6$- bis $C_{18}$-Heteroaryl, $C_1$- bis $C_8$-Alkyl unabhängig aus D, einer elektronenziehenden Gruppe, Halogen, Cl, F, CN, $-NO_2$, teilfluoriertem $C_1$- bis $C_6$-Alkyl, perfluoriertem $C_1$- bis $C_6$-Alkyl, teilfluoriertem $C_1$- bis $C_6$-Alkoxy, perfluoriertem $C_1$- bis $C_6$-Alkoxy ausgewählt sind;

**dadurch gekennzeichnet, dass**

die Lochinjektionsschicht eine zweite Lochtransportmatrixverbindung und eine Verbindung der Formel (II) umfasst, wobei es sich bei der Verbindung der Formel (II) um eine chinoide Verbindung handelt, wobei der Begriff "chinoide Verbindung" eine Verbindung bedeutet und einschließt, die eine Gruppierung enthält, die sich (formal) von einer Verbindung mit einem anellierten aromatischen System oder nicht anellierten aromatischen System ableitet, wobei eine gerade Zahl von Kohlenstoffatomen des anellierten aromatischen Systems oder nicht anellierten aromatischen Systems mit jeglicher notwendiger Umlagerung von Doppelbindungen doppelt an ein Atom oder eine Gruppe außerhalb des anellierten aromatischen Systems oder nicht anellierten aromatischen Systems gebunden ist, und wobei die Verbindung der Formel (II) mindestens einen substituierten oder unsubstituierten Arylsubstituenten oder mindestens einen substituierten oder unsubstituierten Heteroarylsubstituenten, vorzugsweise einen substituierten Arylsubstituenten oder substituierten Heteroarylsubstituenten, weiter bevorzugt ein substituiertes $C_6$- bis $C_{30}$-Aryl oder substituiertes $C_3$-bis $C_{30}$-Heteroaryl und weiter bevorzugt ein substituiertes Phenyl oder substituiertes $C_3$- bis $C_5$-Heteroaryl enthält und wobei $C_3$- bis $C_5$-Heteroaryl vorzugsweise ein sechsgliedriger heteroaromatischer Ring ist.

2. Organische Elektrolumineszenzvorrichtung nach Anspruch 1, wobei in der Verbindung der Formel (II) die notwendige Umlagerung von Doppelbindungen zu einer zumindest teilweisen Aufhebung der Aromatizität in dem anellierten aromatischen System oder nicht anellierten aromatischen System führt.

3. Organische Elektrolumineszenzvorrichtung nach Anspruch 1 oder 2, wobei es sich bei der Verbindung der Formel (II) um eine Verbindung der Formel (IIa) handelt:

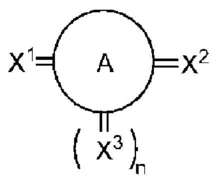

(IIa)

wobei n für eine gerade ganze Zahl einschließlich 0 steht,

wobei $X^1$, $X^2$ und $X^3$ unabhängig aus O, S, $CR^1aR^2a$, $CR^{1b}R^{2b}$, $NR^{3a}$, $NR^{3b}$ ausgewählt sind;

wobei $R^{1a}$, $R^{2a}$, $R^{1b}$ und $R^{2b}$ unabhängig aus Halogen, Cl, F, teilfluoriertem $C_1$- bis $C_6$-Alkyl, perfluoriertem $C_1$- bis $C_6$-Alkyl, $CF_3$, teilfluoriertem $C_1$- bis $C_6$-Alkoxy, perfluoriertem $C_1$- bis $C_6$-Alkoxy, $OCF_3$, CN, Isocyano, SCN, OCN, $NO_2$, $NO_2$, $SF_5$, substituiertem oder unsubstituiertem $C_6$- bis $C_{30}$-Aryl, substituiertem oder unsubstituiertem $C_3$-bis $C_{30}$-Heteroaryl ausgewählt sind,

wobei der eine oder die mehreren Substituenten unabhängig aus D, Halogen, Cl, F, teilfluoriertem $C_1$- bis $C_6$-Alkyl, perfluoriertem $C_1$- bis $C_6$-Alkyl, $CF_3$, teilfluoriertem $C_1$-bis $C_6$-Alkoxy, perfluoriertem $C_1$- bis $C_6$-Alkoxy, $OCF_3$, CN, Isocyano, SCN, OCN, $NO_2$, $SF_5$ ausgewählt sind;

wobei $R^{3a}$ und $R^{3b}$ aus CN, teilfluoriertem $C_1$- bis $C_6$-Alkyl, perfluoriertem $C_1$- bis $C_6$-Alkyl, $CF_3$, substituiertem oder unsubstituiertem $C_6$- bis $C_{30}$-Aryl oder substituiertem oder unsubstituiertem $C_3$- bis $C_{30}$-Heteroaryl ausgewählt sind, wobei der eine oder die mehreren Substituenten unabhängig aus D, Halogen, Cl, F, teilfluoriertem $C_1$- bis $C_6$-Alkyl, perfluoriertem $C_1$- bis $C_6$-Alkyl, $CF_3$, teilfluoriertem $C_1$-bis $C_6$-Alkoxy, perfluoriertem $C_1$- bis

$C_6$-Alkoxy, $OCF_3$, CN, Isocyano, SCN, OCN, $NO_2$, $SF_5$ ausgewählt sind, wobei Ring A ausgewählt ist aus

| | | |
|---|---|---|
| 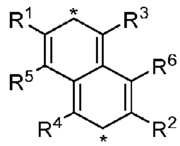 | 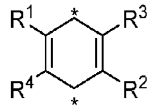 | 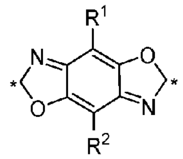 |
| 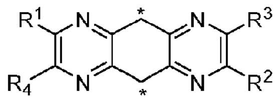 | 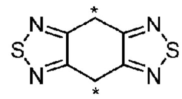 | 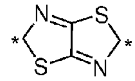 |
| 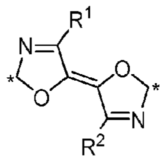 | 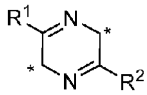 | |
| 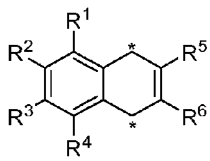 | 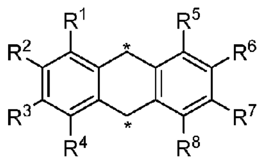 | 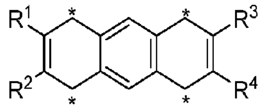 |
| 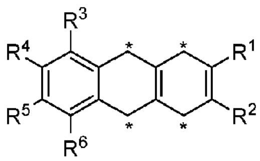 | 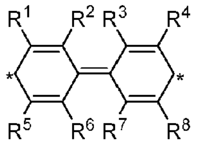 | 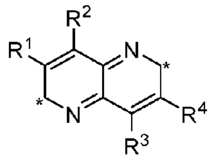 |
| 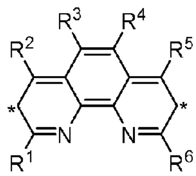 | 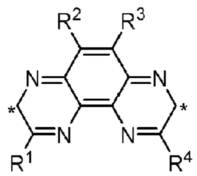 | 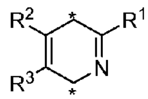 |
| 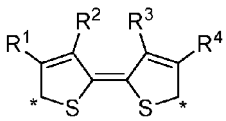 | 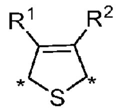 | 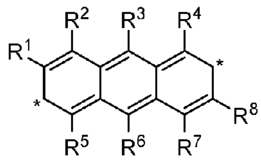 |

| | | |
|---|---|---|
| 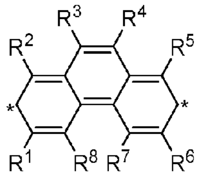 | 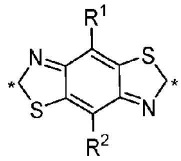 | 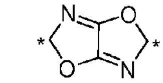 |
| 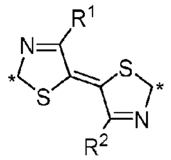 | 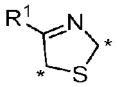 | 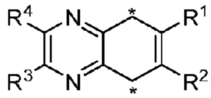 |
| 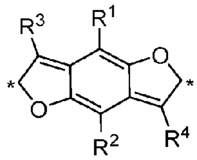 | 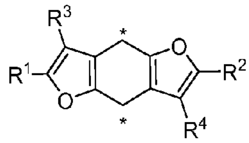 | 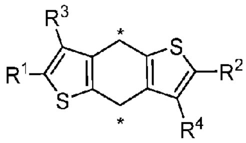 |
| 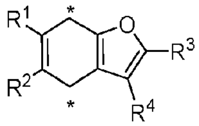 | 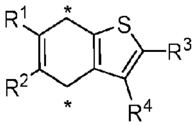 | 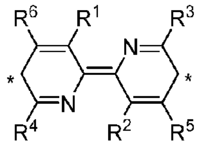 |
| 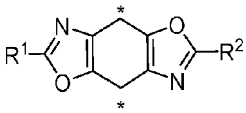 | 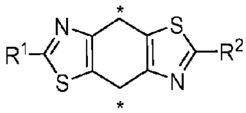 | 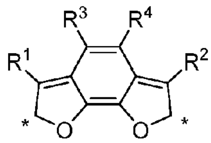 |
| 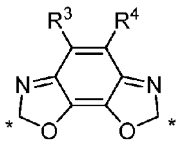 | 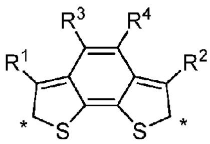 | 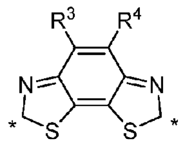 |
| 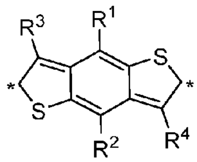 | 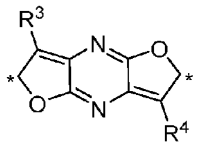 | 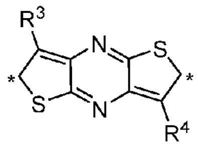 |
| 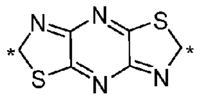 | 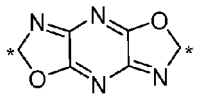 | 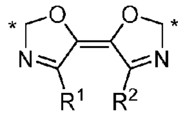 |
| 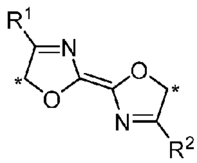 | 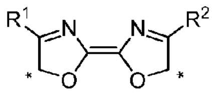 | 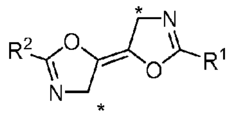 |

| | | |
|---|---|---|
| 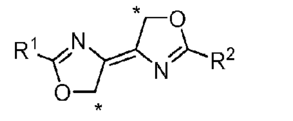 | 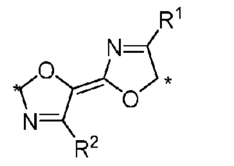 | 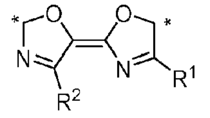 |
| 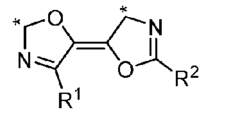 | 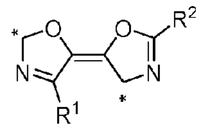 | 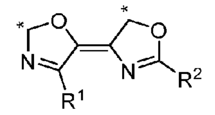 |
| 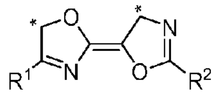 | 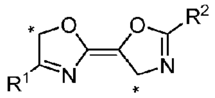 | 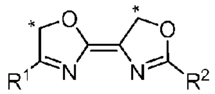 |
| 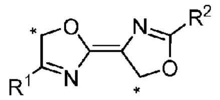 | 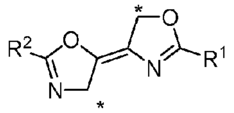 | 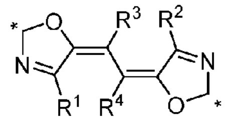 |
| 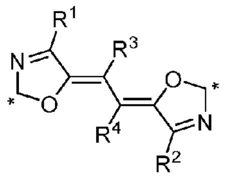 | 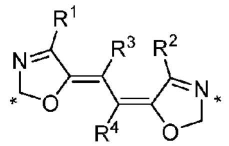 | 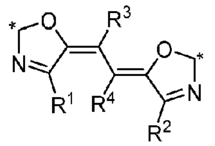 |
| 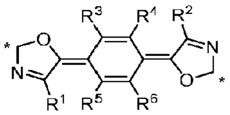 | 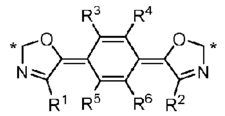 | 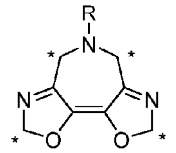 |

wobei das Sternchen "*" die Bindungsposition bezeichnet; wobei $R^1$, $R^2$, $R^3$, $R^4$, $R^5$, $R^6$, $R^7$ und $R^8$ unabhängig aus D, Halogen, Cl, F, substituiertem oder unsubstituiertem $C_1$-bis $C_6$-Alkyl, teilfluoriertem $C_1$- bis $C_6$-Alkyl, perfluoriertem $C_1$- bis $C_6$-Alkyl, $CF_3$, substituiertem oder unsubstituiertem $C_1$- bis $C_6$-Alkoxy, teilfluoriertem $C_1$- bis $C_6$-Alkoxy, perfluoriertem $C_1$- bis $C_6$-Alkoxy, $OCF_3$, substituiertem oder unsubstituiertem $C_6$- bis $C_{30}$-Aryloxy, teilfluoriertem $C_6$- bis $C_{30}$-Aryloxy, perfluoriertem $C_6$-bis $C_{30}$-Aryloxy, substituiertem oder unsubstituiertem $C_6$- bis $C_{30}$-Aryl, substituiertem oder unsubstituiertem $C_3$- bis $C_{30}$-Heteroaryl, CN, Isocyano, SCN, OCN, $NO_2$, $SF_5$ ausgewählt sind,
wobei der eine oder die mehreren Substituenten aus D, Halogen, Cl, F, teilfluoriertem $C_1$- bis $C_6$-Alkyl, perfluoriertem $C_1$- bis $C_6$-Alkyl, $CF_3$, teilfluoriertem $C_1$-bis $C_6$-Alkoxy, perfluoriertem $C_1$- bis $C_6$-Alkoxy, $OCF_3$, CN, Isocyano, SCN, OCN, $NO_2$, $SF_5$ ausgewählt sind; und
wobei mindestens eines von $R^{1a}$, $R^{2a}$, $R^{1b}$, $R^{2b}$, $R^{3a}$, $R^{3b}$, $R^1$, $R^2$, $R^3$, $R^4$, $R^5$, $R^6$, $R^7$ und $R^8$ unabhängig aus einem substituierten oder unsubstituierten $C_6$- bis $C_{30}$-Aryl oder substituierten oder unsubstituierten $C_3$- bis $C_{30}$-Heteroaryl, vorzugsweise einem substituierten $C_6$- bis $C_{30}$-Aryl oder substituierten $C_3$- bis $C_{30}$-Heteroaryl und weiter bevorzugt einem substituierten Phenyl oder substituierten $C_3$- bis $C_5$-Heteroaryl ausgewählt ist und wobei $C_3$- bis $C_5$-Heteroaryl vorzugsweise ein sechsgliedriger heteroaromatischer Ring ist.

**4.** Organische Elektrolumineszenzvorrichtung nach einem der Ansprüche 1 oder 3, wobei die mindestens eine Ladungserzeugungsschicht ferner eine Ladungserzeugungsschicht vom n-Typ umfasst.

**5.** Organische Elektrolumineszenzvorrichtung nach einem der Ansprüche 1 bis 4, wobei in Formel (I) R' aus CN ausgewählt ist.

**6.** Organische Elektrolumineszenzvorrichtung nach einem der Ansprüche 1 bis 5, wobei die Verbindung der Formel (I) bei Berechnung mit dem Programmpaket TURBOMOLE V6.5 (TURBOMOLE GmbH, Litzenhardtstraße 19, 76135 Karlsruhe, Deutschland) durch Anwenden des Hybridfunktionals B3LYP mit einem 6-31G*-Basissatz in der Gasphase ein berechnetes LUMO-Energieniveau ≤ -4,60 eV; vorzugsweise ≤ -4,75 eV; weiter bevorzugt ≤ -5,00 eV; noch weiter bevorzugt ≤ -5,10 eV; noch weiter bevorzugt ≤ -5,15 eV; noch weiter bevorzugt ≤ -5,19 eV, noch weiter bevorzugt ≤ -5,20 eV und noch weiter bevorzugt ≤ -5,22 eV aufweist.

**7.** Organische Elektrolumineszenzvorrichtung nach einem der Ansprüche 1 bis 6, wobei in Formel (I) $Ar^1$, $Ar^2$ und $Ar^3$ unabhängig aus einer der folgenden Gruppen ausgewählt sind:

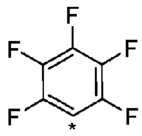 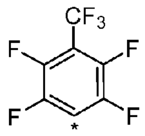 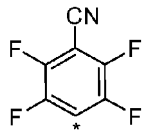 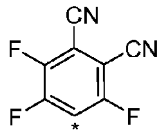 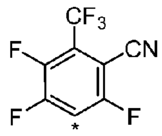

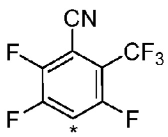 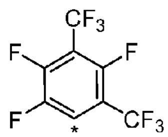 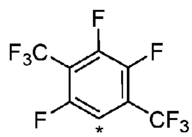 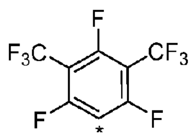 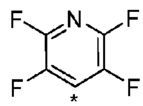

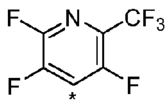 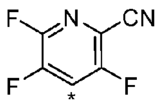 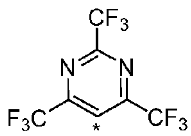 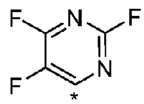 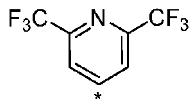

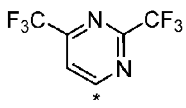 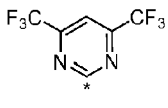 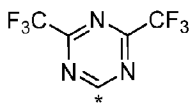 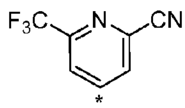 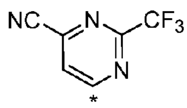

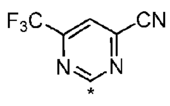 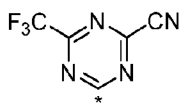 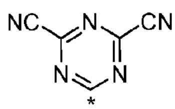 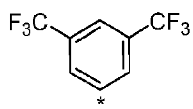 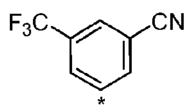

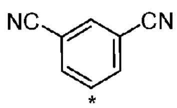 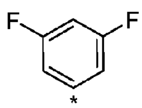 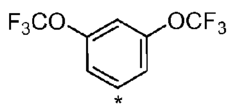 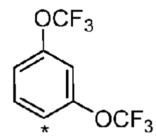 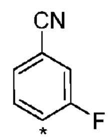

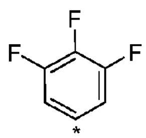 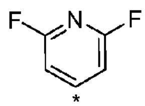 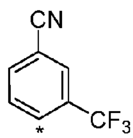 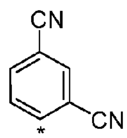 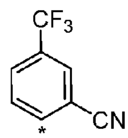

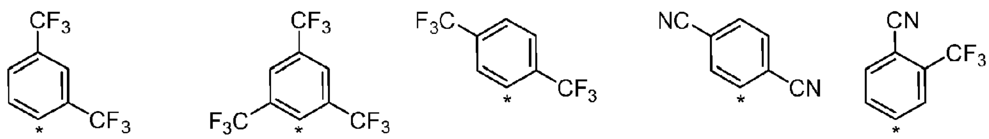

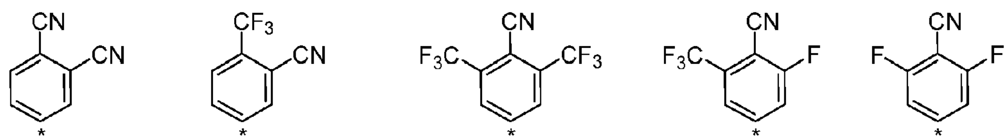

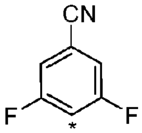
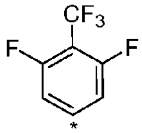
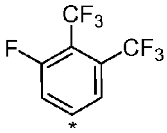
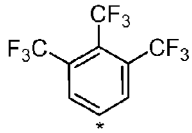
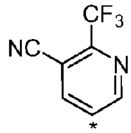

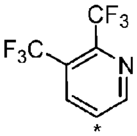
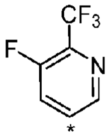
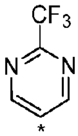
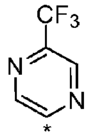
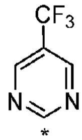

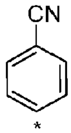
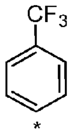
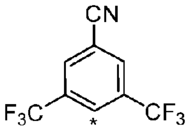
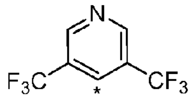
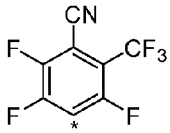

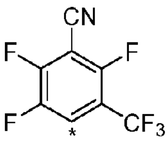
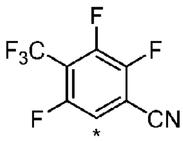
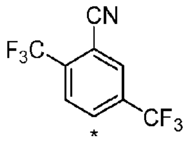

wobei das Sternchen "*" die Bindungsposition bezeichnet.

**8.** Organische Elektrolumineszenzvorrichtung nach einem der Ansprüche 1 bis 7, wobei die Verbindung der Formel (II) ein Molekulargewicht ≥340 g/mol aufweist.

**9.** Organische Elektrolumineszenzvorrichtung nach einem der Ansprüche 1 bis 8, wobei die Verbindung der Formel (II) bei Berechnung mit dem Programmpaket TURBOMOLE V6.5 (TURBOMOLE GmbH, Litzenhardtstraße 19, 76135 Karlsruhe, Deutschland) durch Anwenden des Hybridfunktionals B3LYP mit einem 6-31G*-Basissatz in der Gasphase ein berechnetes LUMO-Energieniveau von ≥ -5,75 eV aufweist.

**10.** Organische Elektrolumineszenzvorrichtung nach einem der Ansprüche 3 bis 9, wobei in der Verbindung der Formel (IIa) Ring A ausgewählt ist aus:

| | | |
|---|---|---|
| 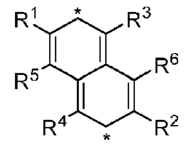 | 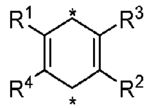 | 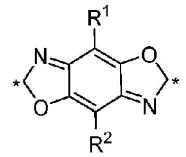 |
| 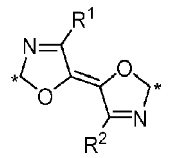 | 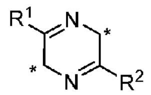 | |
| 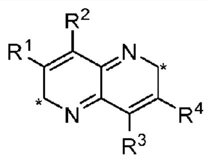 | 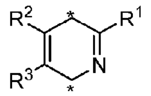 | 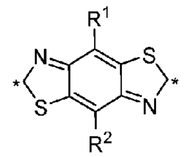 |
| 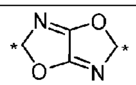 | 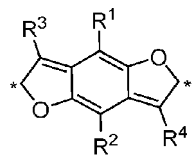 | 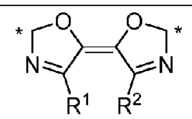 |
| 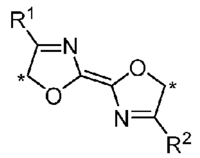 | 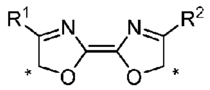 | 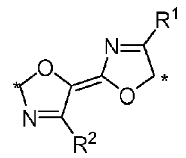 |

| | | |
|---|---|---|
| 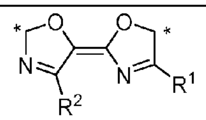 | | |

wobei das Sternchen "*" die Bindungsposition bezeichnet.

**11.** Organische Elektrolumineszenzvorrichtung nach einem der Ansprüche 3 bis 10, wobei in Formel (IIa) der mindestens eine Arylsubstituent bzw. der mindestens eine Heteroarylsubstituent ausgewählt ist aus

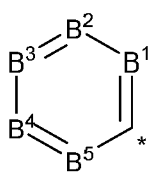
(XXXx)

$B^1$ aus $CL^1$ oder N ausgewählt ist;
$B^2$ aus $CL^2$ oder N ausgewählt ist;
$B^3$ aus $CL^3$ oder N ausgewählt ist;
$B^4$ aus $CL^4$ oder N ausgewählt ist;
$B^5$ aus $CL^5$ oder N ausgewählt ist;
$L^1$, $L^2$, $L^3$, $L^4$ und $L^5$ unabhängig aus CN, Isocyano, SCN, OCN, $NO_2$, $SF_5$, teilfluoriertem $C_1$- bis $C_6$-Alkyl,

perfluoriertem $C_1$- bis $C_6$-Alkyl, $CF_3$, teilfluoriertem $C_1$-bis $C_6$-Alkoxy, perfluoriertem $C_1$- bis $C_6$-Alkoxy, $OCF_3$, Halogen, Cl, F, D oder H ausgewählt sind; wobei das Sternchen "*" die Bindungsposition bezeichnet.

**12.** Organische Elektrolumineszenzvorrichtung nach einem der Ansprüche 3 bis 11, wobei in Formel (IIa) der mindestens eine Arylsubstituent bzw. der mindestens eine Heteroarylsubstituent ausgewählt ist aus

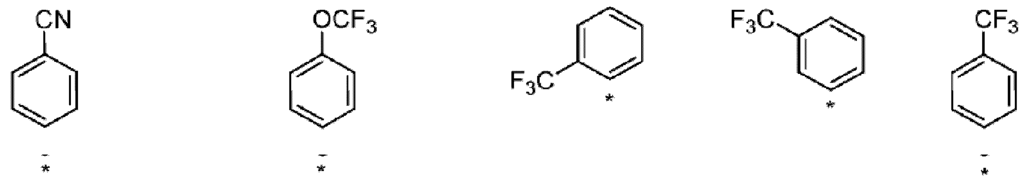

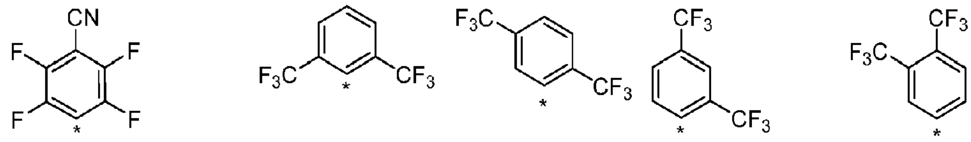

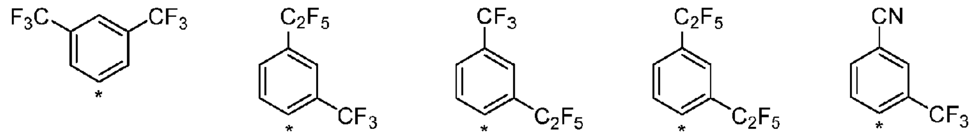

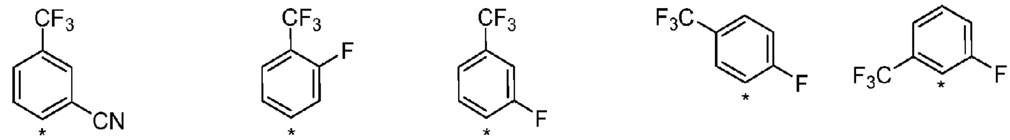

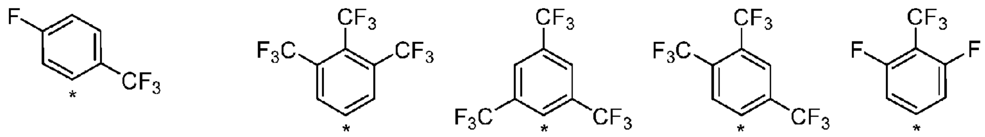

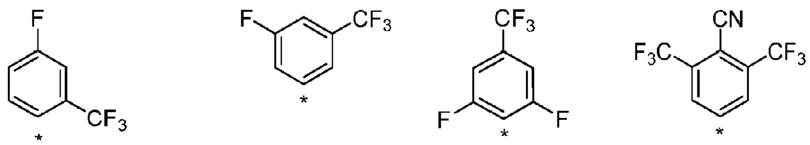

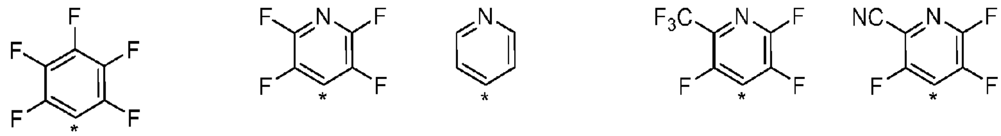

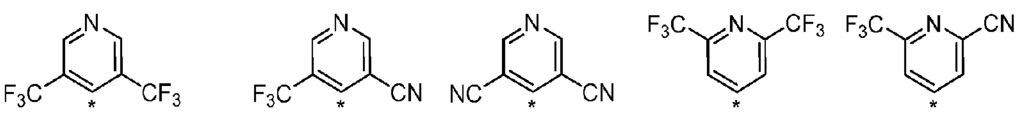

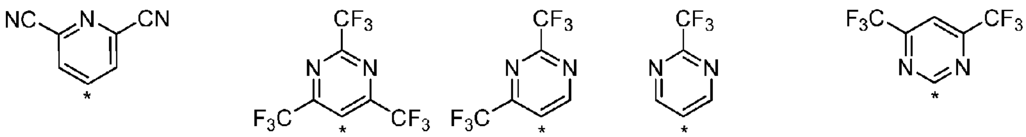

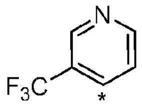

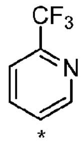

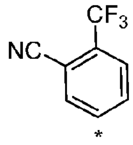

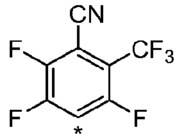

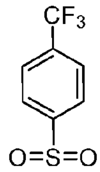

wobei das Sternchen "*" die Bindungsposition bezeichnet.

**13.** Organische Elektrolumineszenzvorrichtung nach einem der Ansprüche 3 bis 12, wobei in Formel (IIa) $X^1$ ausgewählt ist aus

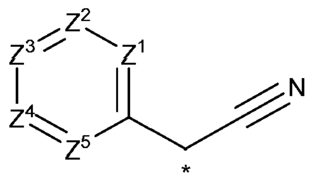

(XXa)

wobei

$Z^1$ aus $CY^1$ oder N ausgewählt ist;
$Z^2$ aus $CY^2$ oder N ausgewählt ist;
$Z^3$ aus $CY^3$ oder N ausgewählt ist;
$Z^4$ aus $CY^4$ oder N ausgewählt ist;
$Z^5$ aus $CY^5$ oder N ausgewählt ist;
wobei
$Y^1$, $Y^2$, $Y^3$, $Y^4$ und $Y^5$ unabhängig aus CN, Isocyano, SCN, OCN, $NO_2$, $SF_5$, teilfluoriertem $C_1$- bis $C_6$-Alkyl, perfluoriertem $C_1$- bis $C_6$-Alkyl, $CF_3$, teilfluoriertem $C_1$-bis $C_6$-Alkoxy, perfluoriertem $C_1$- bis $C_6$-Alkoxy, $OCF_3$, Halogen, Cl, F, D oder H ausgewählt sind, wobei das Sternchen "*" die Bindungsposition bezeichnet.

**14.** Organische Elektrolumineszenzvorrichtung nach einem der Ansprüche 3 bis 12, wobei in Formel (IIa) $X^1$ und/oder $X^2$ unabhängig ausgewählt sind aus:

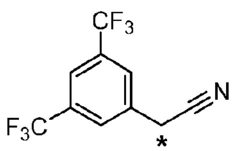
(X1),

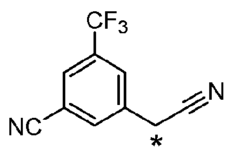
(X2),

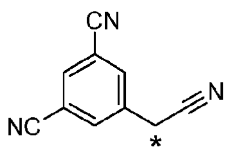
(X3),

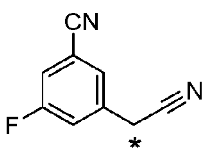
(X4),

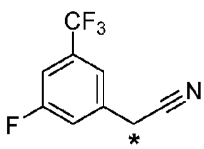
(X5),

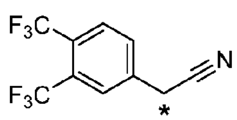
(X6),

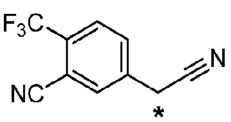
(X7),

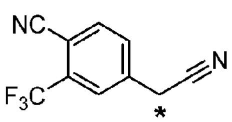
(X8),

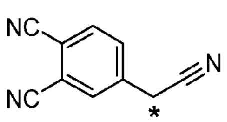
(X9),

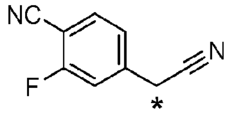 (X10), 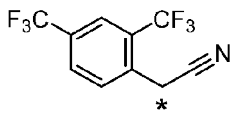 (X11), 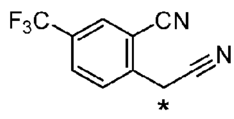 (X12),

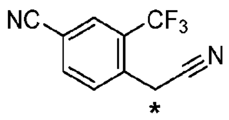 (X13), 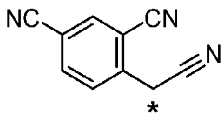 (X14), 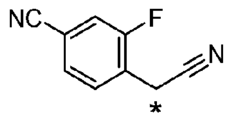 (X15),

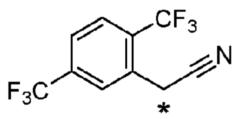 (X16), 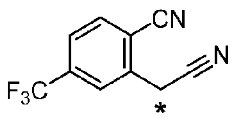 (X17), 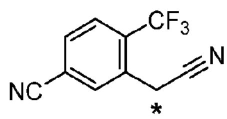 (X18),

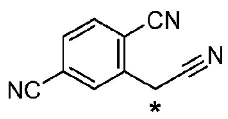 (X19), 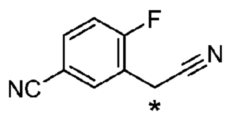 (X20), 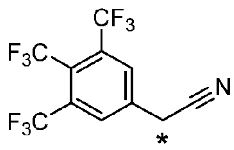 (X21),

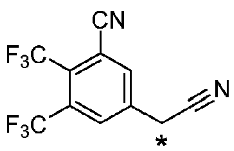 (X22), 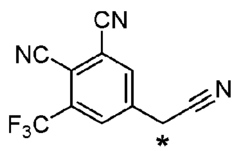 (X23), 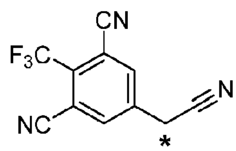 (X24),

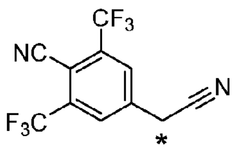 (X25), 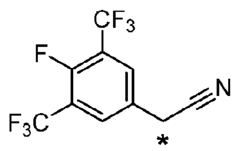 (X26), 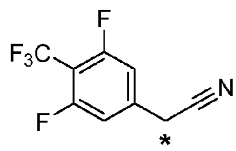 (X27),

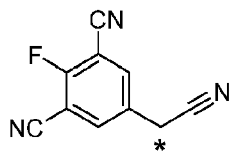 (X28), 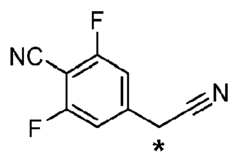 (X29), 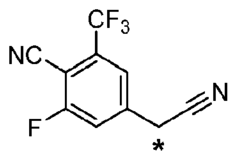 (X30),

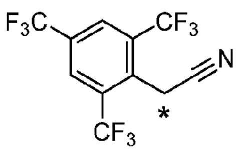 (X31), 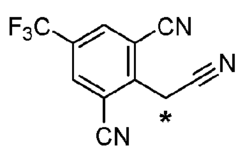 (X32), 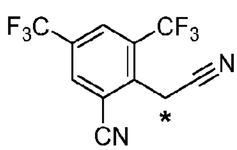 (X33),

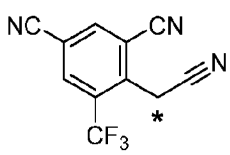 (X34), 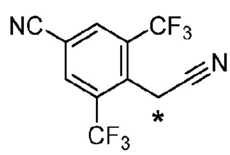 (X35), 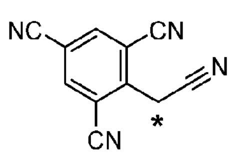 (X36),

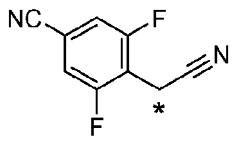 (X37), 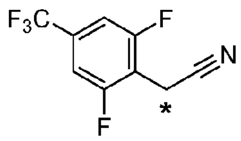 (X38), 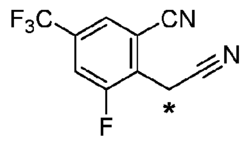 (X39),

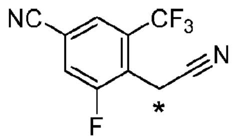 (X40), 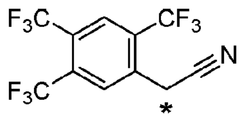 (X41), 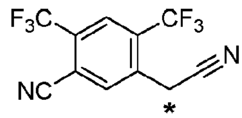 (X42),

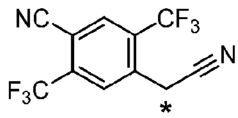 (X43), 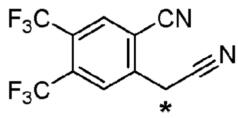 (X44), 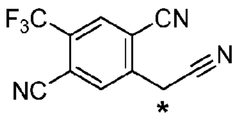 (X45),

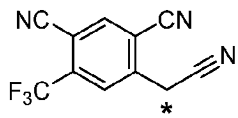 (X46), 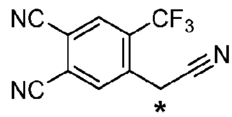 (X47), 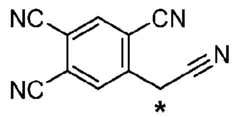 (X48),

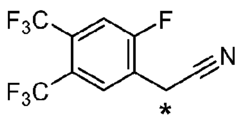 (X49), 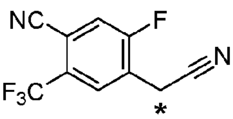 (X50), 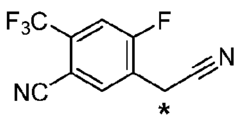 (X51),

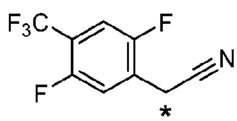 (X52), 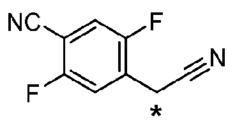 (X53), 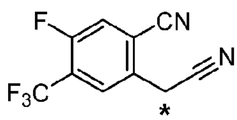 (X54),

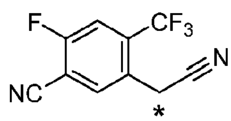 (X55), 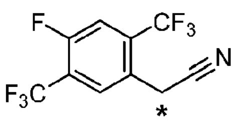 (X56), 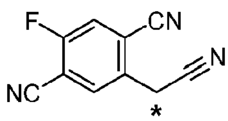 (X57),

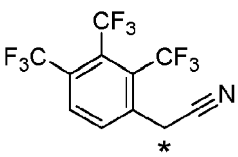 (X58), 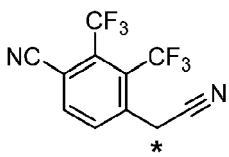 (X59), 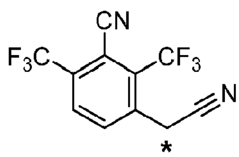 (X60),

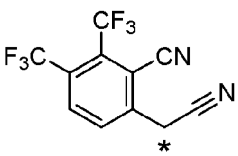 (X61), 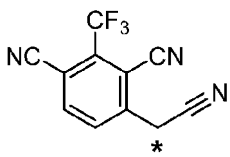 (X62), 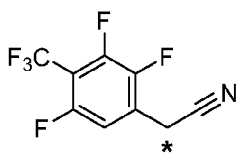 (X63),

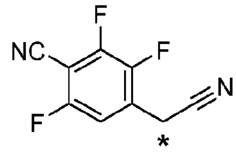 (X64), 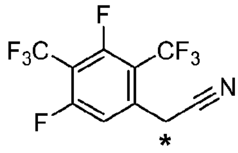 (X65), 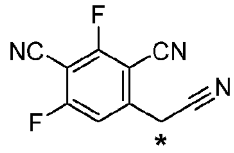 (X66),

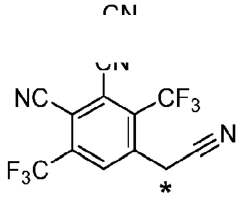 (X67), 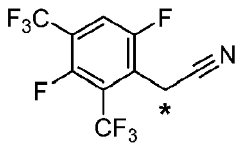 (X68), 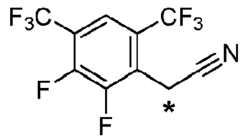 (X69),

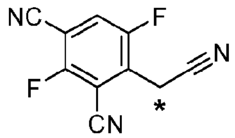 (X70), 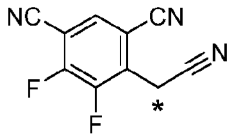 (X71), 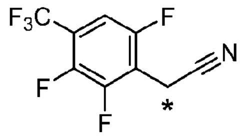 (X72),

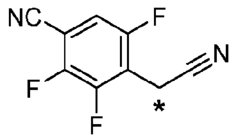 (X73), 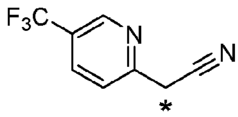 (X74), 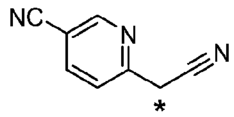 (X75),

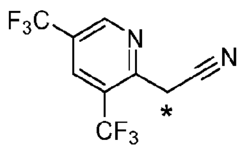 (X76), 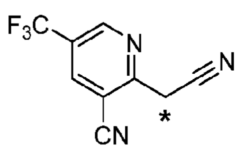 (X77), 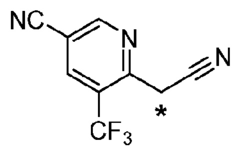 (X78),

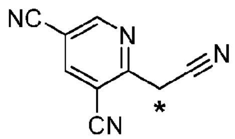 (X79), 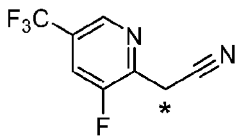 (X80), 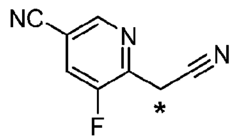 (X81),

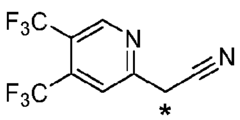 (X82), 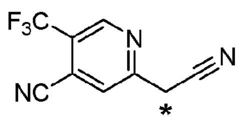 (X83), 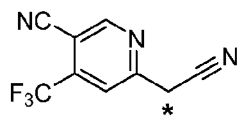 (X84),

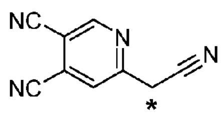 (X85), 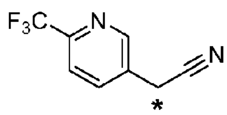 (X86), 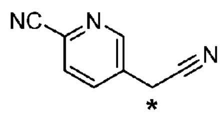 (X87),

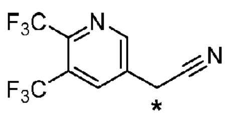 (X88), 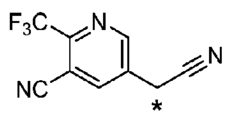 (X89), 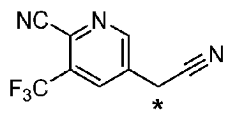 (X90),

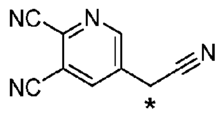 (X91), 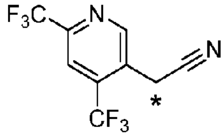 (X92), 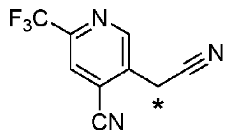 (X93),

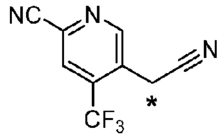 (X94), 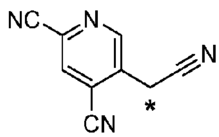 (X95), 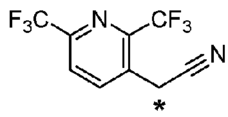 (X96),

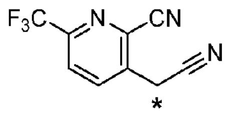 (X97), 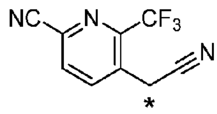 (X98), 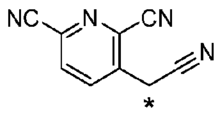 (X99),

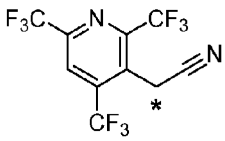 (X100), 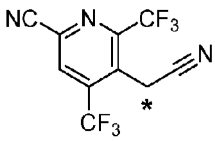 (X101), 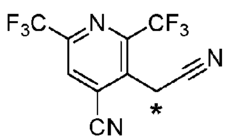 (X102),

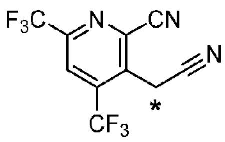 (X103), 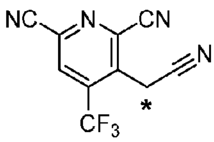 (X104), 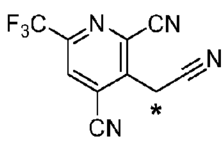 (X105),

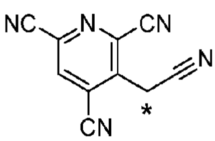 (X106), 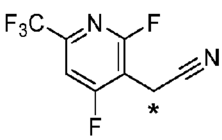 (X107), 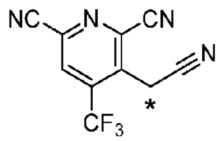 (X108),

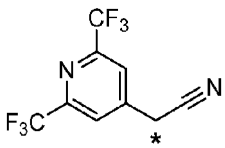 (X109), 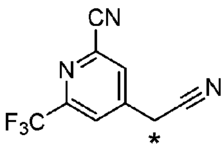 (X110), 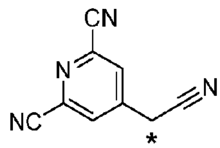 (X111),

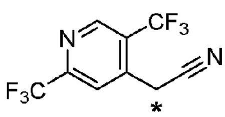 (X112), 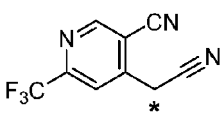 (X113), 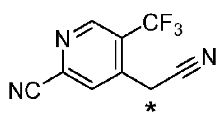 (X114),

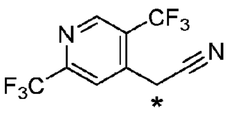 (X115), 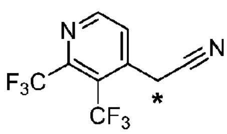 (X116), 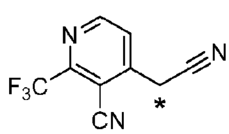 (X117),

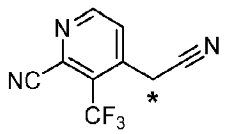 (X118), 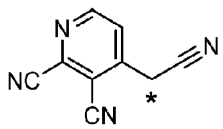 (X119), 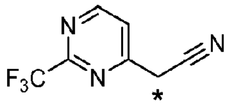 (X120),

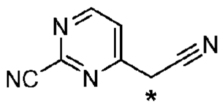 (X121), 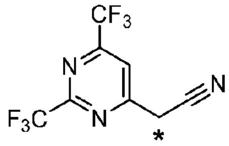 (X122), 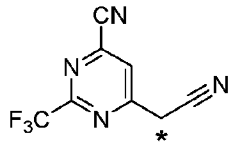 (X123),

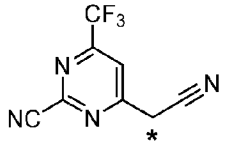 (X124), 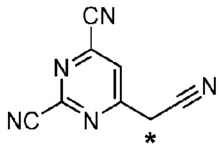 (X125), 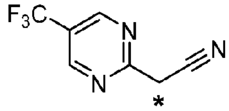 (X126),

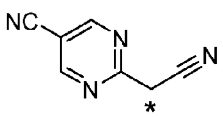 (X127), 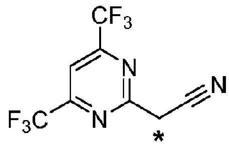 (X128), 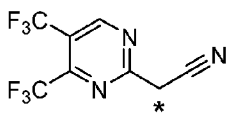 (X129),

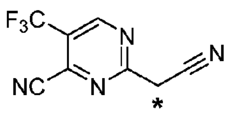 (X130), 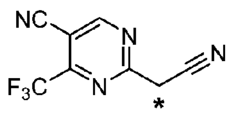 (X131), 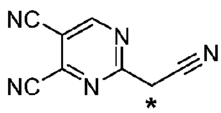 (X132),

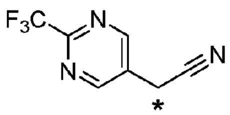 (X133), 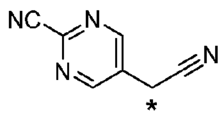 (X134), 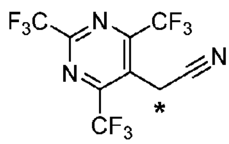 (X135),

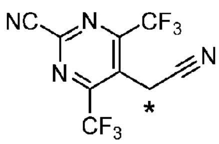 (X136), 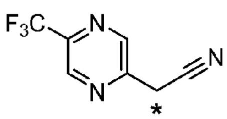 (X137), 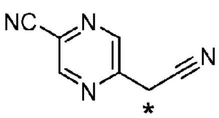 (X138),

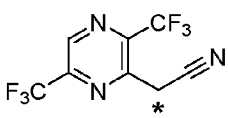 (X139), 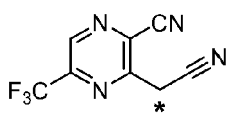 (X140), 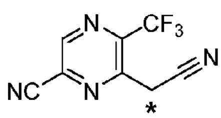 (X141),

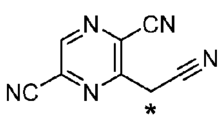 (X142), 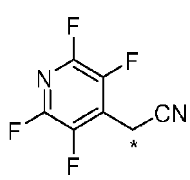 (X143);

wobei das "*" die Bindungsposition bezeichnet.

**15.** Anzeigevorrichtung, umfassend eine Elektrolumineszenzvorrichtung gemäß einem der Ansprüche 1 bis 14.

## Revendications

**1.** Dispositif électronique organique comprenant une couche d'anode, une couche de cathode, une couche d'injection de trous, au moins deux unités émettrices de lumière, et au moins une couche de génération de charge, au moins une couche de génération de charge comprenant une couche de génération de charge de type p ;

chaque unité émettrice de lumière comprenant au moins une couche émettrice de lumière,
chacune parmi la ou les couches de génération de charge étant disposée indépendamment entre un ensemble de deux unités émettrices de lumière adjacentes des au moins deux unités émettrices de lumière ;
la couche d'injection de trous étant plus proche de la couche d'anode que la couche de génération de charge de type p ;
la couche de génération de charge de type p comprenant un premier composé de matrice de transport de trous et un radialène de formule (I),

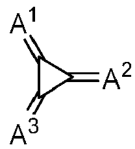

(I),

dans la formule (I)

- $A^1$ étant indépendamment choisi parmi un groupe de formule (Ia) :

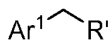

(Ia)

$Ar^1$ étant indépendamment choisi parmi $C_6$ à $C_{36}$ aryle substitué ou non substitué, et $C_2$ à $C_{36}$ hétéroaryle substitué ou non substitué ;
dans le cas où $Ar^1$ est substitué, un ou plusieurs des substituants étant indépendamment choisis dans le groupe constitué par D, un groupe électroattracteur, halogène, Cl, F, CN, $-NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$ alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué et ;
le ou les substituants de $C_6$ à $C_{30}$ aryle, $C_6$ à $C_{30}$ hétéroaryle, $C_1$ à $C_8$ alkyle, $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;

- $A^2$ étant indépendamment choisi parmi un groupe de formule (Ib)

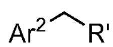

(Ib),

$Ar^2$ étant indépendamment choisi parmi $C_6$ à $C_{36}$ aryle substitué ou non substitué, et $C_2$ à $C_{36}$ hétéroaryle substitué ou non substitué ;
dans le cas où $Ar^2$ est substitué, un ou plusieurs des substituants étant indépendamment choisis dans le groupe constitué par D, un groupe électroattracteur, halogène, Cl, F, CN, $NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$

alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué ; le ou les substituants de $C_6$ à $C_{30}$ aryle, $C_6$ à $C_{30}$ hétéroaryle, $C_1$ à $C_8$ alkyle, $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;

- $A^3$ étant indépendamment choisi parmi un groupe de formule (Ic)

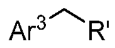

(Ic),

$Ar^3$ étant indépendamment choisi parmi $C_6$ à $C_{36}$ aryle substitué ou non substitué, et $C_2$ à $C_{36}$ hétéroaryle substitué ou non substitué ; dans le cas où $Ar^3$ est substitué, un ou plusieurs des substituants étant indépendamment choisis dans le groupe constitué par D, un groupe électroattracteur, halogène, Cl, F, CN, $NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$ alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué, le ou les substituants de $C_6$ à $C_{30}$ aryle, $C_6$ à $C_{30}$ hétéroaryle, $C_1$ à $C_8$ alkyle, $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ; et dans $A^1$, $A^2$, et $A^3$, chaque R' étant indépendamment choisi parmi $C_6$ à $C_{18}$ aryle substitué ou non substitué, $C_3$ à $C_{18}$ hétéroaryle substitué ou non substitué, un groupe électroattracteur, $C_1$ à $C_8$ alkyle substitué ou non substitué, $C_1$ à $C_8$ alkyle partiellement fluoré, $C_1$ à $C_8$ alkyle perfluoré, halogène, F et CN ; le ou les substituants de $C_6$ à $C_{18}$ aryle, $C_6$ à $C_{18}$ hétéroaryle, $C_1$ à $C_8$ alkyle, étant indépendamment choisis parmi D, un groupe électroattracteur, halogène, Cl, F, CN, $-NO_2$, $C_1$ à $C_6$ alkyle partiellement fluoré, $C_1$ à $C_6$ alkyle perfluoré, $C_1$ à $C_6$ alcoxy partiellement fluoré, $C_1$ à $C_6$ alcoxy perfluoré ;

**caractérisé en ce que**

la couche d'injection de trous comprend un second composé de matrice de transport de trous et un composé de formule (II), le composé de formule (II) étant un composé de quinoïde, le terme « composé de quinoïde » signifiant et/ou comprenant un composé qui contient un groupement qui est dérivé (formellement) d'un composé comprenant un système aromatique annelé ou un système aromatique non annelé, un nombre pair d'atomes de carbone dudit système aromatique annelé ou dudit système aromatique non annelé étant lié de manière double à un atome ou à un groupe extérieur audit système aromatique annelé ou audit système aromatique non annelé avec tout réarrangement nécessaire de liaisons doubles, et le composé de formule (II) contenant au moins un substituant aryle substitué ou non substitué ou au moins un substituant hétéroaryle substitué ou non substitué ; de préférence, un substituant aryle substitué ou un substituant hétéroaryle substitué, plus préférablement $C_6$ à $C_{30}$ aryle substitué ou $C_3$ à $C_{30}$ hétéroaryle substitué préférablement, et plus préférablement phényle substitué ou $C_3$ à $C_5$ hétéroaryle substitué et préférablement $C_3$ à $C_5$ hétéroaryle étant un cycle hétéroaromatique à six chaînons.

2. Dispositif électroluminescent organique selon la revendication 1, dans lequel, dans le composé de formule (II), le réarrangement nécessaire de doubles liaisons entraîne au moins une levée partielle de l'aromaticité dans le système aromatique annelé ou le système aromatique non annelé.

3. Dispositif électroluminescent organique selon la revendication 1 ou 2, dans lequel le composé de formule (II) est un composé selon la formule (IIa) :

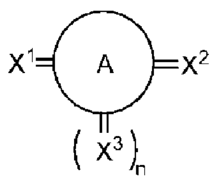

(IIa)

n étant un entier pair y compris 0,

$X^1$, $X^2$, et $X^3$ étant indépendamment choisis parmi O, S, $CR^{1a}R^{2a}$, $CR^{1b}R^{2b}$, $NR^{3a}$, $NR^{3b}$ ;
$R^{1a}$, $R^{2a}$, $R^{1b}$, et $R^{2b}$ étant indépendamment choisis parmi halogène, Cl, F, $C_1$ à $C_6$ alkyle partiellement fluoré, $C_1$ à $C_6$ alkyle perfluoré, $CF_3$, $C_1$ à $C_6$ alcoxy partiellement fluoré, $C_1$ à $C_6$ alcoxy perfluoré, $OCF_3$, CN, isocyano, SCN, OCN, $NO_2$, $NO_2$, $SF_5$, $C_6$ à $C_{30}$ aryle substitué ou non substitué, $C_3$ à $C_{30}$ hétéroaryle substitué ou non substitué,
le ou les substituants étant indépendamment choisis parmi D, halogène, Cl, F, $C_1$ à $C_6$ alkyle partiellement fluoré, $C_1$ à $C_6$ alkyle perfluoré, $CF_3$, $C_1$ à $C_6$ alcoxy partiellement fluoré, $C_1$ à $C_6$ alcoxy perfluoré, $OCF_3$, CN, isocyano, SCN, OCN, $NO_2$, $SF_5$ ;
$R^{3a}$ et $R^{3b}$ étant choisis parmi CN, $C_1$ à $C_6$ alkyle partiellement fluoré, $C_1$ à $C_6$ alkyle perfluoré, $CF_3$, $C_6$ à $C_{30}$ aryle substitué ou non substitué, ou $C_3$ à $C_{30}$ hétéroaryle substitué ou non substitué,
le ou les substituants étant indépendamment choisis parmi D, halogène, Cl, F, $C_1$ à $C_6$ alkyle partiellement fluoré, $C_1$ à $C_6$ alkyle perfluoré, $CF_3$, $C_{1;}$ à $C_6$ alcoxy partiellement fluoré, $C_1$ à $C_6$ alcoxy perfluoré, $OCF_3$, CN, isocyano, SCN, OCN, $NO_2$, $SF_5$,
le cycle A étant choisi parmi

| | | |
|---|---|---|
| 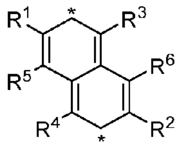 | 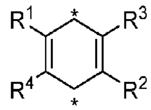 | 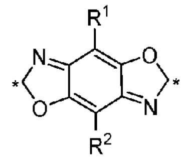 |
| 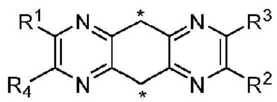 | 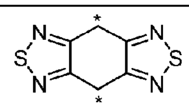 | 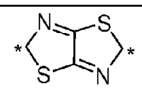 |
| 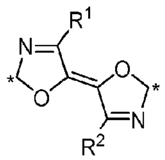 | 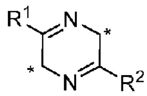 | |
| 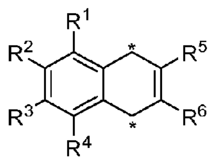 | 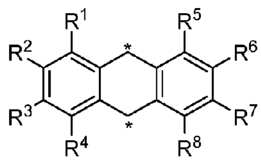 | 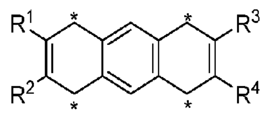 |
| 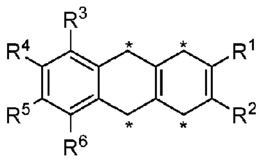 | 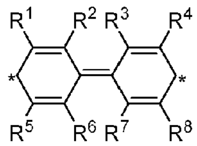 | 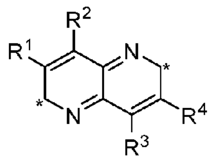 |
| 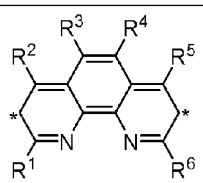 | 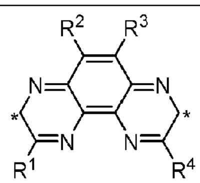 | 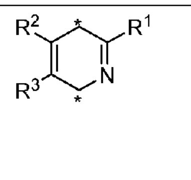 |
| 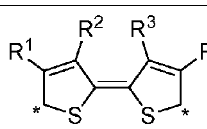 | 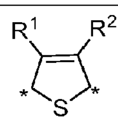 | 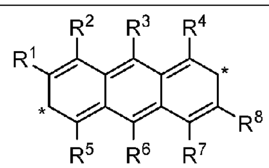 |

| | | |
|---|---|---|
| 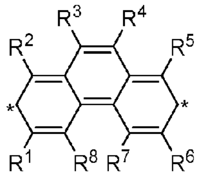 | 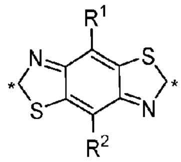 | 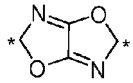 |
| 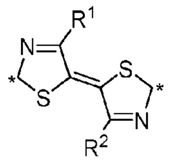 | 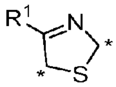 | 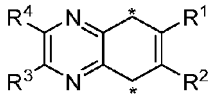 |
| 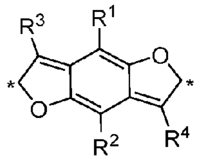 | 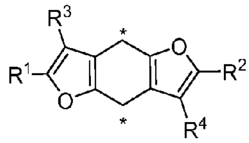 | 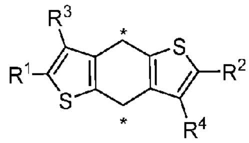 |
| 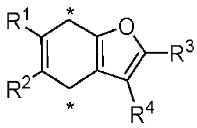 | 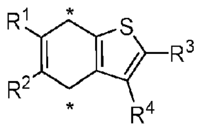 | 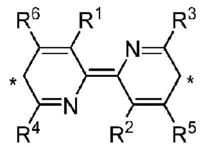 |
| 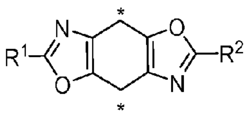 | 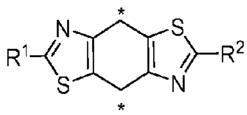 | 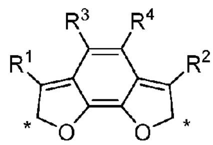 |
| 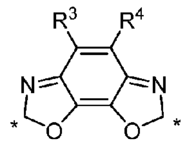 | 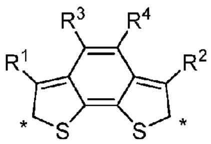 | 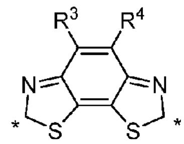 |
| 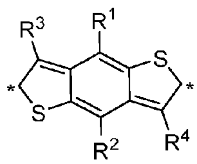 | 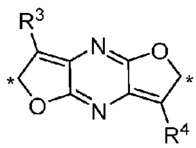 | 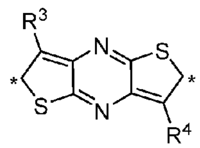 |
| 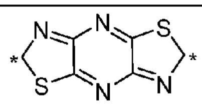 | 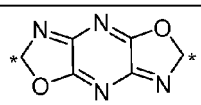 | 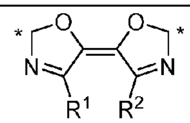 |
| 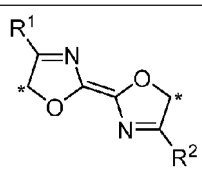 | 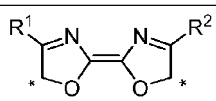 | 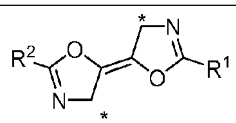 |

| | | |
|---|---|---|
| 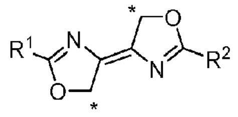 | 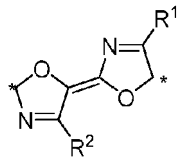 | 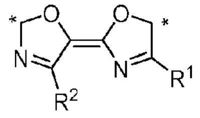 |
| 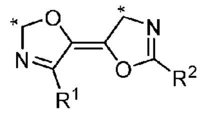 | 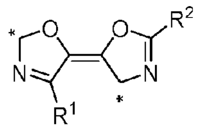 | 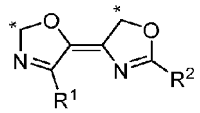 |
| 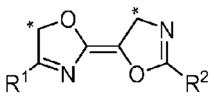 | 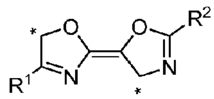 | 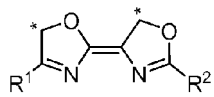 |
| 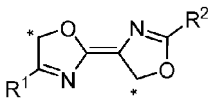 | 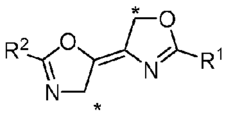 | 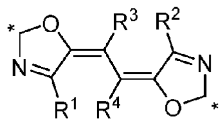 |
| 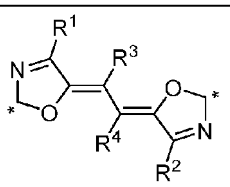 | 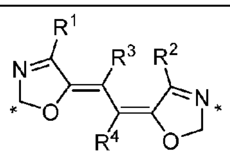 | 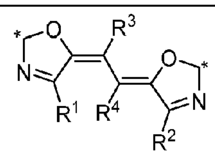 |
| 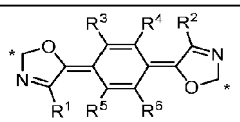 | 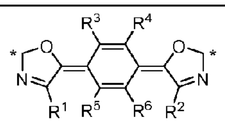 | 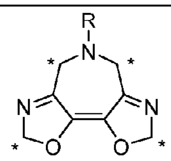 |

l'astérisque « * » désignant la position de liaison ; $R^1$, $R^2$, $R^3$, $R^4$, $R^5$, $R^6$, $R^7$ et $R^8$ étant indépendamment choisis parmi D, halogène, Cl, F, $C_1$ à $C_6$ alkyle substitué ou non substitué, $C_1$ à $C_6$ alkyle partiellement fluoré, $C_1$ à $C_6$ alkyle perfluoré, $CF_3$, $C_1$ à $C_6$ alcoxy substitué ou non substitué, $C_1$ à $C_6$ alcoxy partiellement fluoré, $C_1$ à $C_6$ alcoxy perfluoré, $OCF_3$, $C_6$ à $C_{30}$ aryloxy substitué ou non substitué, $C_6$ à $C_{30}$ aryloxy partiellement fluoré, $C_6$ à $C_{30}$ aryloxy perfluoré, $C_6$ à $C_{30}$ aryle substitué ou non substitué, $C_3$ à $C_{30}$ hétéroaryle substitué ou non substitué, CN, isocyano, SCN, OCN, $NO_2$, $SF_5$,

le ou les substituants étant choisis parmi D, halogène, Cl, F, $C_1$ à $C_6$ alkyle partiellement fluoré, $C_1$ à $C_6$ alkyle perfluoré, $CF_3$, $C_1$ à $C_6$ alcoxy partiellement fluoré, $C_1$ à $C_6$ alcoxy perfluoré, $OCF_3$, CN, isocyano, SCN, OCN, $NO_2$, $SF_5$ ; et

au moins l'un parmi $R^{1a}$, $R^{2a}$, $R^{1b}$, $R^{2b}$, $R^{3a}$, $R^{3b}$, $R^1$, $R^2$, $R^3$, $R^4$, $R^5$, $R^6$, $R^7$ et $R^8$ étant indépendamment choisi parmi un $C_6$ à $C_{30}$ aryle substitué ou non substitué ou $C_3$ à $C_{30}$ hétéroaryle substitué ou non substitué, préférablement $C_6$ à $C_{30}$ aryle substitué ou $C_3$ à $C_{30}$ hétéroaryle substitué, plus préférablement phényle substitué ou $C_3$ à $C_5$ hétéroaryle substitué et préférablement $C_3$ à $C_5$ hétéroaryle étant un cycle hétéroaromatique à six chaînons.

**4.** Dispositif électroluminescent organique selon l'une quelconque des revendications 1 ou 3, l'au moins une couche de génération de charge comprenant en outre une couche de génération de charge de type n.

**5.** Dispositif électroluminescent organique selon l'une quelconque des revendications 1 à 4, dans la formule (I), R' étant choisi parmi CN.

**6.** Dispositif électroluminescent organique selon l'une quelconque des revendications 1 à 5, le composé de formule (I) ayant un niveau d'énergie de LUMO calculé ≤ -4,60 eV lorsqu'il est calculé avec le package de programme TURBOMOLE V6.5 (TURBOMOLE GmbH, Litzenhardtstrasse 19, 76135 Karlsruhe, Allemagne) en appliquant le B3LYP fonctionnel hybride avec un ensemble de base 6-31G* dans la phase gazeuse ; préférablement ≤ -4,75 eV ;

plus préférablement ≤ -5,00 eV ; encore plus préférablement ≤ -5,10 eV ; encore plus préférablement ≤ -5,15 eV ; encore plus préférablement ≤ -5,19 eV ; encore plus préférablement ≤ -5,20 eV, et encore plus préférablement ≤ -5,22 eV.

**7.** Dispositif électroluminescent organique selon l'une quelconque des revendications 1 à 6, dans lequel, dans la formule (I), $Ar^1$, $Ar^2$ et $Ar^3$ sont choisis indépendamment parmi l'un des groupes suivants :

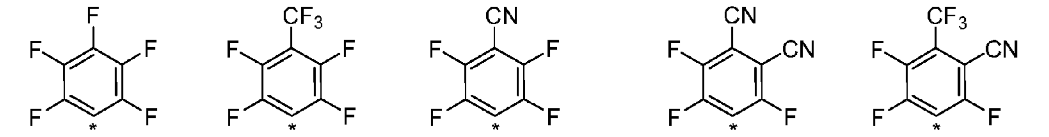
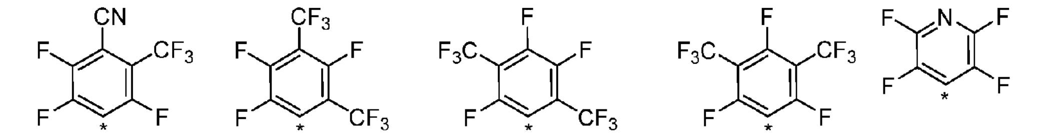
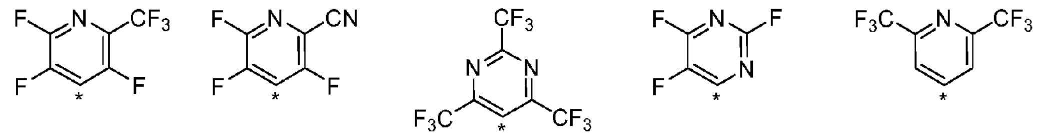
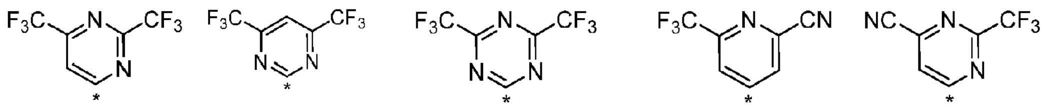
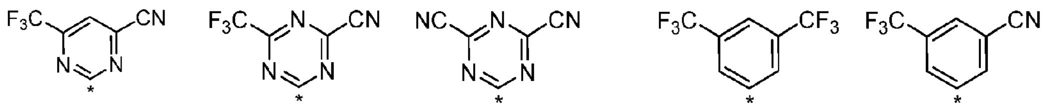
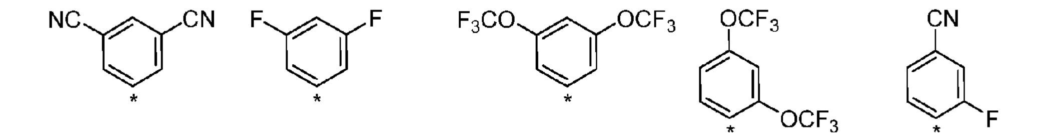
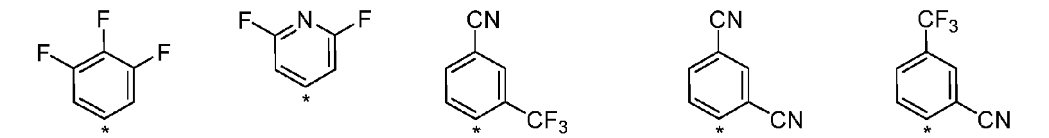
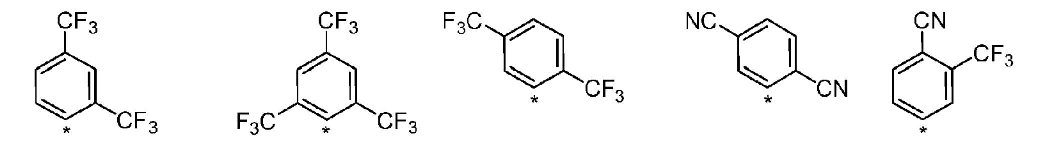
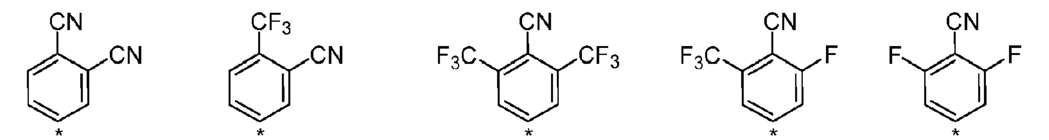

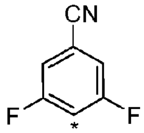 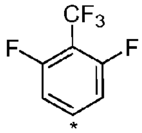 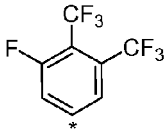 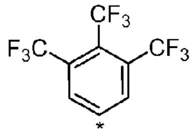 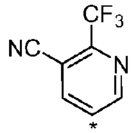

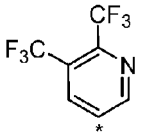 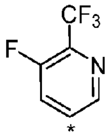 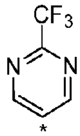 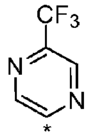 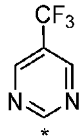

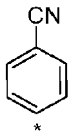 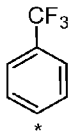 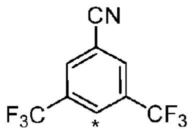 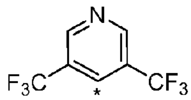 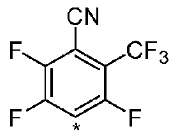

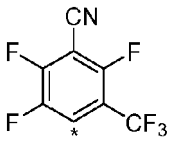 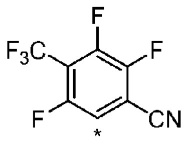 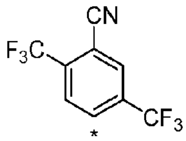

l'astérisque « * » désignant la position de liaison.

**8.** Dispositif électroluminescent organique selon l'une quelconque des revendications 1 à 7, dans lequel le composé de formule (II) a un poids moléculaire ≥ 340 g/mole.

**9.** Dispositif électroluminescent organique selon l'une quelconque des revendications 1 à 8, le composé de formule (II) ayant un niveau d'énergie de LUMO calculé ≥ -5,75 eV lorsqu'il est calculé avec le package de programme TURBOMOLE V6.5 (TURBOMOLE GmbH, Litzenhardtstrasse 19, 76135 Karlsruhe, Allemagne) en appliquant le B3LYP fonctionnel hybride avec un ensemble de base 6-31G* dans la phase gazeuse.

**10.** Dispositif électroluminescent organique selon l'une quelconque des revendications 3 à 9, dans lequel le composé de formule (IIa), le cycle A est choisi parmi :

| | | |
|---|---|---|
| 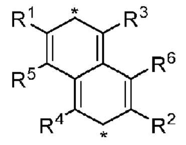 | 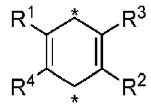 | 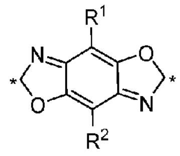 |
| 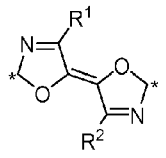 | 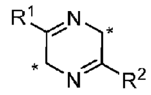 | |
| 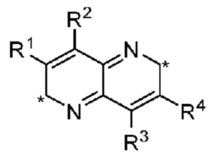 | 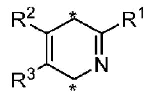 | 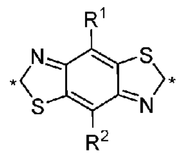 |
| 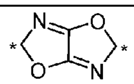 | 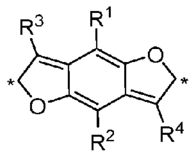 | 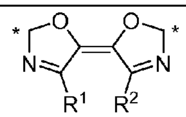 |
| 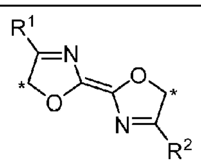 | 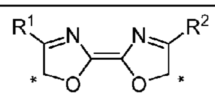 | 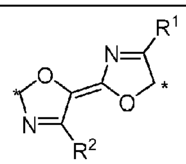 |

| | | |
|---|---|---|
| 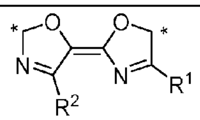 | | |

l'astérisque « * » désignant la position de liaison.

**11.** Dispositif électroluminescent organique selon l'une quelconque des revendications 3 à 10, dans lequel, dans les formules (IIa), l'au moins un substituant aryle ou l'au moins un substituant hétéroaryle est choisi parmi

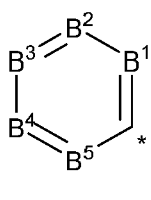 (XXXx)

$B^1$ étant choisi parmi $CL^1$ ou N ;
$B^2$ étant choisi parmi $CL^2$ ou N ;
$B^3$ étant choisi parmi $CL^3$ ou N ;
$B^4$ étant choisi parmi $CL^4$ ou N ;
$B^5$ étant choisi parmi $CL^5$ ou N ;
$L^1$, $L^2$, $L^3$, $L^4$, et $L^5$ étant indépendamment choisis parmi CN, isocyano, SCN, OCN, $NO_2$, $SF_5$, $C_1$ à $C_6$ alkyle partiellement fluoré, $C_1$ à $C_6$ alkyle perfluoré, $CF_3$, $C_1$ à $C_6$ alcoxy partiellement fluoré, $C_1$ à $C_6$ alcoxy perfluoré,

$OCF_3$, halogène, Cl, F, D ou H ; l'astérisque « * » désignant la position de liaison.

**12.** Dispositif électroluminescent organique selon l'une quelconque des revendications 3 à 11, dans lequel, dans les formules (IIa), l'au moins un substituant aryle ou l'au moins un substituant hétéroaryle est choisi parmi

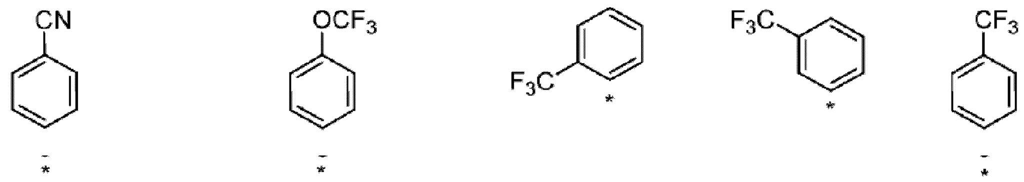

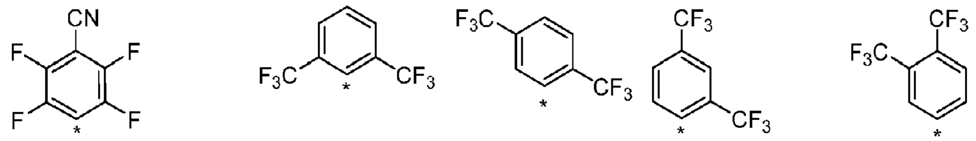

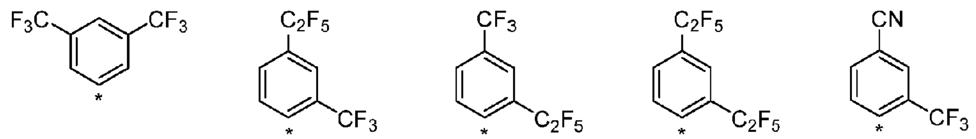

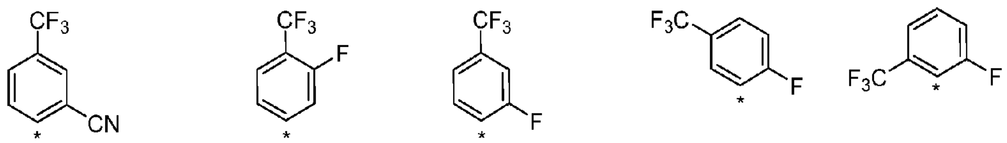

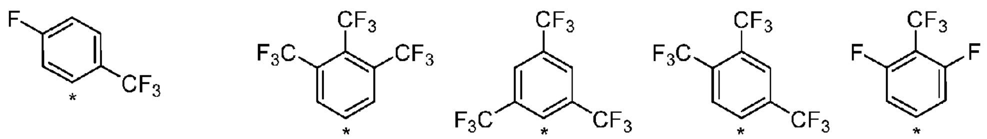

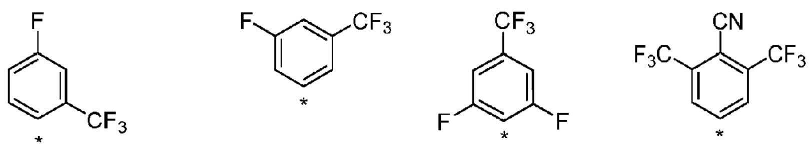

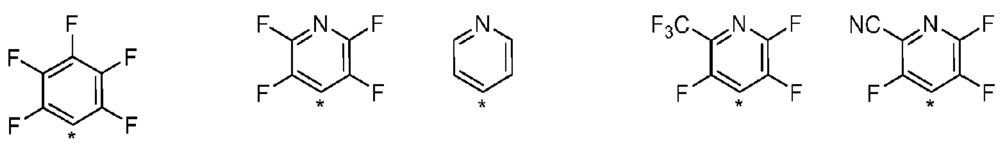

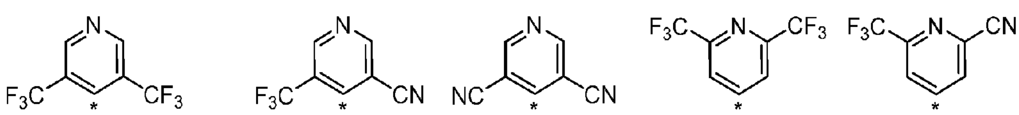

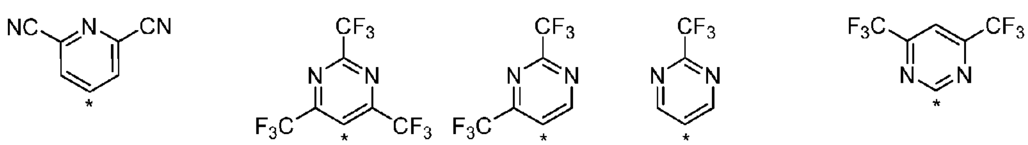

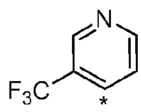 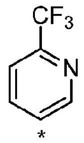 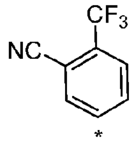 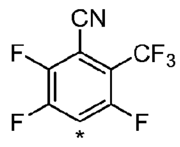 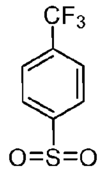

l'astérisque « * » désignant la position de liaison.

**13.** Dispositif électroluminescent organique selon l'une quelconque des revendications 3 à 12, dans lequel, dans les formules (IIa), $X^1$ est choisi parmi :

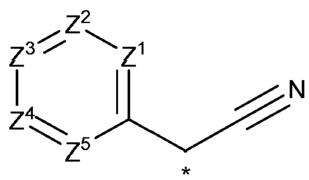

(XXa)

$Z^1$ étant choisi parmi $CY^1$ ou N ;
$Z^2$ étant choisi parmi $CY^2$ ou N ;
$Z^3$ étant choisi parmi $CY^3$ ou N ;
$Z^4$ étant choisi parmi $CY^4$ ou N ;
$Z^5$ étant choisi parmi $CY^5$ ou N ;
$Y^1$, $Y^2$, $Y^3$, $Y^4$, et $Y^5$ étant indépendamment choisis parmi CN, isocyano, SCN, OCN, $NO_2$, $SF_5$, $C_1$ à $C_6$ alkyle partiellement fluoré, $C_1$ à $C_6$ alkyle perfluoré, $CF_3$, $C_1$ à $C_6$ alcoxy partiellement fluoré, $C_1$ à $C_6$ alcoxy perfluoré, $OCF_3$, halogène, Cl, F, D ou H, l'astérisque « * » désignant la position de liaison.

**14.** Dispositif électroluminescent organique selon l'une quelconque des revendications 3 à 12, dans la formule (IIa), $X^1$ et/ou $X^2$ étant choisis indépendamment parmi :

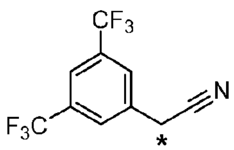 (X1), 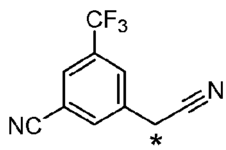 (X2), 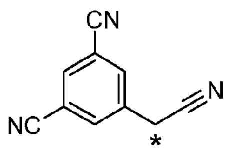 (X3),

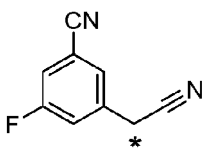 (X4), 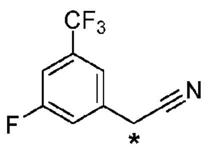 (X5), 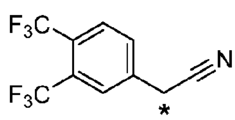 (X6),

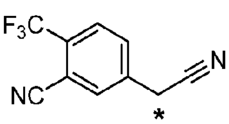 (X7), 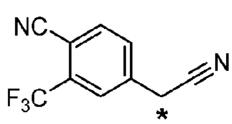 (X8), 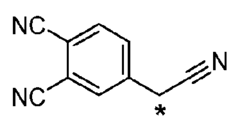 (X9),

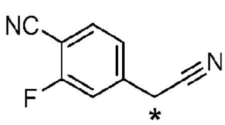 (X10), 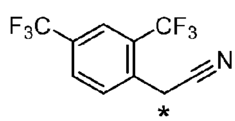 (X11), 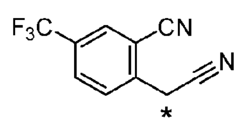 (X12),

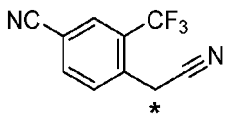 (X13), 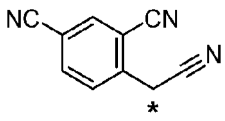 (X14), 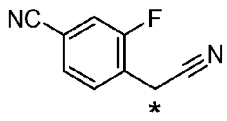 (X15),

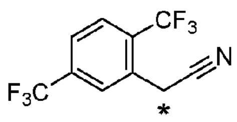 (X16), 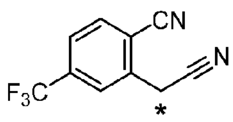 (X17), 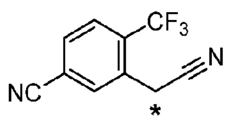 (X18),

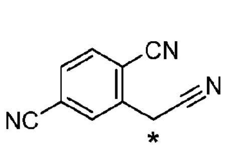 (X19), 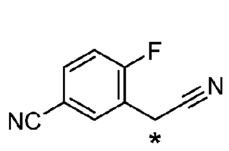 (X20), 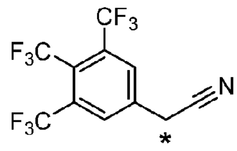 (X21),

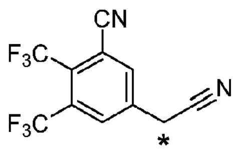 (X22), 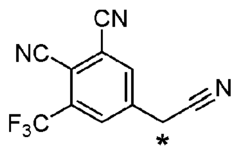 (X23), 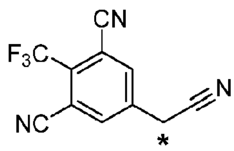 (X24),

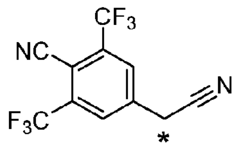 (X25), 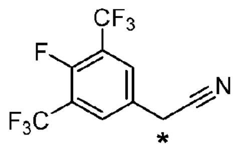 (X26), 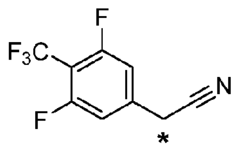 (X27),

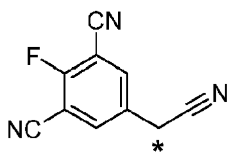 (X28), 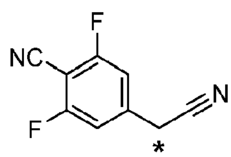 (X29), 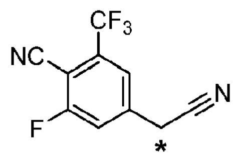 (X30),

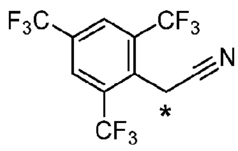 (X31), 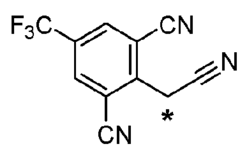 (X32), 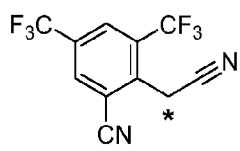 (X33),

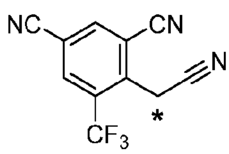 (X34), 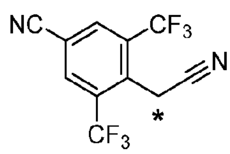 (X35), 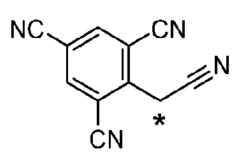 (X36),

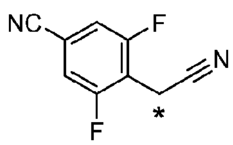 (X37), 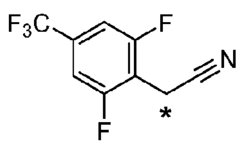 (X38), 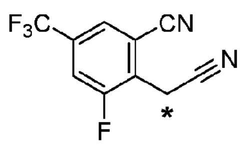 (X39),

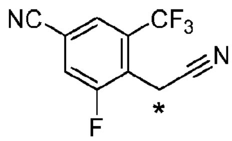 (X40), 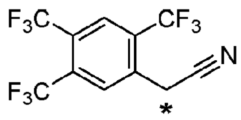 (X41), 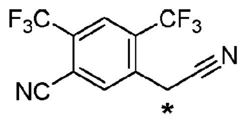 (X42),

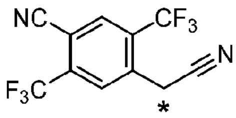 (X43), 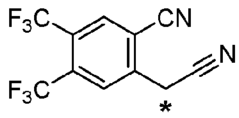 (X44), 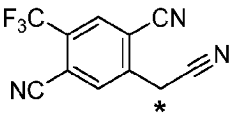 (X45),

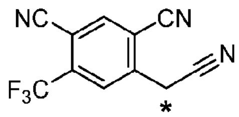 (X46), 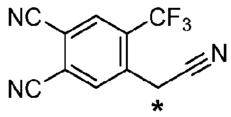 (X47), 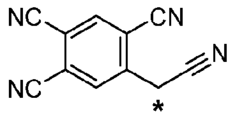 (X48),

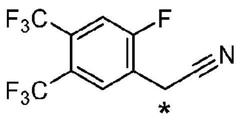 (X49), 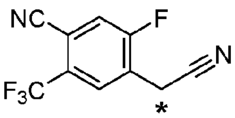 (X50), 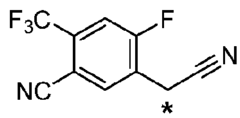 (X51),

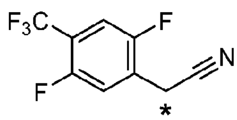 (X52), 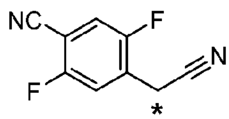 (X53), 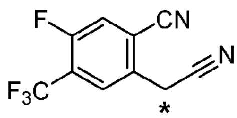 (X54),

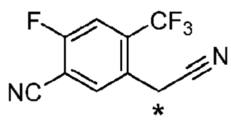 (X55), 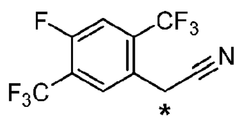 (X56), 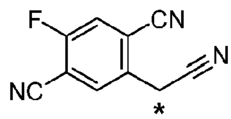 (X57),

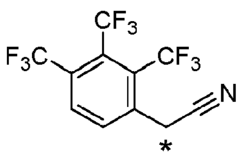 (X58), 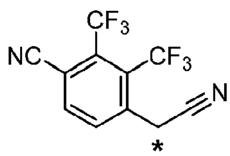 (X59), 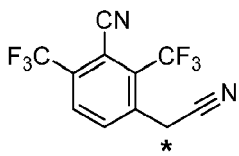 (X60),

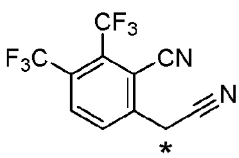 (X61), 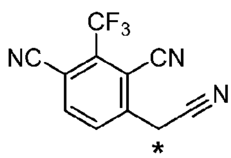 (X62), 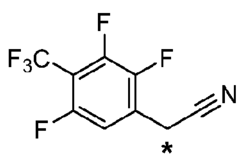 (X63),

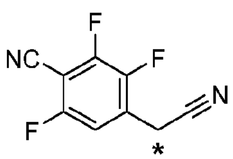 (X64), 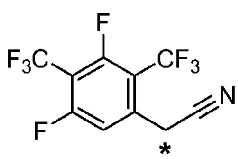 (X65), 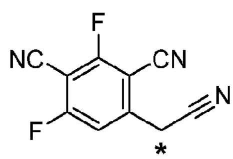 (X66),

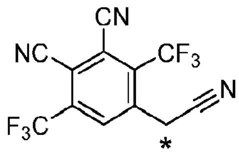 (X67), 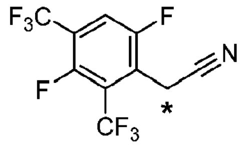 (X68), 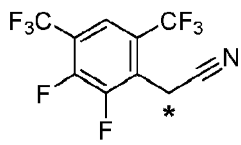 (X69),

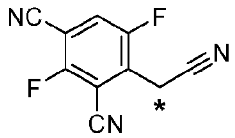 (X70), 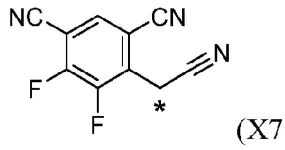 (X71), 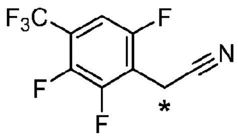 (X72),

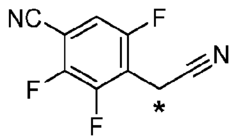 (X73), 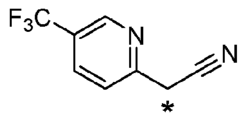 (X74), 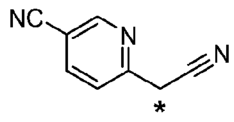 (X75),

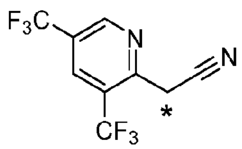 (X76), 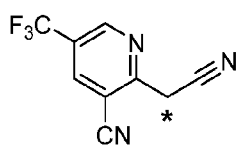 (X77), 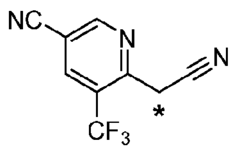 (X78),

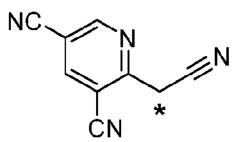 (X79), 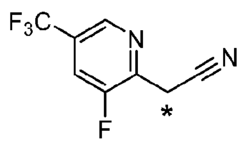 (X80), 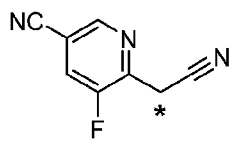 (X81),

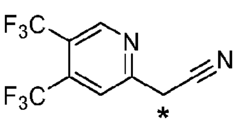 (X82), 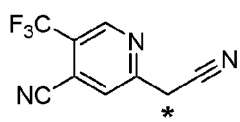 (X83), 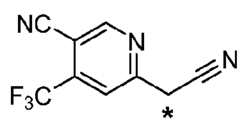 (X84),

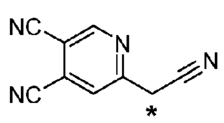 (X85), 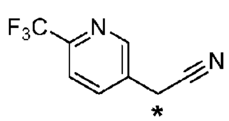 (X86), 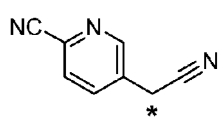 (X87),

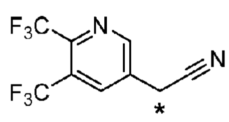 (X88), 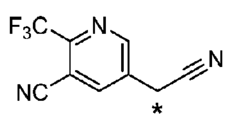 (X89), 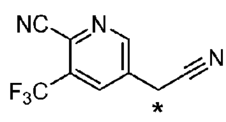 (X90),

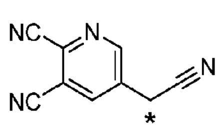 (X91), 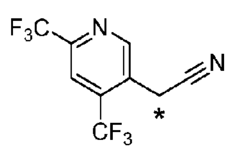 (X92), 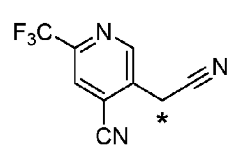 (X93),

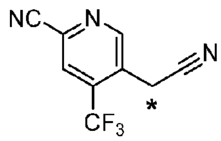 (X94), 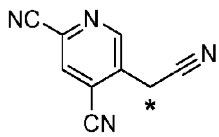 (X95), 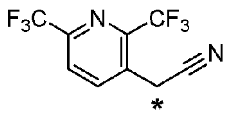 (X96),

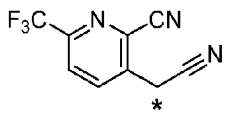 (X97), 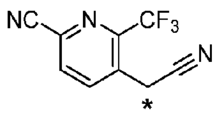 (X98), 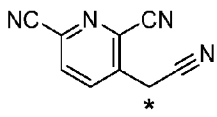 (X99),

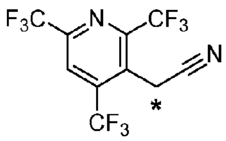 (X100), 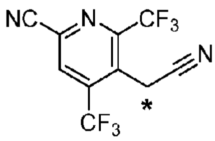 (X101), 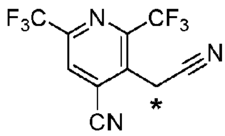 (X102),

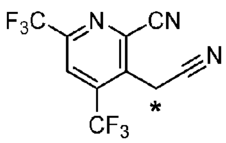 (X103), 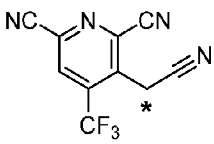 (X104), 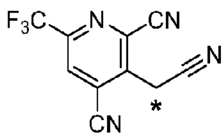 (X105),

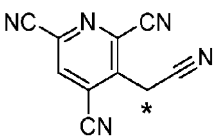 (X106), 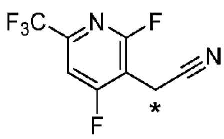 (X107), 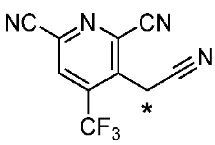 (X108),

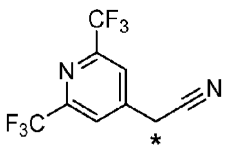 (X109), 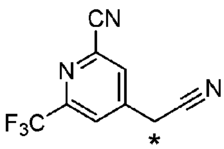 (X110), 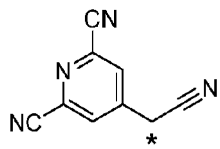 (X111),

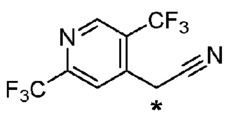 (X112), 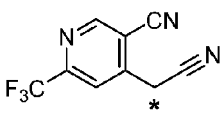 (X113), 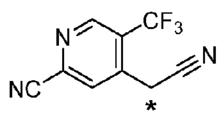 (X114),

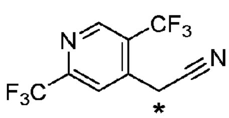 (X115), 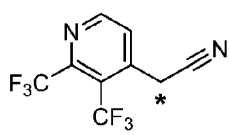 (X116), 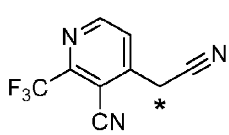 (X117),

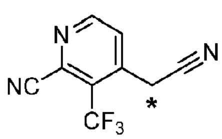 (X118), 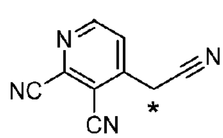 (X119), 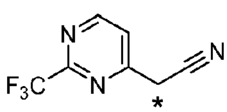 (X120),

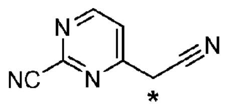 (X121), 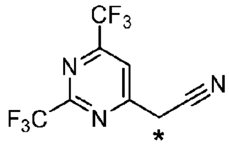 (X122), 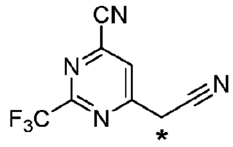 (X123),

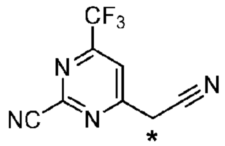 (X124), 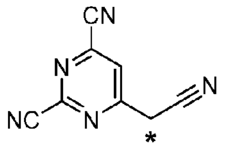 (X125), 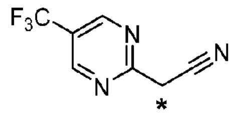 (X126),

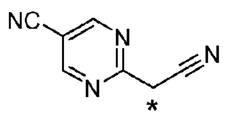 (X127), 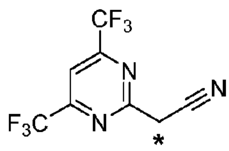 (X128), 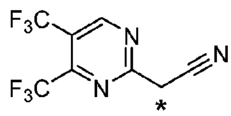 (X129),

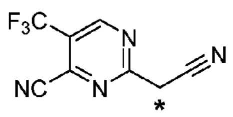 (X130), 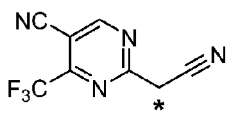 (X131), 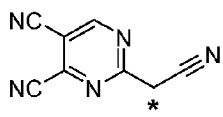 (X132),

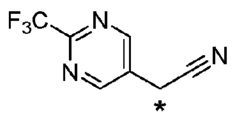 (X133), 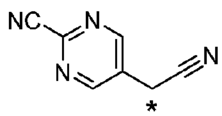 (X134), 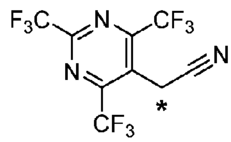 (X135),

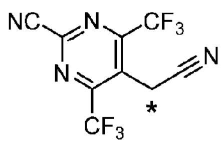 (X136), 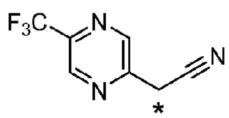 (X137), 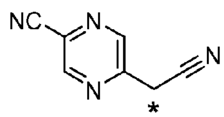 (X138),

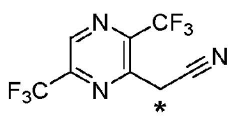 (X139), 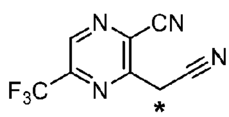 (X140), 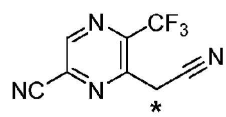 (X141),

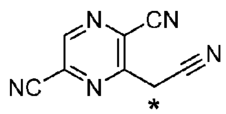 (X142), 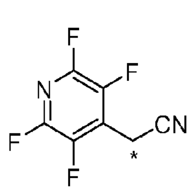 (X143);

l’astérisque « * » désignant la position de liaison.

**15.** Dispositif d’affichage comprenant un dispositif électroluminescent organique selon l’une quelconque des revendications 1 à 14.

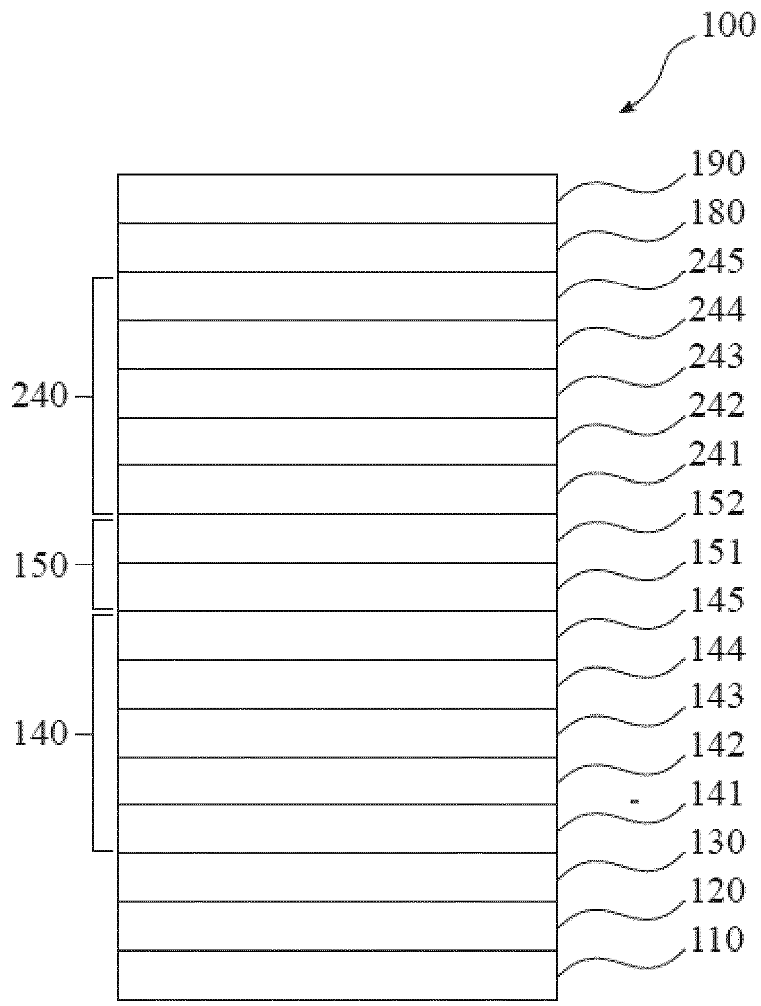
100
190
180
245
244
243
242
241
152
151
145
144
143
142
141
130
120
110
240
150
140

Fig. 1

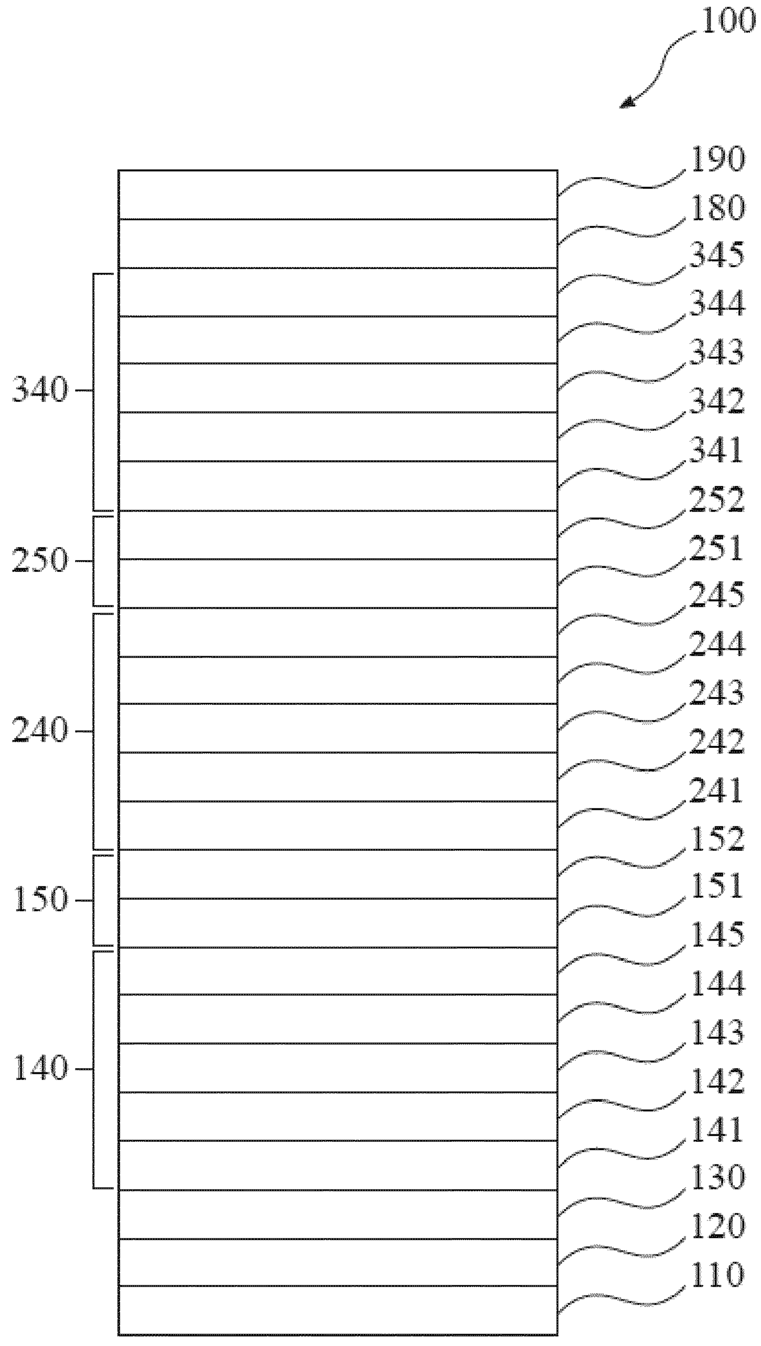
100
190
180
345
344
343
342
341
252
251
245
244
243
242
241
152
151
145
144
143
142
141
130
120
110
340
250
240
150
140

Fig. 2

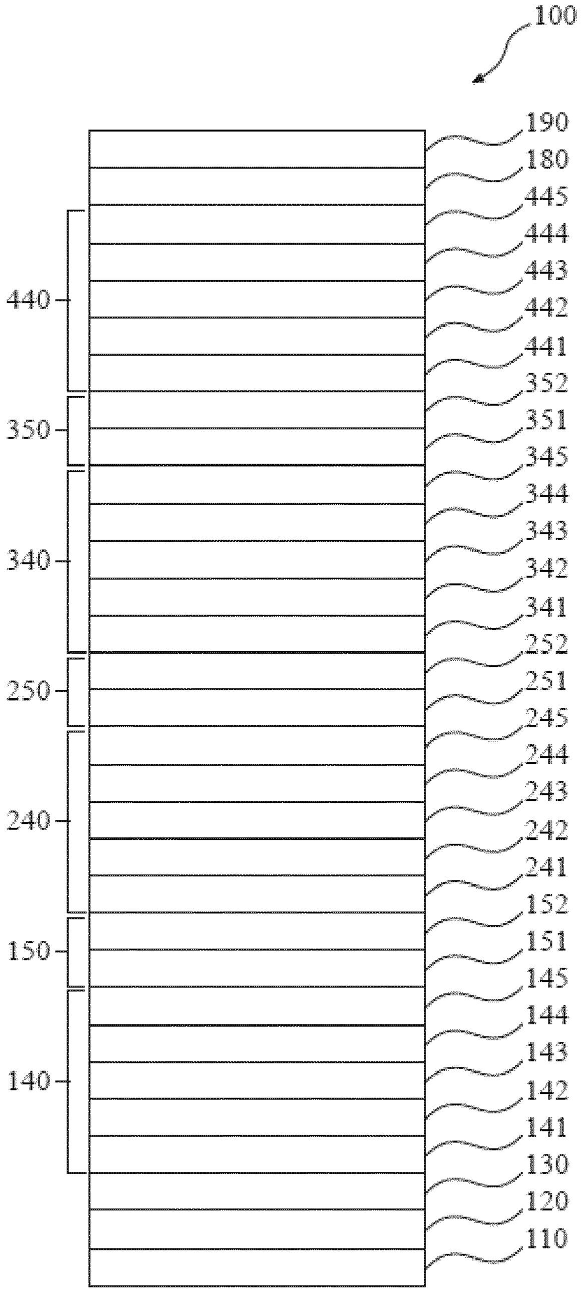
100
190
180
445
444
443
442
441
352
351
345
344
343
342
341
252
251
245
244
243
242
241
152
151
145
144
143
142
141
130
120
110
440
350
340
250
240
150
140

Fig. 3

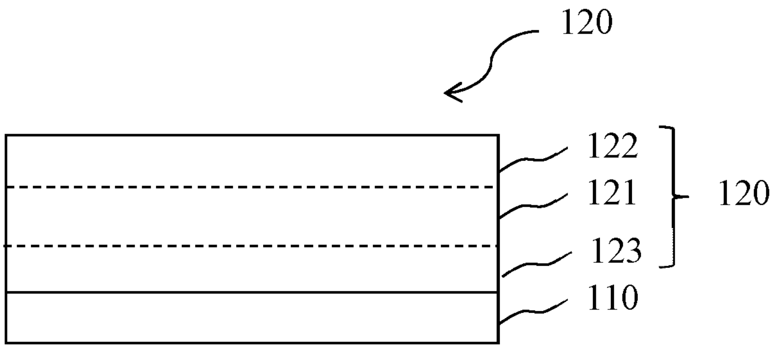


Fig. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2021250277 A
- EP 3989305 A1
- US 20200062778 A1
- EP 2722908 A1
- EP 2180029 A1
- WO 2016097017 A1
- US 2005121667 A1


### Non-patent literature cited in the description


- **YASUHIKO SHIROTA** ; **HIROSHI KAGEYAMA**. *Chem. Rev.*, 2007, vol. 107, 953-1010
- **BUCSIS** ; **FRIEDRICHS**. *Chem. Ber.*, 1976, vol. 109, 2462-2468
- *J. Org. Chem.*, 1995, vol. 60 (13), 4077-4084
- **HÜNIGS** ; **AUMÜLLERS**. *Liebigs Annalen der Chemie*, 1986, vol. 1, 142-164